(19) Europäisches Patentamt
European Patent Office
Office européen des brevets

(11) EP 3 560 941 B1

(12) **EUROPEAN PATENT SPECIFICATION**

(45) Date of publication and mention of the grant of the patent:
**08.09.2021 Bulletin 2021/36**

(51) Int Cl.:
***C07F 15/00*** *(2006.01)* ***H01L 51/00*** *(2006.01)*
***H01L 51/50*** *(2006.01)*

(21) Application number: **19170468.3**

(22) Date of filing: **23.04.2019**

(54) **ORGANOMETALLIC COMPOUND, ORGANIC LIGHT-EMITTING DEVICE INCLUDING THE ORGANOMETALLIC COMPOUND, AND DIAGNOSTIC COMPOUND INCLUDING THE ORGANOMETALLIC COMPOUND**

ORGANOMETALLISCHE VERBINDUNG, ORGANISCHE LICHTEMITTIERENDE VORRICHTUNG MIT DER ORGANOMETALLISCHEN VERBINDUNG UND DIAGNOSTISCHE VERBINDUNG MIT DER ORGANOMETALLISCHEN VERBINDUNG

COMPOSÉ ORGANOMÉTALLIQUE, DISPOSITIF ÉLECTROLUMINESCENT ORGANIQUE LE COMPRENANT ET COMPOSÉ DIAGNOSTIQUE COMPRENANT LE COMPOSÉ ORGANOMÉTALLIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **23.04.2018 KR 20180046990**
**22.04.2019 KR 20190046949**

(43) Date of publication of application:
**30.10.2019 Bulletin 2019/44**

(60) Divisional application:
**20171778.2 / 3 722 302**

(73) Proprietor: **Samsung Electronics Co., Ltd.**
**Gyeonggi-do 16677 (KR)**

(72) Inventors:
- **KWAK, Yoonhyun**
  **16678 Gyeonggi-do (KR)**
- **LEE, Sunyoung**
  **16678 Gyeonggi-do (KR)**
- **LEE, Jungin**
  **16678 Gyeonggi-do (KR)**
- **LEE, Jiyoun**
  **16678 Gyeonggi-do (KR)**
- **JEON, Aram**
  **16678 Gyeonggi-do (KR)**
- **KOO, Hyun**
  **16678 Gyeonggi-do (KR)**
- **ARATANI, Sukekazu**
  **16678 Gyeonggi-do (KR)**
- **ISHIHARA, Shingo**
  **16678 Gyeonggi-do (KR)**
- **CHO, Yuri**
  **16678 Gyeonggi-do (KR)**
- **CHOI, Byoungki**
  **16678 Gyeonggi-do (KR)**
- **HONG, Seokhwan**
  **16678 Gyeonggi-do (KR)**

(74) Representative: **Elkington and Fife LLP**
**Prospect House**
**8 Pembroke Road**
**Sevenoaks, Kent TN13 1XR (GB)**

(56) References cited:
**WO-A2-2014/023377 CN-A- 103 694 277**
**CN-A- 107 459 535**

Remarks:
The file contains technical information submitted after the application was filed and not included in this specification

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 560 941 B1

## Description

FIELD OF THE INVENTION

One or more embodiments relate to an organometallic compound, an organic light-emitting device including the organometallic compound, and a diagnostic composition including the organometallic compound.

BACKGROUND OF THE INVENTION

Organic light-emitting devices are self-emission devices, which have better characteristics in terms of a viewing angle, a response time, a brightness, a driving voltage, and a response speed, and produce full-color images.

In an example, an organic light-emitting device includes an anode, a cathode, and an organic layer between the anode and the cathode, wherein the organic layer includes an emission layer. A hole transport region may be between the anode and the emission layer, and an electron transport region may be between the emission layer and the cathode. Holes provided from the anode may move toward the emission layer through the hole transport region, and electrons provided from the cathode may move toward the emission layer through the electron transport region. The holes and the electrons recombine in the emission layer to produce excitons. These excitons transit from an excited state to a ground state, thereby generating light.

Meanwhile, luminescent compounds may be used to monitor, sense, or detect a variety of biological materials including cells and proteins. An example of the luminescent compounds includes a phosphorescent luminescent compound.

CN 107 459 535 discloses a polysubstituted quinoline-coordinated iridium-hybridized compound, a preparation method thereof and application of the compound in electroluminescent materials.

CN 103 694 277 discloses an organic light emitting diode consisting of a cathode, an anode and a luminescent layer between the cathode and the anode. The luminescent layer contains an organometallic compound characterized in that 4th and 7th positions of a quinoline ring are provided with a substituent.

WO 2014/023377 discloses metal complexes and electronic devices, in particular organic electroluminescent devices, containing said metal complexes.

SUMMARY OF THE INVENTION

Aspects of the present disclosure provide a novel organometallic compound and an organic light-emitting device and a diagnostic composition including the same.

Additional aspects will be set forth in part in the description which follows and, in part, will be apparent from the description, or may be learned by practice of the presented embodiments. The present invention is defined by the appended claims. The description is for reference only.

An aspect of the present disclosure provides an organometallic compound represented by Formula 1 below:

<Formula 1>

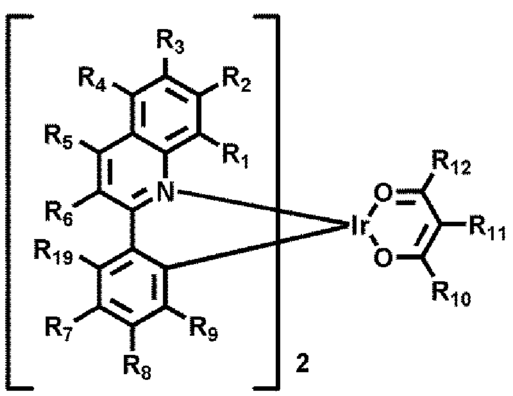

In Formula 1, $R_1$ to $R_{12}$ and $R_{19}$ may each independently be selected from hydrogen, deuterium, -F, -Cl, -Br, -I, $-SF_5$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl

group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent non-aromatic condensed polycyclic group, a substituted or unsubstituted monovalent non-aromatic condensed heteropolycyclic group, $-N(Q_1)(Q_2)$, $-Si(Q_3)(Q_4)(Q_5)$, - $Ge(Q_3)(Q_4)(Q_5)$, $-B(Q_6)(Q_7)$, $-P(=O)(Q_8)(Q_9)$, and $-P(Q_8)(Q_9)$, and

at least one selected from $R_1$ to $R_6$ may be selected from groups represented by Formula 2:

<Formula 2>

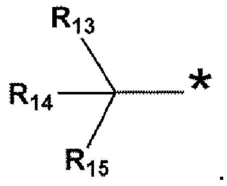

The number of carbon atoms included in Formula 2 may be 4 or more,

$R_{13}$ in Formula 2 may be hydrogen, deuterium, a $C_1$-$C_{20}$ alkyl group, a deuterium-containing $C_1$-$C_{20}$ alkyl group, a $C_3$-$C_{10}$ cycloalkyl group, or a deuterium-containing $C_3$-$C_{10}$ cycloalkyl group,

$R_{14}$ and $R_{15}$ in Formula 2 may each independently be a $C_1$-$C_{20}$ alkyl group, a deuterium-containing $C_1$-$C_{20}$ alkyl group, a $C_3$-$C_{10}$ cycloalkyl group, or a deuterium-containing $C_3$-$C_{10}$ cycloalkyl group,

provided that, $R_{13}$, $R_{14}$ and $R_{15}$ may not be a methyl group, simultaneously,

* indicates a binding site to a neighboring atom,

two or more selected from $R_1$ to $R_9$ and $R_{19}$ in Formula 1 may optionally be linked to form a $C_5$-$C_{30}$ carbocyclic group that is unsubstituted or substituted with at least one $R_{1a}$ or a $C_2$-$C_{30}$ heterocyclic group that is unsubstituted or substituted with at least one $R_{1a}$,

$R_{1a}$ may be the same as described in connection with $R_7$, at least one substituent of the substituted $C_1$-$C_{60}$ alkyl group, the substituted C2-C60 alkenyl group, the substituted $C_2$-$C_{60}$ alkynyl group, the substituted $C_1$-$C_{60}$ alkoxy group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_6$-C60 aryloxy group, the substituted $C_6$-$C_{60}$ arylthio group, the substituted $C_1$-$C_{60}$ heteroaryl group, the substituted monovalent non-aromatic condensed polycyclic group, and the substituted monovalent non-aromatic condensed heteropolycyclic group may be selected from:

deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-C60 alkyl group, a $C_2$-$C_{60}$ alkenyl group, a $C_2$-$C_{60}$ alkynyl group, and a $C_1$-$C_{60}$ alkoxy group;

a $C_1$-$C_{60}$ alkyl group, a $C_2$-$C_{60}$ alkenyl group, a $C_2$-$C_{60}$ alkynyl group, and a $C_1$-$C_{60}$ alkoxy group, each substituted with at least one selected from deuterium, -F, - Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, a monovalent non-aromatic condensed heteropolycyclic group, - $N(Q_{11})(Q_{12})$, $-Si(Q_{13})(Q_{14})(Q_{15})$, $-Ge(Q_{13})(Q_{14})(Q_{15})$, $-B(Q_{16})(Q_{17})$, $-P(=O)(Q_{18})(Q_{19})$, and $-P(Q_{18})(Q_{19})$;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, and a monovalent non-aromatic condensed heteropolycyclic group;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, and a monovalent non-aromatic condensed

heteropolycyclic group, each substituted with at least one selected from deuterium, - F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, a monovalent non-aromatic condensed heteropolycyclic group, - $N(Q_{21})(Q_{22})$, $-Si(Q_{23})(Q_{24})(Q_{25})$, $-Ge(Q_{23})(Q_{24})(Q_{25})$, $-B(Q_{26})(Q_{27})$, $-P(=O)(Q_{28})(Q_{29})$, and $-P(Q_{28})(Q_{29})$; and

$-N(Q_{31})(Q_{32})$, $-Si(Q_{33})(Q_{34})(Q_{35})$, $-Ge(Q_{33})(Q_{34})(Q_{35})$, $-B(Q_{36})(Q_{37})$, - $P(=O)(Q_{38})(Q_{39})$, and $-P(Q_{38})(Q_{39})$, and $Q_1$ to $Q_9$, $Q_{11}$ to $Q_{19}$, $Q_{21}$ to $Q_{29}$, and $Q_{31}$ to $Q_{39}$ may each independently be selected from hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryl group substituted with at least one selected from a $C_1$-$C_{60}$ alkyl group and a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, and a monovalent non-aromatic condensed heteropolycyclic group.

Another aspect of the present disclosure provides an organic light-emitting device including: a first electrode, a second electrode, and an organic layer between the first electrode and the second electrode and including an emission layer, wherein the organic layer includes at least one of the organometallic compound described above.

The organometallic compound in the emission layer of the organic layer may act as a dopant.

Still another aspect of the present disclosure provides a diagnostic composition including at least one organometallic compound described above.

## BRIEF DESCRIPTION OF THE DRAWING

These and/or other aspects will become apparent and more readily appreciated from the following description of the embodiments, taken in conjunction with FIGURE which is a schematic view of an organic light-emitting device according to an embodiment.

## DETAILED DESCRIPTION OF THE EMBODIMENTS

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description. As used herein, the term "and/or" includes any and all combinations of one or more of the associated listed items. Expressions such as "at least one of," when preceding a list of elements, modify the entire list of elements and do not modify the individual elements of the list.

An organometallic compound according to an embodiment is represented by Formula 1 below:

<Formula 1>

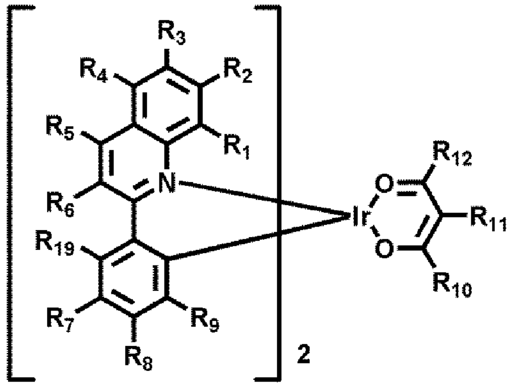

In Formula 1, $R_1$ to $R_{12}$ and $R_{19}$ may each independently be selected from hydrogen, deuterium, -F, -Cl, -Br, -I, $-SF_5$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent non-aromatic condensed polycyclic group, a substituted or unsubstituted monovalent non-aromatic condensed heteropolycyclic group, $-N(Q_1)(Q_2)$, $-Si(Q_3)(Q_4)(Q_5)$, $-Ge(Q_3)(Q_4)(Q_5)$, $-B(Q_6)(Q_7)$, $-P(=O)(Q_8)(Q_9)$, and $-P(Q_8)(Q_9)$. Formulae 2 and 3 and $Q_1$ to $Q_9$ are the same as described above.

For example, $R_1$ to $R_{12}$ and $R_{19}$ may each independently be selected from:

hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, $-SF_5$, a $C_1$-$C_{20}$ alkyl group, and a $C_1$-$C_{20}$ alkoxy group;

a $C_1$-$C_{20}$ alkyl group and a $C_1$-$C_{20}$ alkoxy group, each substituted with at least one selected from deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group, a cyclopentyl group, a cyclohexyl group, a cycloheptyl group, a cycloctyl group, an adamantanyl group, a norbornanyl group, a norbornenyl group, a cyclopentenyl group, a cyclohexenyl group, a cycloheptenyl group, bicyclo[1.1.1]pentyl, bicyclo[2.1.1]hexyl, bicyclo[2.2.1]heptyl, a bicyclo[2.2.2]octyl group, a phenyl group, a biphenyl group, a terphenyl group, naphthyl group, a pyridinyl group, and a pyrimidinyl group;

a cyclopentyl group, a cyclohexyl group, a cycloheptyl group, a cycloctyl group, an adamantanyl group, a norbornanyl group, a norbornenyl group, a cyclopentenyl group, a cyclohexenyl group, a cycloheptenyl group, bicyclo[1.1.1]pentyl, bicyclo[2.1.1]hexyl, bicyclo[2.2.1]heptyl, a bicyclo[2.2.2]octyl group, a phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, and an imidazopyrimidinyl group;

a cyclopentyl group, a cyclohexyl group, a cycloheptyl group, a cycloctyl group, an adamantanyl group, a norbornanyl group, a norbornenyl group, a cyclopentenyl group, a cyclohexenyl group, a cycloheptenyl group, bicyclo[1.1.1]pentyl, bicyclo[2.1.1]hexyl, bicyclo[2.2.1]heptyl, a bicyclo[2.2.2]octyl group, a phenyl group, a biphenyl group, a terphenyl group, a naphthyl group, a fluorenyl group, a phenanthrenyl group, an anthracenyl group, a fluoranthenyl

group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, and an imidazopyrimidinyl group, each substituted with at least one selected from deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a cyclopentyl group, a cyclohexyl group, a cycloheptyl group, a cycloctyl group, an adamantanyl group, a norbornanyl group, a norbornenyl group, a cyclopentenyl group, a cyclohexenyl group, a cycloheptenyl group, bicyclo[1.1.1]pentyl, bicyclo[2.1.1]hexyl, bicyclo[2.2.1]heptyl, a bicyclo[2.2.2]octyl group, a phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, and $-Si(Q_{33})(Q_{34})(Q_{35})$; and

$-N(Q_1)(Q_2)$, $-Si(Q_3)(Q_4)(Q_5)$, $-Ge(Q_3)(Q_4)(Q_5)$, $-B(Q_6)(Q_7)$, $-P(=O)(Q_8)(Q_9)$, and $-P(Q_8)(Q_9)$, and

$Q_1$ to $Q_9$ and $Q_{33}$ to $Q_{35}$ may each independently be selected from:

$-CH_3$, $-CD_3$, $-CD_2H$, $-CDH_2$, $-CH_2CH_3$, $-CH_2CD_3$, $-CH_2CD_2H$, $-CH_2CDH_2$, $-CHDCH_3$, $-CHDCD_2H$, $-CHDCDH_2$, $-CHDCD_3$, $-CD_2CD_3$, $-CD_2CD_2H$, and $-CD_2CDH_2$;

an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group; and

an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group, each substituted with at least one selected from deuterium, a $C_1$-$C_{10}$ alkyl group, and a phenyl group.

In one embodiment, $R_1$ to $R_9$ and $R_{19}$ may each independently be selected from hydrogen, deuterium, a substituted or unsubstituted $C_1$-$C_{60}$ alkyl group, a substituted or unsubstituted $C_3$-$C_{10}$ cycloalkyl group, or $-Si(Q_3)(Q_4)(Q_5)$. $Q_3$ to $Q_5$ are the same as described in this disclosure.

In one or more embodiments, $R_1$ to $R_{12}$ and $R_{19}$ may each independently be selected from:

hydrogen, deuterium, a methyl group, an ethyl group, an n-propyl group, an iso-propyl group, an n-butyl group, a sec-butyl group, an iso-butyl group, a tert-butyl group, an n-pentyl group, a tert-pentyl group, a neopentyl, an isopentyl group, a sec-pentyl group, a 3-pentyl group, a sec-isopentyl group, an n-hexyl group, an isohexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group, a tert-decyl group, a methoxy group, an ethoxy group, a propoxy group, a butoxy group, a pentoxy group, a cyclopentyl group, a cyclohexyl group, a cycloheptyl group, a cycloctyl group, an adamantanyl group, a norbornanyl group, a norbornenyl group, a cyclopentenyl group, a cyclohexenyl group, a cycloheptenyl group, bicyclo[1.1.1]pentyl, bicyclo[2.1.1]hexyl, bicyclo[2.2.1]heptyl, a bicyclo[2.2.2]octyl group, a phenyl group, a biphenyl group, a terphenyl group, a naphthyl group, a pyridinyl group, a pyrimidinyl group, a carbazolyl group, a fluorenyl group, a dibenzosilolyl group, a dibenzofuranyl group, a dibenzothiophenyl group, and $-Si(Q_3)(Q_4)(Q_5)$;

a methyl group, an ethyl group, an n-propyl group, an iso-propyl group, an n-butyl group, a sec-butyl group, an isobutyl group, a tert-butyl group, an n-pentyl group, a tert-pentyl group, a neopentyl group, an iso-pentyl group, a secpentyl group, a 3-pentyl group, a sec-isopentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group,

an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group, and a tert-decyl group, each substituted with at least one deuterium; and

a methoxy group, an ethoxy group, a propoxy group, a butoxy group, a pentoxy group, a cyclopentyl group, a cyclohexyl group, a cycloheptyl group, a cycloctyl group, an adamantanyl group, a norbornanyl group, a norbornenyl group, a cyclopentenyl group, a cyclohexenyl group, a cycloheptenyl group, bicyclo[1.1.1]pentyl, bicyclo[2.1.1]hexyl, bicyclo[2.2.1]heptyl, a bicyclo[2.2.2]octyl group, a phenyl group, a biphenyl group, a terphenyl group, a naphthyl group, a pyridinyl group, a pyrimidinyl group, a carbazolyl group, a fluorenyl group, a dibenzosilolyl group, a dibenzofuranyl group, and a dibenzothiophenyl group, each substituted with at least one selected from deuterium and a $C_1$-$C_{10}$ alkyl group, and

$Q_3$ to $Q_5$ are the same as described above.

In one or more embodiments, $R_1$ to $R_{12}$ and $R_{19}$ may each independently be selected from:

hydrogen, deuterium, -F, a cyano group, a nitro group, $-SF_5$, $-CH_3$, $-CD_3$, $-CD_2H$, $-CDH_2$, $-CF_3$, $-CF_2H$, $-CFH_2$, groups represented by Formulae 9-1 to 9-66, groups represented by Formulae 9-1 to 9-66 in which at least one hydrogen is substituted with deuterium, groups represented by Formulae 10-1 to 10-249, groups represented by Formulae 10-1 to 10-249 in which at least one hydrogen is substituted with deuterium, or $-Si(Q_3)(Q_4)(Q_5)$ (wherein $Q_3$ to $Q_5$ are the same as described above), but embodiments of the present disclosure are not limited thereto:

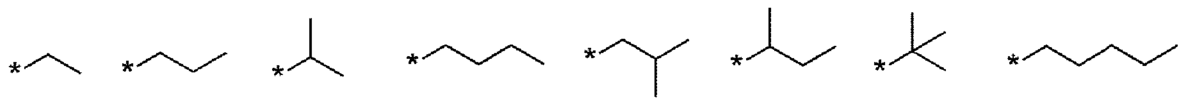

9-1 9-2 9-3 9-4 9-5 9-6 9-7 9-8

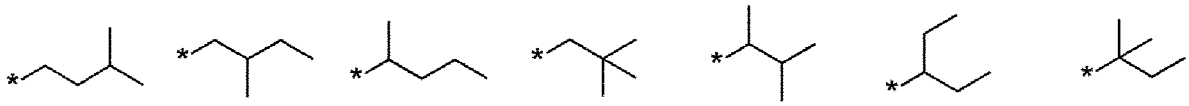

9-9 9-10 9-11 9-12 9-13 9-14 9-15

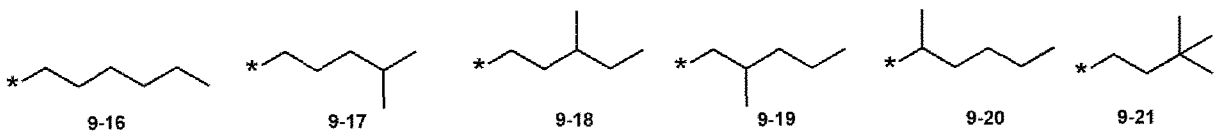

9-16 9-17 9-18 9-19 9-20 9-21

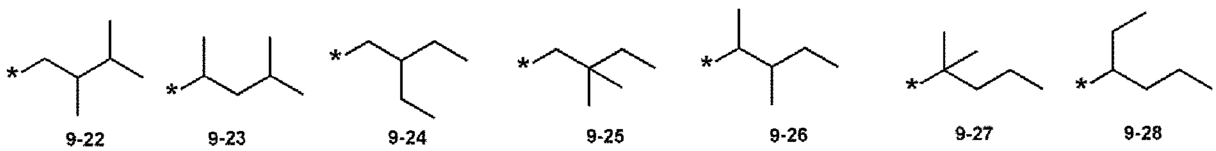

9-22 9-23 9-24 9-25 9-26 9-27 9-28

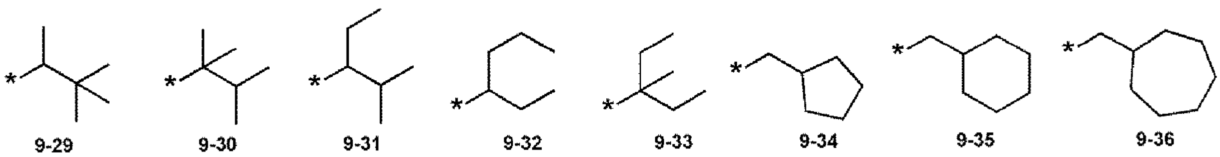

9-29 9-30 9-31 9-32 9-33 9-34 9-35 9-36

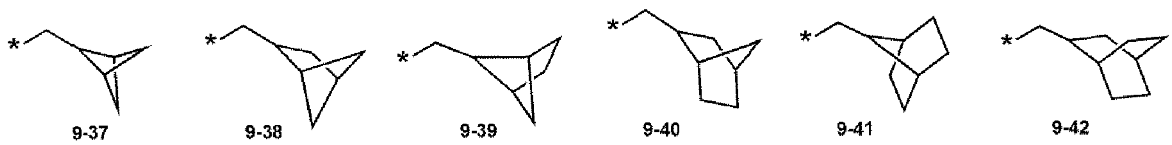

9-37 9-38 9-39 9-40 9-41 9-42

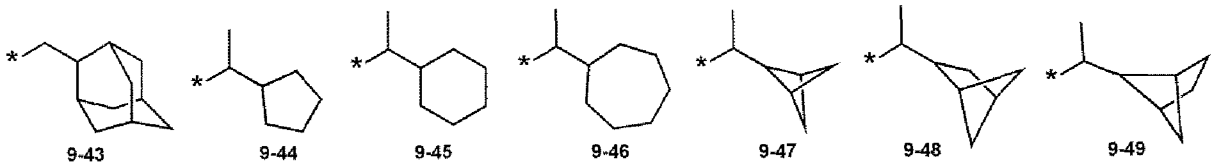

9-43 9-44 9-45 9-46 9-47 9-48 9-49

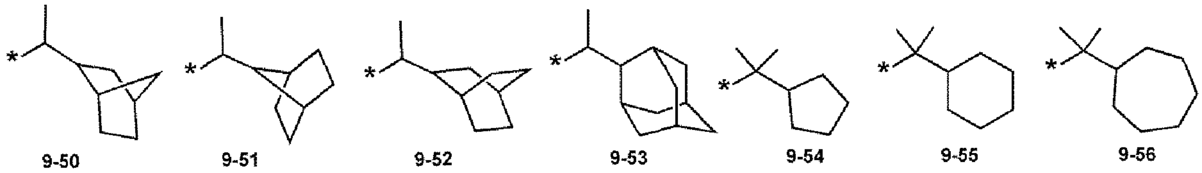

9-50 9-51 9-52 9-53 9-54 9-55 9-56

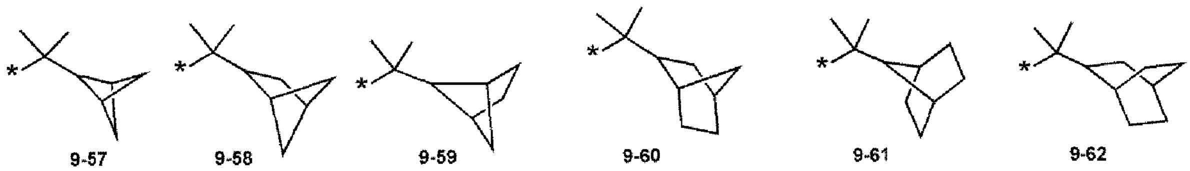

9-57 9-58 9-59 9-60 9-61 9-62

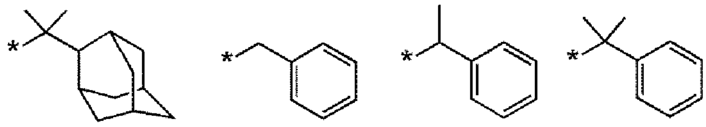

9-63 9-64 9-65 9-66

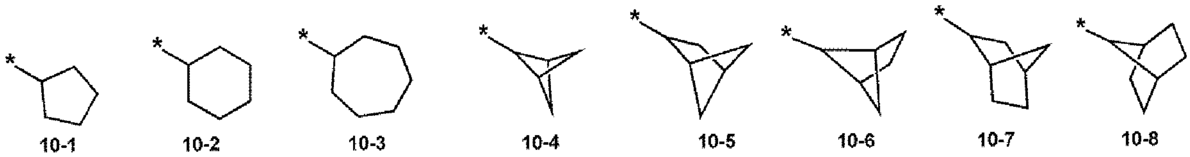

10-1 10-2 10-3 10-4 10-5 10-6 10-7 10-8

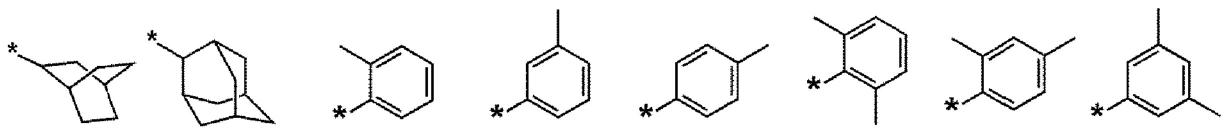

10-9 10-10 10-11 10-12 10-13 10-14 10-15 10-16

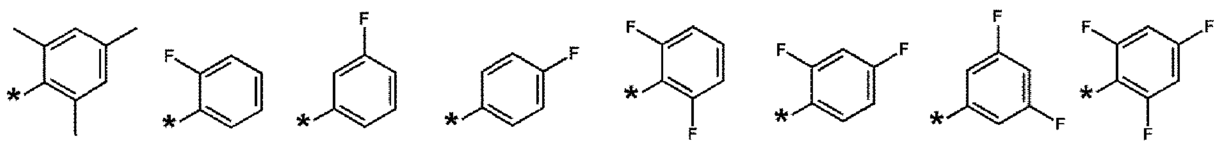

10-17 10-18 10-19 10-20 10-21 10-22 10-23 10-24

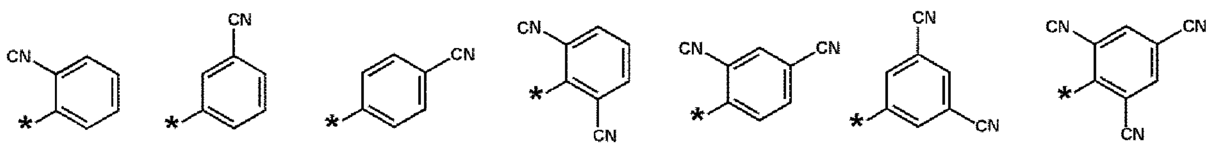

10-25 10-26 10-27 10-28 10-29 10-30 10-31

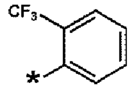
10-32

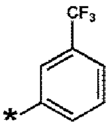
10-33

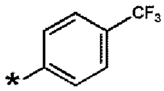
10-34

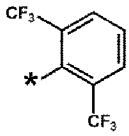
10-35

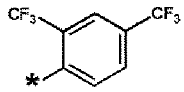
10-36

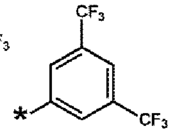
10-37

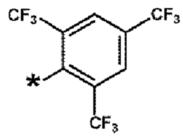
10-38

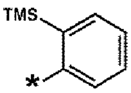
10-39

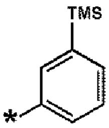
10-40

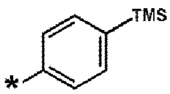
10-41

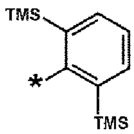
10-42

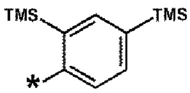
10-43

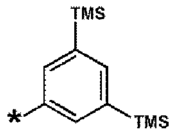
10-44

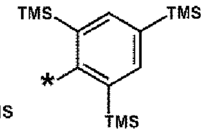
10-45

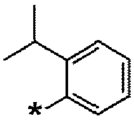
10-46

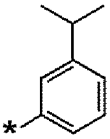
10-47

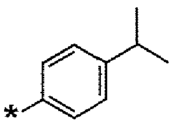
10-48

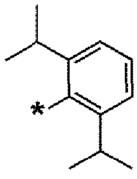
10-49

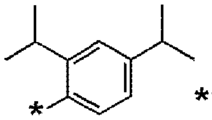
10-50

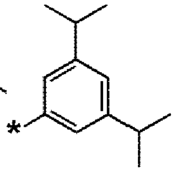
10-51

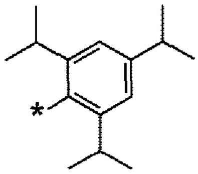
10-52

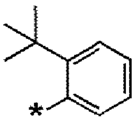
10-53

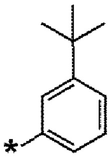
10-54

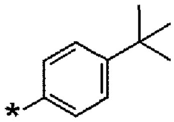
10-55

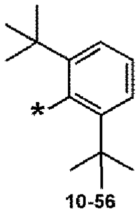
10-56

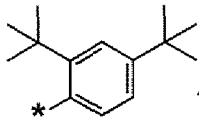
10-57

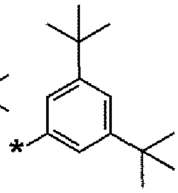
10-58

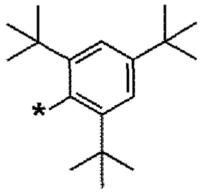
10-59

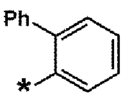
10-60

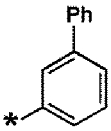
10-61

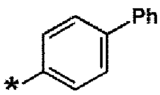
10-62

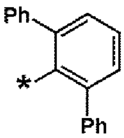
10-63

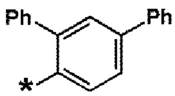
10-64

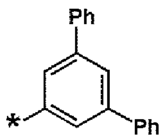
10-65

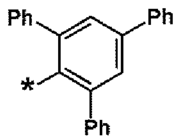
10-66

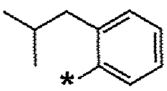
10-67

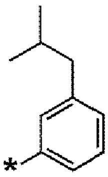
10-68

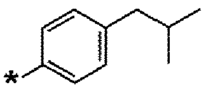
10-69

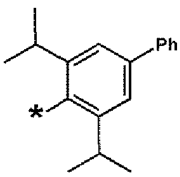
10-70

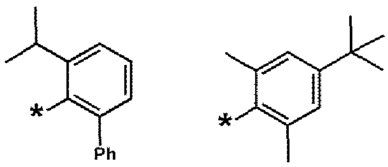
10-71

10-72

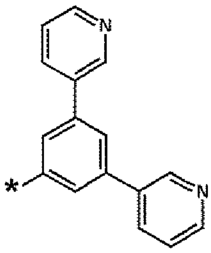
10-73
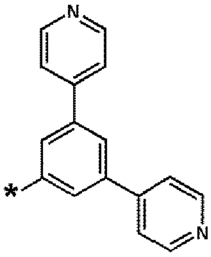
10-74
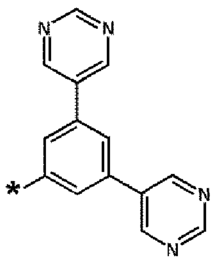
10-75
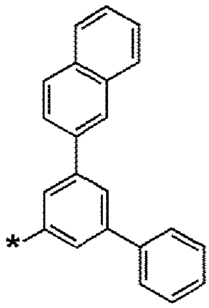
10-76
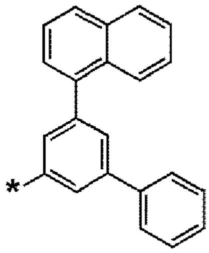
10-77

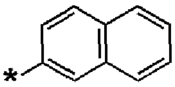
10-78
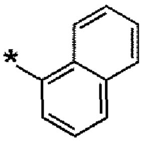
10-79
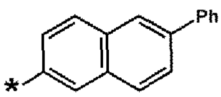
10-80
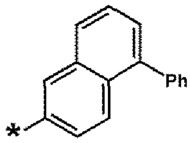
10-81
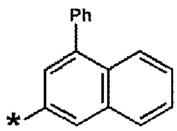
10-82

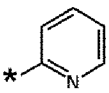
10-83
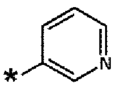
10-84
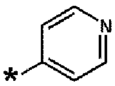
10-85
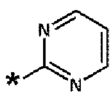
10-86
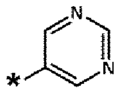
10-87
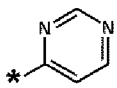
10-88
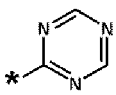
10-89

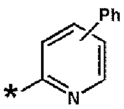
10-90
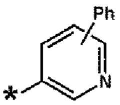
10-91
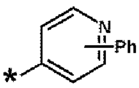
10-92
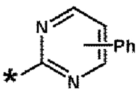
10-93
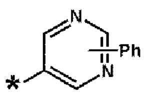
10-94
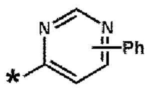
10-95
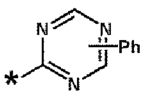
10-96

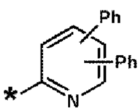
10-97
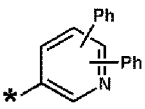
10-98
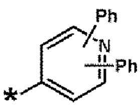
10-99
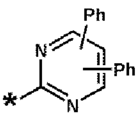
10-100
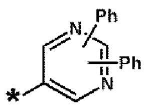
10-101
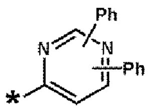
10-102
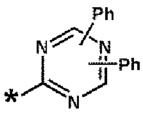
10-103

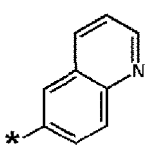
10-104
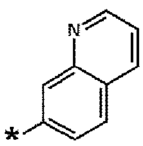
10-105
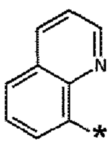
10-106
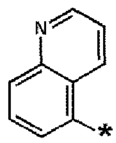
10-107
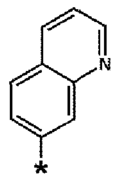
10-108
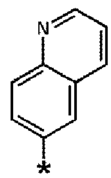
10-109

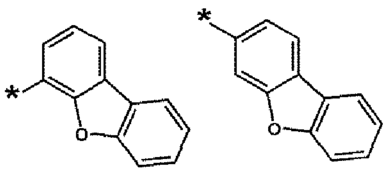
10-110
10-111
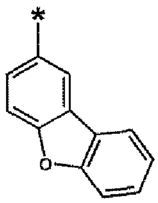
10-112
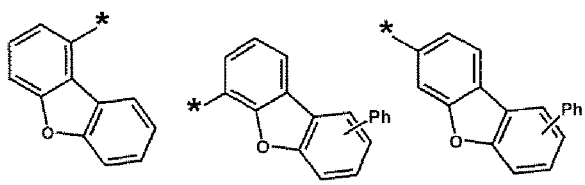
10-113
10-114
10-115

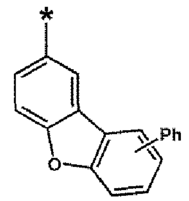
10-116

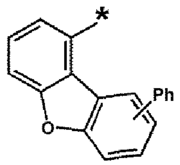
10-117

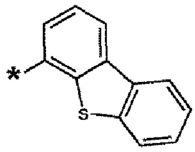
10-118

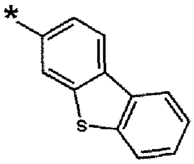
10-119

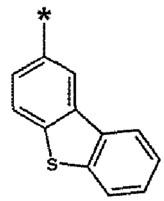
10-120

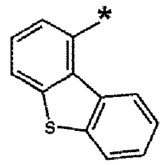
10-121

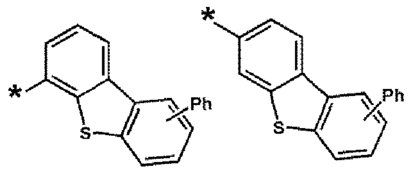
10-122

10-123

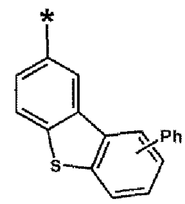
10-124

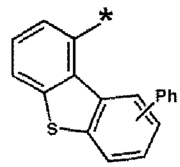
10-125

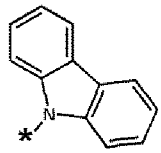
10-126

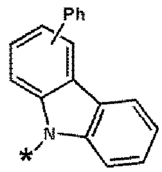
10-127

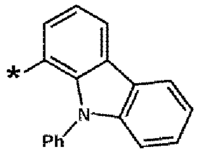
10-128

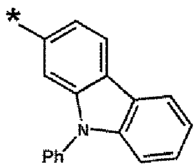
10-129

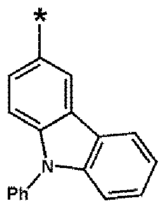
10-130

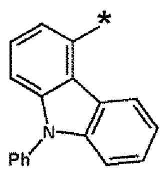
10-131

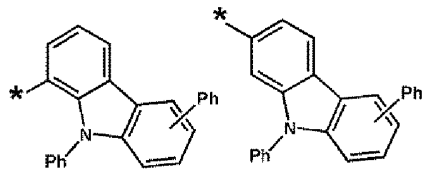
10-132

10-133

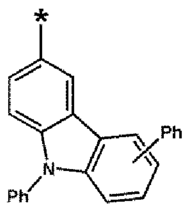
10-134

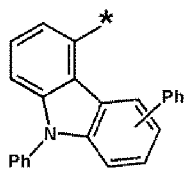
10-135

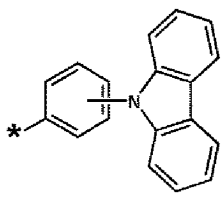
10-136

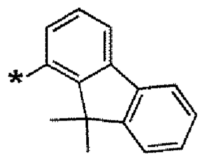
10-137

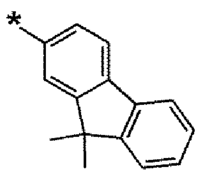
10-138

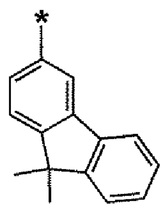
10-139

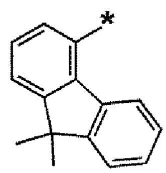
10-140

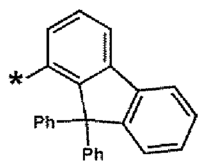
10-141

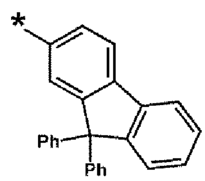
10-142

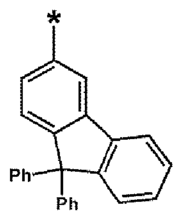
10-143

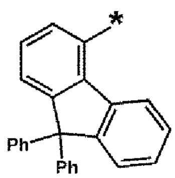
10-144

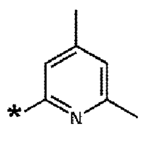
10-145

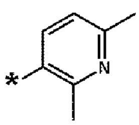
10-146

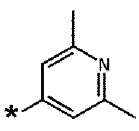
10-147

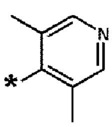
10-148

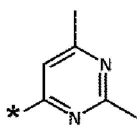
10-149

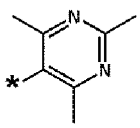
10-150

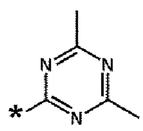
10-151

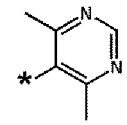
10-152

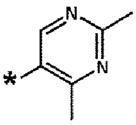
10-153

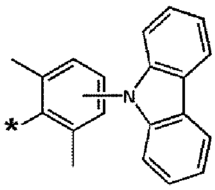
10-154

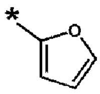
10-155

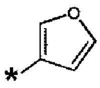
10-156

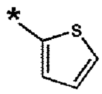
10-157

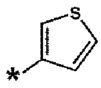
10-158

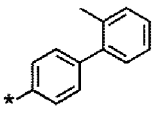
10-159

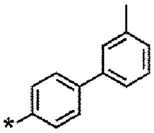
10-160

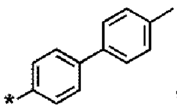
10-161

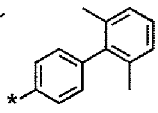
10-162

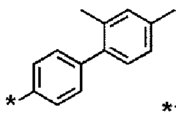
10-163

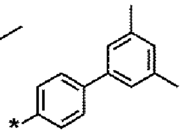
10-164

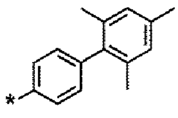
10-165

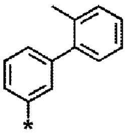
10-166

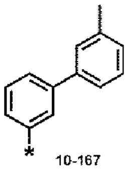
10-167

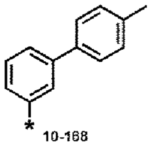
10-168

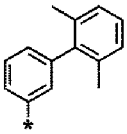
10-169

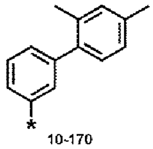
10-170

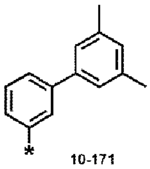
10-171

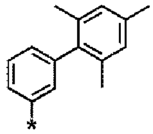
10-172

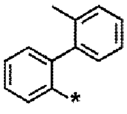
10-173

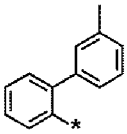
10-174

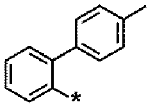
10-175

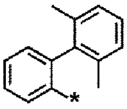
10-176

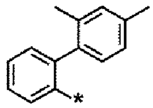
10-177

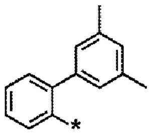
10-178

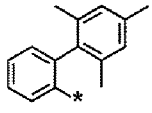
10-179

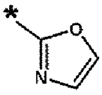
10-180

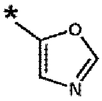
10-181

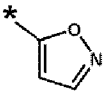
10-182

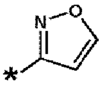
10-183

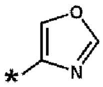
10-184

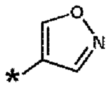
10-185

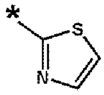
10-186

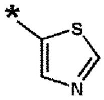
10-187

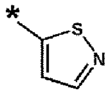
10-188

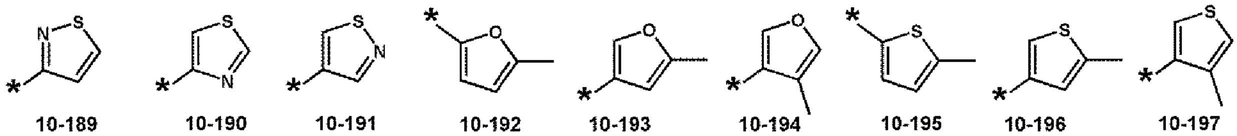
10-189 10-190 10-191 10-192 10-193 10-194 10-195 10-196 10-197

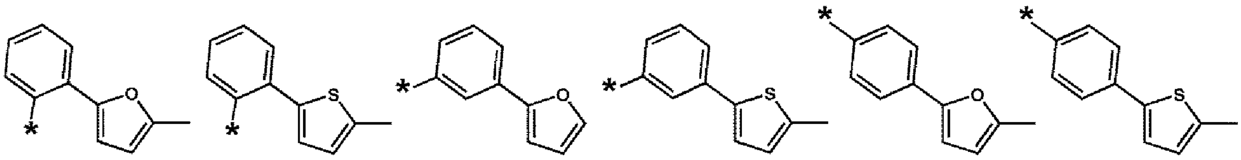
10-198 10-199 10-200 10-201 10-202 10-203

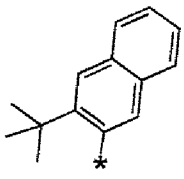 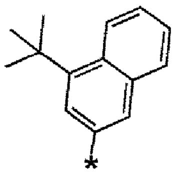 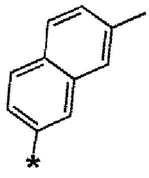 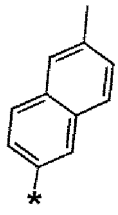 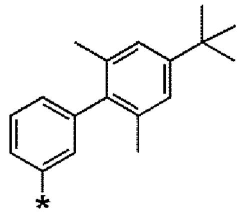 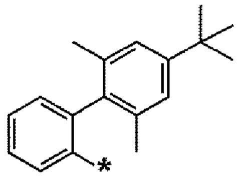

10-204 10-205 10-206 10-207 10-208 10-209

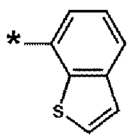 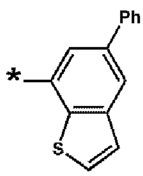 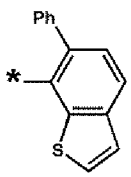 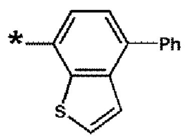 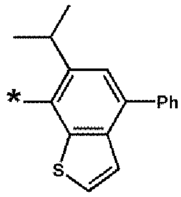 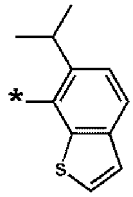 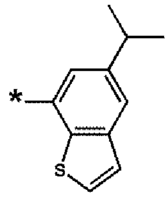

10-210 10-211 10-212 10-213 10-214 10-215 10-216

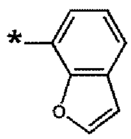 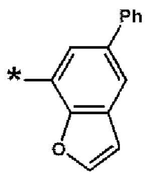 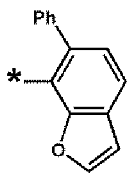 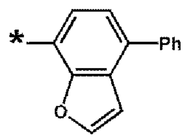 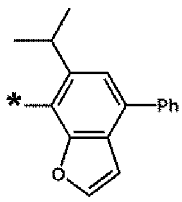 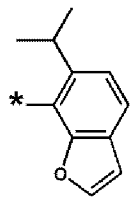 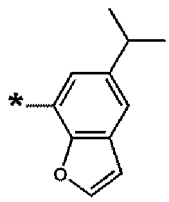

10-217 10-218 10-219 10-220 10-221 10-222 10-223

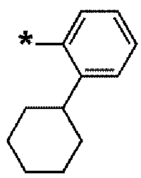 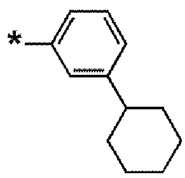 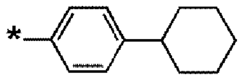 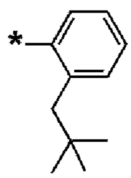 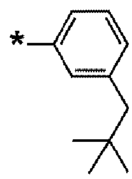 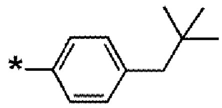

10-224 10-225 10-226 10-227 10-228 10-229

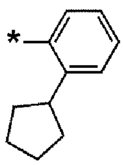 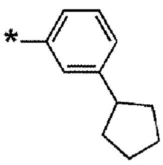 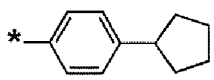 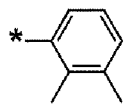 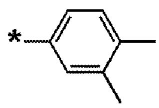 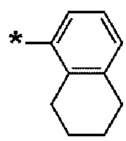 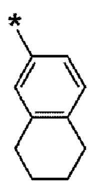

10-230 10-231 10-232 10-233 10-234 10-235 10-236

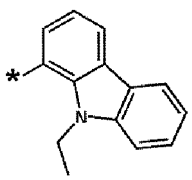 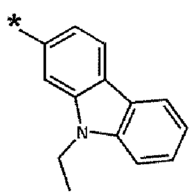 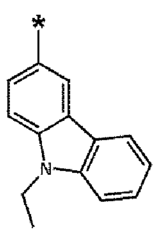 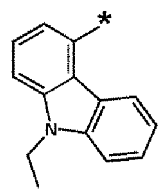 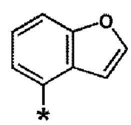 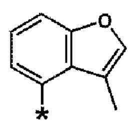

10-237 10-238 10-239 10-240 10-241 10-242

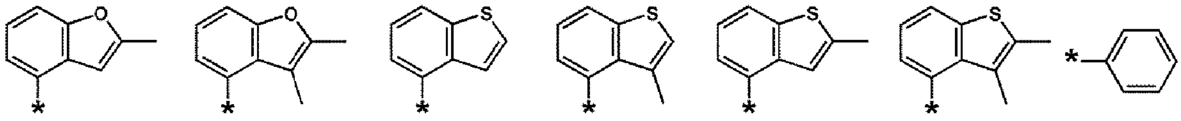

10-243 10-244 10-245 10-246 10-247 10-248 10-249 .

In Formulae 9-1 to 9-66 and 10-1 to 10-249, * indicates a binding site to a neighboring atom, Ph indicates a phenyl group, and TMS indicates a trimethylsilyl group.

The "groups represented by Formulae 9-1 to 9-66 in which at least one hydrogen is substituted with deuterium" may refer to, for example, groups represented by Formulae 9-501 to 9-552:

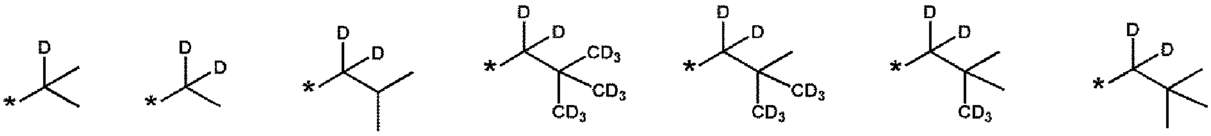

9-501 9-502 9-503 9-504 9-505 9-506 9-507

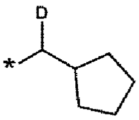 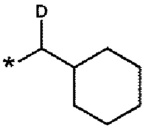 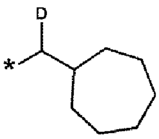 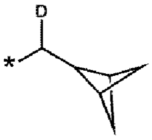 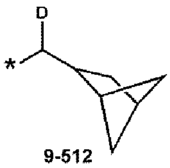 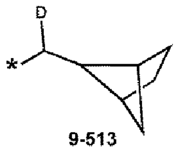 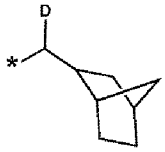

9-508 9-509 9-510 9-511 9-512 9-513 9-514

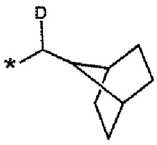 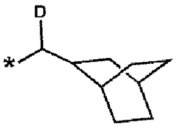 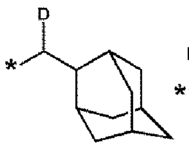 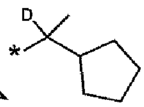 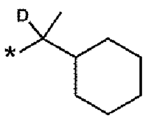 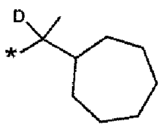 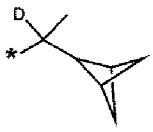

9-515 9-516 9-517 9-518 9-519 9-520 9-521

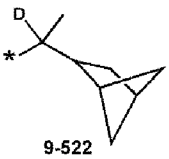 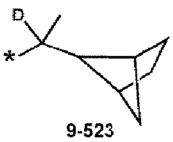 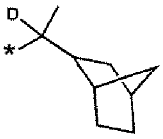 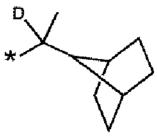 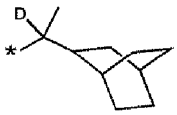 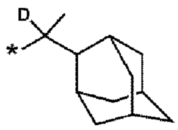

9-522 9-523 9-524 9-525 9-526 9-527

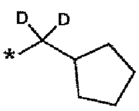 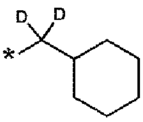 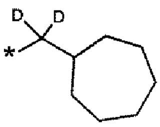 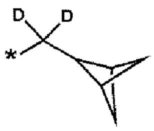 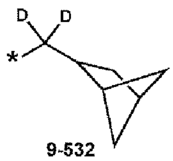 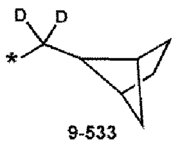 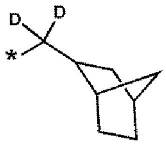

9-528 9-529 9-530 9-531 9-532 9-533 9-534

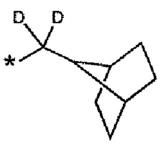 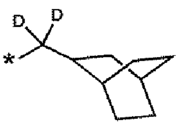 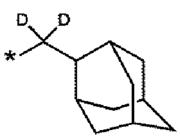 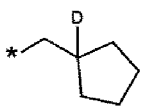 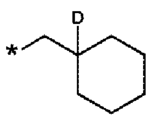 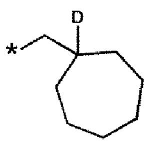

9-535 9-536 9-537 9-538 9-539 9-540

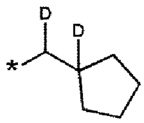
9-541
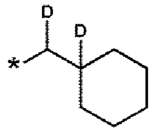
9-542
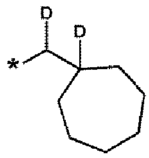
9-543
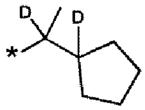
9-544
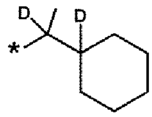
9-545
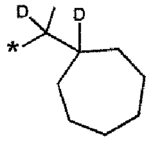
9-546
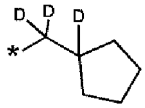
9-547

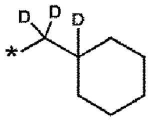
9-548
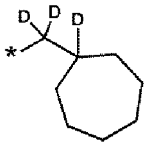
9-549
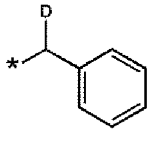
9-550
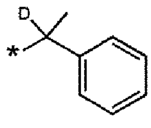
9-551
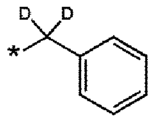
9-552

.

The "groups represented by Formulae 10-1 to 10-249 in which at least one hydrogen is substituted deuterium" may refer to, for example, groups represented by Formulae 10-501 to 10-510:

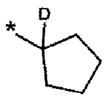
10-501
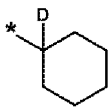
10-502
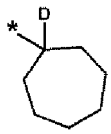
10-503
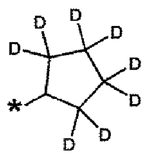
10-504
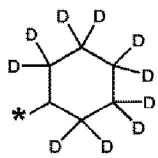
10-505
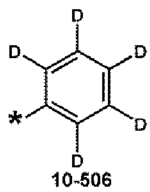
10-506
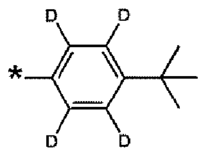
10-507

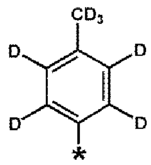
10-508
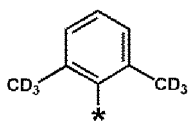
10-509
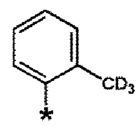
10-510

.

At least one selected from $R_1$ to $R_6$ may each independently be selected from groups represented by Formula 2:

<Formula 2>

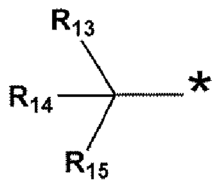

.

The number of carbon atoms included in Formula 2 may be 4 or more (for example, 4 to 20, 4 to 15 or 4 to 10),

$R_{13}$ in Formula 2 may be hydrogen, deuterium, a $C_1$-$C_{20}$ alkyl group, a deuterium-containing $C_1$-$C_{20}$ alkyl group, a $C_3$-$C_{10}$ cycloalkyl group, or a deuterium-containing $C_3$-$C_{10}$ cycloalkyl group,
$R_{14}$ and $R_{15}$ in Formula 2 may each independently be a $C_1$-$C_{20}$ alkyl group, a deuterium-containing $C_1$-$C_{20}$ alkyl group, a $C_3$-$C_{10}$ cycloalkyl group, or a deuterium-containing $C_3$-$C_{10}$ cycloalkyl group, and
* indicates a binding site to a neighboring atom.

The terms "deuterium-containing $C_1$-$C_{20}$ alkyl group" and "deuterium-containing $C_3$-$C_{10}$ cycloalkyl group" as used herein refer to a $C_1$-$C_{20}$ alkyl group and a $C_3$-$C_{10}$ cycloalkyl group, each substituted with at least one deuterium. For example, the deuterium-containing methyl group refers to $-CDH_2$, $-CD_2H$, and $-CD_3$.

The term "$C_1$-$C_{20}$ alkyl group" as used herein refers to, for example, a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, or a tert-decyl group, but embodiments of the present disclosure are not limited thereto.

The term "$C_3$-$C_{10}$ cycloalkyl group" as used herein refers to, for example, a cyclopentyl group, a cyclohexyl group, a cycloheptyl group, a cycloctyl group, an adamantanyl group, a norbornanyl group, a bicyclo[1.1.1]pentyl group, a bicyclo[2.1.1]hexyl group, a bicyclo[2.2.1]heptyl group, or a bicyclo[2.2.2]octyl group, but embodiments of the present disclosure are not limited thereto.

In one embodiment, one selected from $R_2$ to $R_5$ in Formula 1 may be a group represented by Formula 2.

In one or more embodiments, one selected from $R_2$ to $R_5$ in Formula 1 may be a group represented by Formula 2, and groups other than the one of $R_2$ to $R_5$ which is the groups represented by Formula 2 among $R_1$ to $R_6$ may be hydrogen.

In one or more embodiments, in Formula 1,

1) $R_2$ may be a group represented by Formula 2 and $R_1$ and $R_3$ to $R_6$ may be hydrogen,
2) $R_3$ may be a group represented by Formula 2 and $R_1$, $R_2$ and $R_4$ to $R_6$ may be hydrogen,
3) $R_4$ may be a group represented by Formula 2 and $R_1$ to $R_3$, $R_5$ and $R_6$ may be hydrogen,
4) $R_5$ may be a group represented by Formula 2 and $R_1$ to $R_4$ and $R_6$ may be hydrogen,
5) $R_4$ may be a group represented by Formula 2, $R_5$ may be a substituted or unsubstituted $C_1$-$C_{60}$ alkyl group, a substituted or unsubstituted $C_3$-$C_{10}$ cycloalkyl group, a phenyl group, a biphenyl group, or -Si($Q_3$)($Q_4$)($Q_5$) and $R_1$, $R_2$, $R_3$ and $R_6$ may be hydrogen,
6) $R_5$ may be a group represented by Formula 2, $R_3$ may be a substituted or unsubstituted $C_1$-$C_{60}$ alkyl group, a substituted or unsubstituted $C_3$-$C_{10}$ cycloalkyl group, a phenyl group, a biphenyl group, or -Si($Q_3$)($Q_4$)($Q_5$) and $R_1$, $R_2$, $R_4$ and $R_6$ may be hydrogen,
7) $R_2$ may be a group represented by Formula 2, $R_5$ may be a substituted or unsubstituted $C_1$-$C_{60}$ alkyl group, a substituted or unsubstituted $C_3$-$C_{10}$ cycloalkyl group, a phenyl group, a biphenyl group, or -Si($Q_3$)($Q_4$)($Q_5$) and $R_1$, $R_3$, $R_4$ and $R_6$ may be hydrogen,
8) $R_4$ may be a group represented by Formula 2, $R_6$ may be a substituted or unsubstituted $C_1$-$C_{60}$ alkyl group, a substituted or unsubstituted $C_3$-$C_{10}$ cycloalkyl group, a phenyl group, a biphenyl group, or -Si($Q_3$)($Q_4$)($Q_5$) and $R_1$, $R_2$, $R_3$ and $R_5$ may be hydrogen,
9) $R_3$ may be a group represented by Formula 2, $R_5$ may be a substituted or unsubstituted $C_1$-$C_{60}$ alkyl group, a substituted or unsubstituted $C_3$-$C_{10}$ cycloalkyl group, a phenyl group, a biphenyl group, or -Si($Q_3$)($Q_4$)($Q_5$) and $R_1$, $R_2$, $R_4$ and $R_6$ may be hydrogen, or
10) $R_2$ may be a group represented by Formula 2, $R_4$ and $R_5$ may each independently be a substituted or unsubstituted $C_1$-$C_{60}$ alkyl group, a substituted or unsubstituted $C_3$-$C_{10}$ cycloalkyl group, a phenyl group, a biphenyl group, or -Si($Q_3$)($Q_4$)($Q_5$) and $R_1$, $R_3$ and $R_6$ may be hydrogen.

In one or more embodiments, at least one of $R_7$ to $R_9$ in Formula 1 may not be hydrogen.

In one or more embodiments, at least one of $R_7$ to $R_9$ in Formula 1 may each independently be, a substituted or unsubstituted $C_1$-$C_{60}$ alkyl group, a substituted or unsubstituted $C_3$-$C_{10}$ cycloalkyl group, or a substituted or unsubstituted $C_6$-$C_{60}$ aryl group.

In one or more embodiments, at least one of $R_7$ to $R_9$ in Formula 1 may each independently be, a substituted or unsubstituted $C_2$-$C_{60}$ alkyl group, a substituted or unsubstituted $C_3$-$C_{10}$ cycloalkyl group, or a substituted or unsubstituted $C_6$-$C_{60}$ aryl group.

In one or more embodiments, in Formula 1,

1) $R_7$ and $R_9$ may not hydrogen and $R_8$ and $R_{19}$ may be hydrogen,
2) $R_7$ and $R_8$ may not hydrogen and $R_9$ and $R_{19}$ may be hydrogen,
3) $R_7$ to $R_9$ may not hydrogen and $R_{19}$ may be hydrogen, or
4) $R_7$ may not hydrogen and $R_8$, $R_9$ and $R_{19}$ may be hydrogen.

In one or more embodiments, $R_{19}$ in Formula 1 may be hydrogen.

In one or more embodiments, $R_7$ and $R_9$ in Formula 1 may not be hydrogen, and $R_7$ and $R_9$ may be identical to each other.

In one or more embodiments, $R_7$ and $R_9$ in Formula 1 may not be hydrogen, and $R_7$ and $R_9$ may be different

from each other.

In one or more embodiments, $R_7$ and $R_9$ in Formula 1 may not be hydrogen, $R_7$ and $R_9$ may be different from each other, and the number of carbon atoms included in $R_7$ may be greater than that of carbon atoms included in $R_9$.

In one or more embodiments, $R_{13}$ in Formula 2 may be hydrogen or deuterium.

In one or more embodiments, $R_{13}$ in Formula 2 may be a $C_1$-$C_{20}$ alkyl group, a deuterium-containing $C_1$-$C_{20}$ alkyl group, a $C_3$-$C_{10}$ cycloalkyl group, or a deuterium-containing $C_3$-$C_{10}$ cycloalkyl group.

In one or more embodiments, $R_{14}$ and $R_{15}$ in Formula 2 may be different from each other.

In one or more embodiments, in Formula 2,

$R_{13}$ may be hydrogen, deuterium, $-CH_3$, $-CDH_2$, $-CD_2H$, or $-CD_3$,
$R_{14}$ and $R_{15}$ may each independently be:

a methyl group, an ethyl group, an n-propyl group, an iso-propyl group, an n-butyl group, a sec-butyl group, an iso-butyl group, a tert-butyl group, an n-pentyl group, a tert-pentyl group, a neopentyl, an iso-pentyl group, a sec-pentyl group, a 3-pentyl group, a sec-isopentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group, a tert-decyl group, a cyclopentyl group, a cyclohexyl group, a cycloheptyl group, a cycloctyl group, an adamantanyl group, a norbornanyl group, a norbornenyl group, a cyclopentenyl group, a cyclohexenyl group, a cycloheptenyl group, bicyclo[1.1.1]pentyl, bicyclo[2.1.1]hexyl, bicyclo[2.2.1]heptyl, or a bicyclo[2.2.2]octyl group; or

a methyl group, an ethyl group, an n-propyl group, an iso-propyl group, an n-butyl group, a sec-butyl group, an iso-butyl group, a tert-butyl group, an n-pentyl group, a tert-pentyl group, a neopentyl, an iso-pentyl group, a sec-pentyl group, a 3-pentyl group, a sec-isopentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group, a tert-decyl group, a cyclopentyl group, a cyclohexyl group, a cycloheptyl group, a cycloctyl group, an adamantanyl group, a norbornanyl group, a norbornenyl group, a cyclopentenyl group, a cyclohexenyl group, a cycloheptenyl group, bicyclo[1.1.1]pentyl, bicyclo[2.1.1]hexyl, bicyclo[2.2.1]heptyl, or a bicyclo[2.2.2]octyl group, each substituted with at least one deuterium.

In one or more embodiments, in Formula 2, $R_{14}$ and $R_{15}$ may each independently be selected from $-CH_3$, $-CD_3$, $-CD_2H$, $-CDH_2$, $-CF_3$, $-CF_2H$, $-CFH_2$, groups represented by Formulae 9-1 to 9-33, groups represented by Formulae 9-1 to 9-33 in which at least one hydrogen is substituted with deuterium, groups represented by Formulae 10-1 to 10-10, and groups represented by Formulae 10-1 to 10-10 in which at least one hydrogen is substituted with deuterium, but embodiments of the present disclosure are not limited thereto.

In one or more embodiments, a case where $R_{13}$ to $R_{15}$ in Formula 2 are identical to each other may be excluded.

In one or more embodiments, $R_{13}$ to $R_{15}$ in Formula 2 may be different from each other.

In one or more embodiments, a case where each of $R_{13}$ to $R_{15}$ in Formula 2 is a methyl group may be excluded. That is, $R_{13}$, $R_{14}$ and $R_{15}$ in Formula 2 may not be a methyl group, simultaneously.

At least one selected from $R_{10}$ and $R_{12}$ in Formula 1 may be a group represented by Formula 3:

<Formula 3>

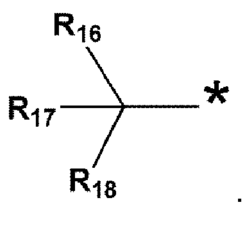

$R_{16}$ to $R_{18}$ in Formula 3 may each independently be selected from:

hydrogen, deuterium, a $C_1$-$C_{20}$ alkyl group, a $C_3$-$C_{10}$ cycloalkyl group, a $C_6$-C60 aryl group, and a $C_1$-$C_{60}$ heteroaryl group; and

a $C_1$-$C_{20}$ alkyl group, a $C_3$-$C_{10}$ cycloalkyl group, a $C_6$-$C_{60}$ aryl group, and a $C_1$-$C_{60}$ heteroaryl group, each substituted

with at least one selected from deuterium and a $C_1$-$C_{20}$ alkyl group, and
* indicates a binding site to a neighboring atom.

For example, $R_{16}$ to $R_{18}$ in Formula 3 may each independently be hydrogen or deuterium.
In one embodiment, one or more selected from $R_{16}$ to $R_{18}$ in Formula 3 may not be hydrogen and deuterium. That is, Formula 3 may include two or less benzylic protons.
In one embodiment, two or more selected from $R_{16}$ to $R_{18}$ in Formula 3 may not be hydrogen and deuterium. That is, Formula 3 may include one or less benzylic proton.
In one embodiment, $R_{16}$ to $R_{18}$ in Formula 3 may not be hydrogen and deuterium.
In one embodiment, in Formula 3,

$R_{16}$ to $R_{18}$ may each independently be hydrogen or deuterium,
$R_{16}$ to $R_{18}$ may each independently be a methyl group or a deuterium-containing methyl group,
$R_{16}$ and $R_{17}$ may each independently be hydrogen or deuterium, and $R_{18}$ may be a methyl group or a deuterium-containing methyl group,
$R_{16}$ and $R_{17}$ may each independently be hydrogen or deuterium, and $R_{18}$ may be a $C_2$-$C_{20}$ alkyl group or a deuterium-containing $C_2$-$C_{20}$ alkyl group,
$R_{16}$ may be hydrogen or deuterium, and $R_{17}$ and $R_{18}$ may each independently be a methyl group or a deuterium-containing methyl group,
$R_{16}$ may be hydrogen or deuterium, and $R_{17}$ and $R_{18}$ may each independently be a $C_2$-$C_{20}$ alkyl group or a deuterium-containing $C_2$-$C_{20}$ alkyl group,
$R_{16}$ may be a methyl group or a deuterium-containing methyl group, and $R_{17}$ and $R_{18}$ may each independently be a $C_2$-$C_{20}$ alkyl group or a deuterium-containing C2-C20 alkyl group, or
$R_{16}$ and $R_{17}$ may each independently be a methyl group or a deuterium-containing methyl group, and $R_{18}$ may be a $C_2$-$C_{20}$ alkyl group or a deuterium-containing $C_2$-$C_{20}$ alkyl group.

Examples of "the $C_2$-$C_{20}$ alkyl group or the deuterium-containing $C_2$-$C_{20}$ alkyl group" may include:

an ethyl group, an n-propyl group, an iso-propyl group, an n-butyl group, a sec-butyl group, an iso-butyl group, a tert-butyl group, an n-pentyl group, a tert-pentyl group, a neopentyl, an iso-pentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, and a tert-decyl group; and
an ethyl group, an n-propyl group, an iso-propyl group, an n-butyl group, a sec-butyl group, an iso-butyl group, a tert-butyl group, an n-pentyl group, a tert-pentyl group, a neopentyl, an iso-pentyl group, a sec-pentyl group, a 3-pentyl group, a sec-isopentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group, and a tert-decyl group, each substituted with at least one deuterium
but embodiments of the present disclosure are not limited thereto.

In one or more embodiments, $R_{10}$ and $R_{12}$ in Formula 1 may be identical to each other.
In one or more embodiments, $R_{10}$ and $R_{12}$ in Formula 1 may be different from each other.
For example, in Formula 1, $R_{10}$ may be an ethyl group, and $R_{12}$ may be a methyl group, an n-propyl group, or an isopropyl group, but embodiments of the present disclosure are not limited thereto.
In one or more embodiments, at least one of $R_{10}$, $R_{12}$ and $R_{14}$ in Formulae 1 and 2 may each independently be a $C_3$-$C_{10}$ cycloalkyl group, or a deuterium-containing $C_3$-$C_{10}$ cycloalkyl group.
Two or more selected from $R_1$ to $R_9$ and $R_{19}$ in Formula 1 may optionally be linked to form a $C_5$-$C_{30}$ carbocyclic group unsubstituted or substituted with at least one $R_{1a}$, or a $C_2$-$C_{30}$ heterocyclic group unsubstituted or substituted with at least one $R_{1a}$.
For example, two or more selected from $R_1$ to $R_9$ and $R_{19}$ in Formula 1 may optionally be linked to form a cyclopentadiene group, a cyclohexane group, a cycloheptane group, an adamantane group, a bicycle-heptane group, a bicycle-octane group, a benzene group, a pyridine group, a pyrimidine group, a pyrazine group, a pyridazine group, a naphthalene group, an anthracene group, a tetracene group, a phenanthrene group, a dihydronaphthalene group, a phenalene group, a benzofuran group, a benzothiophene group, a benzoselenophene group, an indole group, an indene group, a benzosilole group, an azabenzofuran group, an azabenzothiophene group, an azabenzoselenophene group,

an azaindole group, an azaindene group, and an azabenzosilole group, each unsubstituted or substituted with at least one $R_{1a}$, but embodiments of the present disclosure are not limited thereto.

$R_{1a}$ may be the same as defined in connection with $R_7$.

In one or more embodiments, the organometallic compound represented by Formula 1 may satisfy at least one of <Condition 1> to <Condition 6>:

<Condition 1>
At least one of $R_1$ to $R_3$, $R_5$ and $R_6$ in Formula 1 may not be hydrogen.
<Condition 2>
At least one of $R_7$ to $R_9$ in Formula 1 may each independently be a group having two more carbons.
<Condition 3>
At least one of $R_7$ to $R_9$ in Formula 1 may each independently be a substituted or unsubstituted $C_2$-$C_{60}$ alkyl group, a substituted or unsubstituted $C_3$-$C_{10}$ cycloalkyl group, or a substituted or unsubstituted $C_6$-$C_{60}$ aryl group.
<Condition 4>
At least one of $R_{10}$ and $R_{12}$ in Formula 1 may each independently be a group represented by Formula 3 and $R_{16}$ to $R_{18}$ in Formula 3 may not be hydrogen.
<Condition 5>
At least one of $R_{10}$ and $R_{12}$ in Formula 1 may each independently be a group represented by Formula 3 and at least one of $R_{16}$ to $R_{18}$ in Formula 3 may each independently be a $C_2$-$C_{20}$ alkyl group, a $C_3$-$C_{10}$ cycloalkyl group or a $C_6$-$C_{60}$ aryl group; or a $C_2$-$C_{20}$ alkyl group, a $C_3$-$C_{10}$ cycloalkyl group or a $C_6$-$C_{60}$ aryl group, each substituted with at least one selected from deuterium and a $C_1$-$C_{20}$ alkyl group.
<Condition 6>
At least one of $R_{10}$ and $R_{12}$ in Formula 1 may each independently be a substituted or unsubstituted $C_3$-$C_{10}$ cycloalkyl group.

In one or more embodiments, the organometallic compound may be one selected from Compounds 1 to 20, but embodiments of the present disclosure are not limited thereto:

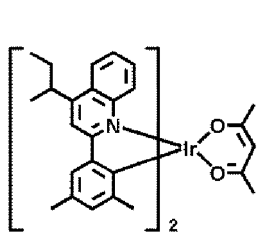

1

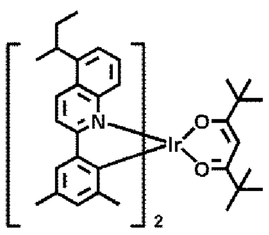

2

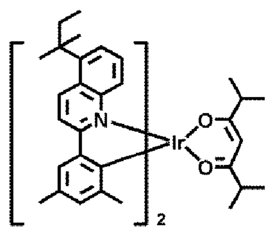

3

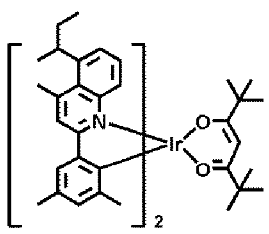

4

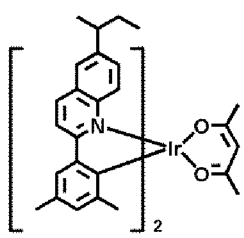

5

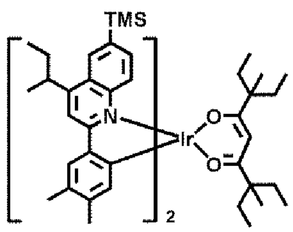

6

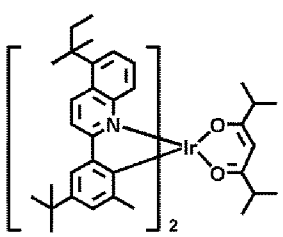

7

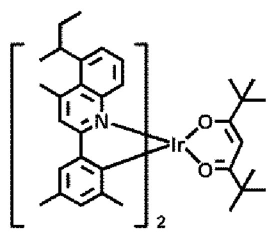

8

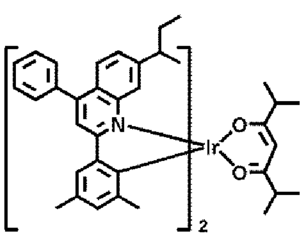

9

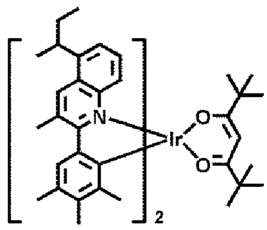

10

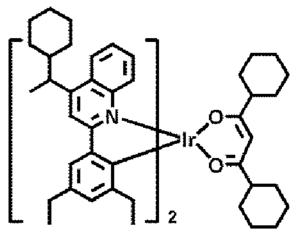

11

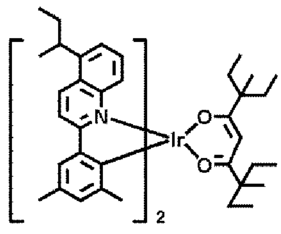

12

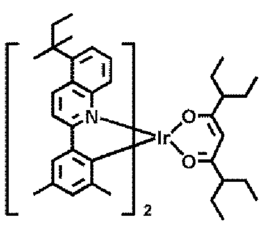

13

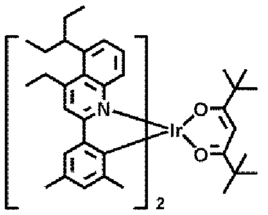

14

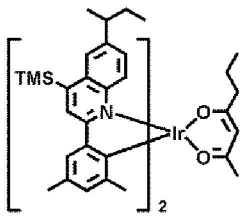

15

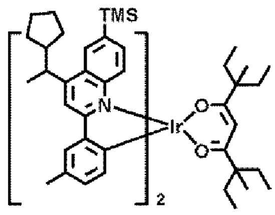

16

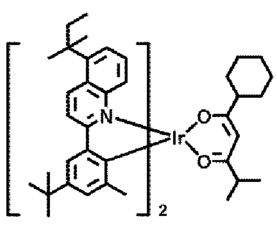

17

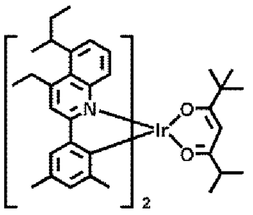

18

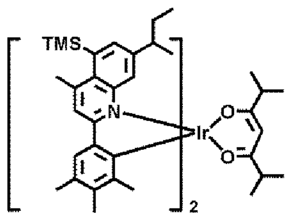

19

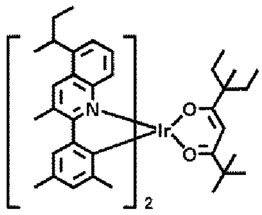

20

.

In Comopunds 1 to 20, TMS is a tri(methyl)silyl group.

Formula 1 has the structure as described herein, wherein at least one selected from $R_1$ to $R_6$ are each independently selected from groups represented by Formula 2:

<Formula 2>

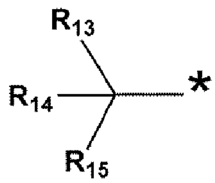

.

The number of carbon atoms included in Formula 2 may be 4 or more, $R_{13}$ may be hydrogen, deuterium, a $C_1$-$C_{20}$ alkyl group, a deuterium-containing $C_1$-$C_{20}$ alkyl group, a $C_3$-$C_{10}$ cycloalkyl group, or a deuterium-containing $C_3$-$C_{10}$ cycloalkyl group, $R_{14}$ and $R_{15}$ may each independently be a $C_1$-$C_{20}$ alkyl group, a deuterium-containing $C_1$-$C_{20}$ alkyl group, a $C_3$-$C_{10}$ cycloalkyl group, or a deuterium-containing $C_3$-$C_{10}$ cycloalkyl group, and * indicates a binding site to a neighboring atom.

That is, the group represented by Formula 2 is an alkyl group having one or less benzylic proton or a derivative thereof.

Although not limited to a specific theory, since the benzylic proton has high chemical reactivity, as compared with proton other than the benzylic proton, the benzylic proton may cause side reaction due to the generation of Intermediate in various forms. However, since at least one selected from $R_1$ to $R_6$ in Formula 1 is each independently a group represented by Formula 2 which is an alkyl group having one or less benzylic proton or a derivative thereof, the organometallic compound represented by Formula 1 has a stable chemical structure in which the generation of side reaction

before and after synthesis is minimized. In addition, interaction between the organometallic compound molecules may be minimized during the driving of an electronic device (for example, an organic light-emitting device) including the organometallic compound represented by Formula 1. Therefore, the electronic device, for example, the organic light-emitting device, which includes the organometallic compound represented by Formula 1, may have improved driving voltage, improved current density, improved external quantum luminescence efficiency, improved roll off ratio, and improved lifespan.

Furthermore, $R_{13}$, $R_{14}$ and $R_{15}$ in Formula 2 are not a methyl group, simultaneously. That is, a group represented by Formula 2 is not a tert-butyl (t-butyl) group. Although not limited to a specific theory, t-butyl group may be decomposed from a quinoline ring of Formula 1 to be t-butyl radical (or, t-butyl cation), which causes a decrease of lifespan of the electronic device, for example, the organic light-emitting device. However, since a group represented by Formula 2 is not a tert-butyl (t-butyl) group, the lifespan of the electronic device, for example, the organic light-emitting device, which includes the organometallic compound represented by Formula 1, may not be substantially decreased.

Synthesis methods of the organometallic compound represented by Formula 1 may be recognizable by one of ordinary skill in the art by referring to Synthesis Examples provided below.

The organometallic compound represented by Formula 1 is suitable for use in an organic layer of an organic light-emitting device, for example, for use as a dopant in an emission layer of the organic layer. Thus, another aspect provides an organic light-emitting device that includes: a first electrode; a second electrode; and an organic layer that is disposed between the first electrode and the second electrode and includes an emission layer, wherein the organic layer includes at least one of the organometallic compound represented by Formula 1.

The organic light-emitting device may have, due to the inclusion of an organic layer including the organometallic compound represented by Formula 1, improved driving voltage, improved current density, improved external quantum luminescence efficiency, improved roll off ratio, and improved lifespan.

The organometallic compound of Formula 1 may be used between a pair of electrodes of an organic light-emitting device. For example, the organometallic compound represented by Formula 1 may be included in the emission layer. In this regard, the organometallic compound may act as a dopant, and the emission layer may further include a host (that is, in the emission layer, an amount of the organometallic compound represented by Formula 1 is smaller than an amount of the host).

In one embodiment, the emission layer may emit red light.

The expression "(an organic layer) includes at least one of organometallic compounds" as used herein may include a case in which "(an organic layer) includes identical organometallic compounds represented by Formula 1" and a case in which "(an organic layer) includes two or more different organometallic compounds represented by Formula 1."

For example, the organic layer may include, as the organometallic compound, only Compound 1. In this regard, Compound 1 may exist in an emission layer of the organic light-emitting device. In one or more embodiments, the organic layer may include, as the organometallic compound, Compound 1 and Compound 2. In this regard, Compound 1 and Compound 2 may exist in an identical layer (for example, Compound 1 and Compound 2 all may exist in an emission layer).

The first electrode may be an anode, which is a hole injection electrode, and the second electrode may be a cathode, which is an electron injection electrode; or the first electrode may be a cathode, which is an electron injection electrode, and the second electrode may be an anode, which is a hole injection electrode.

In one embodiment, in the organic light-emitting device, the first electrode is an anode, and the second electrode is a cathode, and the organic layer further includes a hole transport region between the first electrode and the emission layer and an electron transport region between the emission layer and the second electrode, and the hole transport region includes a hole injection layer, a hole transport layer, an electron blocking layer, a buffer layer, or any combination thereof, and the electron transport region includes a hole blocking layer, an electron transport layer, an electron injection layer, or any combination thereof.

The term "organic layer" as used herein refers to a single layer and/or a plurality of layers between the first electrode and the second electrode of the organic light-emitting device. The "organic layer" may include, in addition to an organic compound, an organometallic complex including metal.

FIGURE is a schematic view of an organic light-emitting device 10 according to an embodiment. Hereinafter, the structure of an organic light-emitting device according to an embodiment and a method of manufacturing an organic light-emitting device according to an embodiment will be described in connection with the FIGURE. The organic light-emitting device 10 includes a first electrode 11, an organic layer 15, and a second electrode 19, which are sequentially stacked.

A substrate may be additionally disposed under the first electrode 11 or above the second electrode 19. For use as the substrate, any substrate that is used in general organic light-emitting devices may be used, and the substrate may be a glass substrate or a transparent plastic substrate, each having excellent mechanical strength, thermal stability, transparency, surface smoothness, ease of handling, and water resistance.

The first electrode 11 may be formed by depositing or sputtering a material for forming the first electrode 11 on the substrate. The first electrode 11 may be an anode. The material for forming the first electrode 11 may be selected

from materials with a high work function to facilitate hole injection. The first electrode 11 may be a reflective electrode, a semi-transmissive electrode, or a transmissive electrode. The material for forming the first electrode may be, for example, indium tin oxide (ITO), indium zinc oxide (IZO), tin oxide ($SnO_2$), and zinc oxide (ZnO). In one or more embodiments, magnesium (Mg), aluminum (Al), aluminum-lithium (Al-Li), calcium (Ca), magnesium-indium (Mg-In), or magnesium-silver (Mg-Ag) may be used as the material for forming the first electrode.

The first electrode 11 may have a single-layered structure or a multi-layered structure including two or more layers. For example, the first electrode 11 may have a three-layered structure of ITO/Ag/ITO, but the structure of the first electrode 110 is not limited thereto.

The organic layer 15 is disposed on the first electrode 11.

The organic layer 15 may include a hole transport region, an emission layer, and an electron transport region.

The hole transport region may be disposed between the first electrode 11 and the emission layer.

The hole transport region may include a hole injection layer, a hole transport layer, an electron blocking layer, a buffer layer, or any combination thereof.

The hole transport region may include only either a hole injection layer or a hole transport layer. In one or more embodiments, the hole transport region may have a hole injection layer/hole transport layer structure or a hole injection layer/hole transport layer/electron blocking layer structure, which are sequentially stacked in this stated order from the first electrode 11.

A hole injection layer may be formed on the first electrode 11 by using one or more suitable methods selected from vacuum deposition, spin coating, casting, or Langmuir-Blodgett (LB) deposition.

When a hole injection layer is formed by vacuum deposition, the deposition conditions may vary according to a compound that is used to form the hole injection layer, and the structure and thermal characteristics of the hole injection layer. For example, the deposition conditions may include a deposition temperature of about 100 °C to about 500 °C, a vacuum pressure of about $10^{-8}$ torr to about $10^{-3}$ torr, and a deposition rate of about 0.01 Å/sec to about 100 Å/sec. However, the deposition conditions are not limited thereto.

When the hole injection layer is formed using spin coating, coating conditions may vary according to the material used to form the hole injection layer, and the structure and thermal properties of the hole injection layer. For example, a coating speed may be from about 2,000 rpm to about 5,000 rpm, and a temperature at which a heat treatment is performed to remove a solvent after coating may be from about 80 °C to about 200 °C. However, the coating conditions are not limited thereto.

Conditions for forming a hole transport layer and an electron blocking layer may be understood by referring to conditions for forming the hole injection layer.

The hole transport region may include at least one selected from m-MTDATA, TDATA, 2-TNATA, NPB, β-NPB, TPD, Spiro-TPD, Spiro-NPB, methylated-NPB, TAPC, HMTPD, 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonicacid (PANI/CSA), polyaniline/poly(4-styrenesulfonate) (PANI/PSS), a compound represented by Formula 201 below, and a compound represented by Formula 202 below:

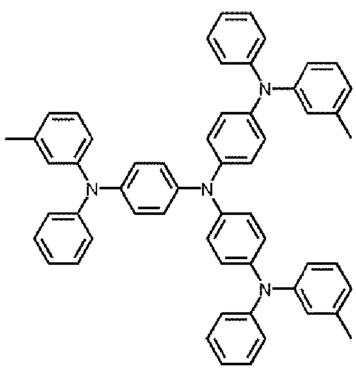

m-MTDATA

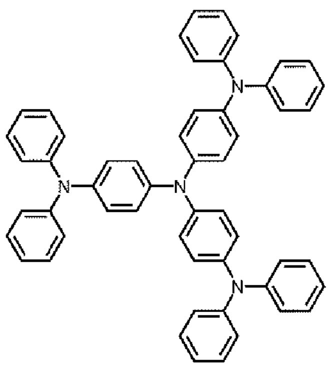

TDATA

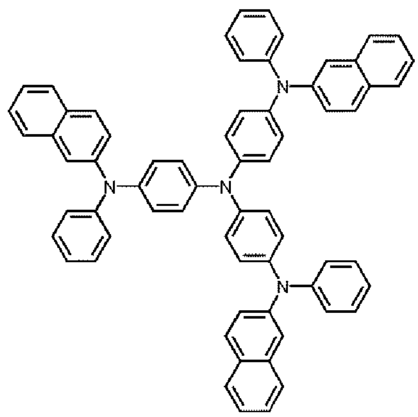

2-TNATA

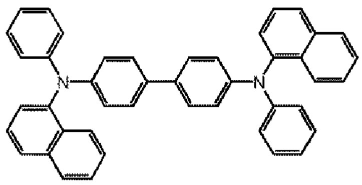

NPB

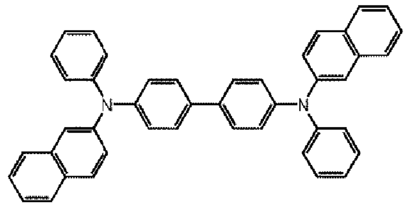

β-NPB

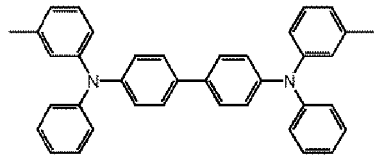

TPD

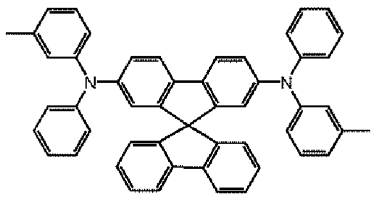

Spiro-TPD

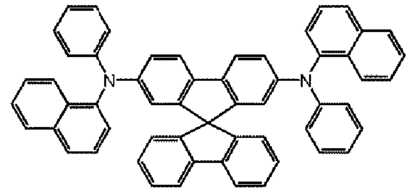

Spiro-NPB

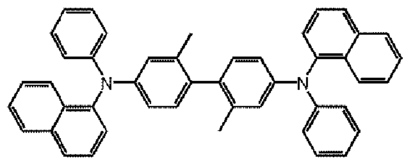

methylated NPB

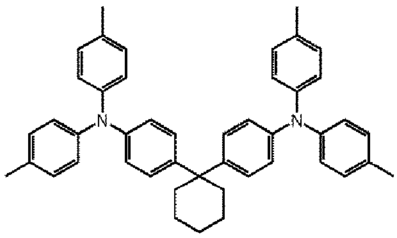

TAPC

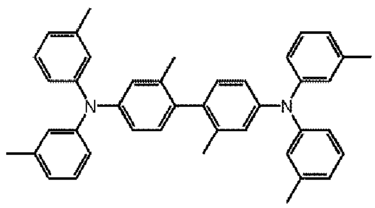

HMTPD

<Formula 201>

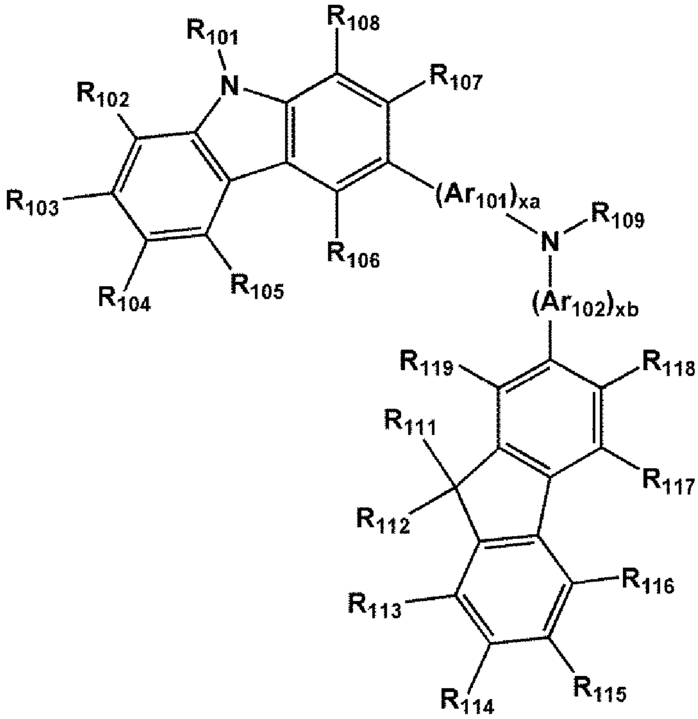

<Formula 202>

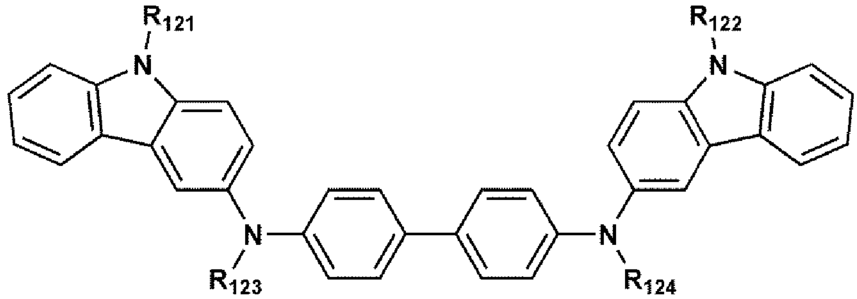

$Ar_{101}$ and $Ar_{102}$ in Formula 201 may each independently be selected from:

a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, and a pentacenylene group; and

a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, and a pentacenylene group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_3$-$C_{10}$ cycloalkenyl group, a $C_1$-$C_{10}$ heterocycloalkyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, and a monovalent non-aromatic condensed heteropolycyclic group.

In Formula 201, xa and xb may each independently be an integer from 0 to 5, or may be 0, 1, or 2. For example, xa is 1 and xb is 0, but xa and xb are not limited thereto.

$R_{101}$ to $R_{108}$, $R_{111}$ to $R_{119}$, and $R_{121}$ to $R_{124}$ in Formulae 201 and 202 may each independently be selected from:

hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group (for example, a methyl group, an ethyl group, a propyl group, a butyl group, a pentyl group, a hexyl group, and so on), or a $C_1$-$C_{10}$ alkoxy group (for example, a methoxy group, an ethoxy group, a propoxy group, a butoxy group, a pentoxy group, and so on);

a $C_1$-$C_{10}$ alkyl group or a $C_1$-$C_{10}$ alkoxy group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, and a phosphoric acid group or a salt thereof;

a phenyl group, a naphthyl group, an anthracenyl group, a fluorenyl group, and a pyrenyl group; and

a phenyl group, a naphthyl group, an anthracenyl group, a fluorenyl group, and a pyrenyl group, each substituted with at least one selected from deuterium, -F, - Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group, and a $C_1$-$C_{10}$ alkoxy group, but embodiments of the present disclosure are not limited thereto.

$R_{109}$ in Formula 201 may be selected from:

a phenyl group, a naphthyl group, an anthracenyl group, and a pyridinyl group; and

a phenyl group, a naphthyl group, an anthracenyl group, and a pyridinyl group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy

group, a phenyl group, a naphthyl group, an anthracenyl group, and a pyridinyl group.

In one embodiment, the compound represented by Formula 201 may be represented by Formula 201A, but embodiments of the present disclosure are not limited thereto:

<Formula 201A>

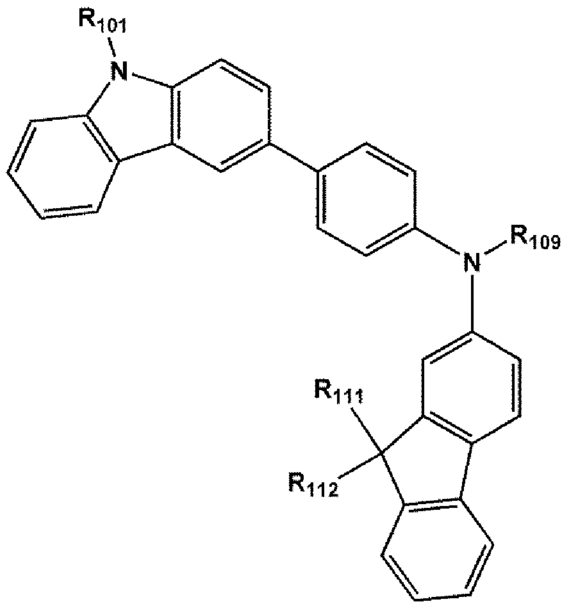

$R_{101}$, $R_{111}$, $R_{112}$, and $R_{109}$ in Formula 201A may be understood by referring to the description provided herein.

For example, the compound represented by Formula 201, and the compound represented by Formula 202 may include compounds HT1 to HT20 illustrated below, but are not limited thereto.

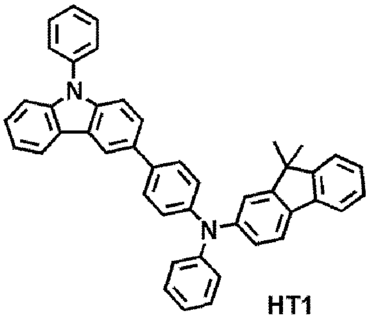
HT1

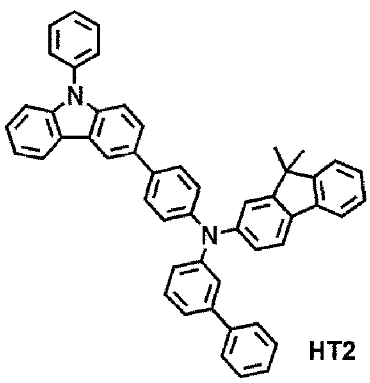
HT2

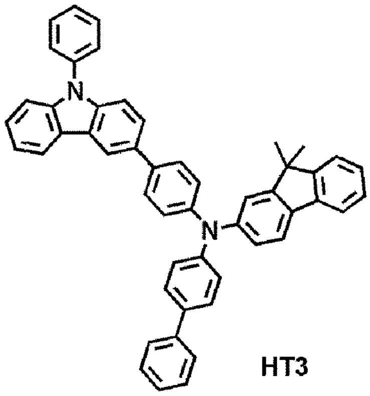
HT3

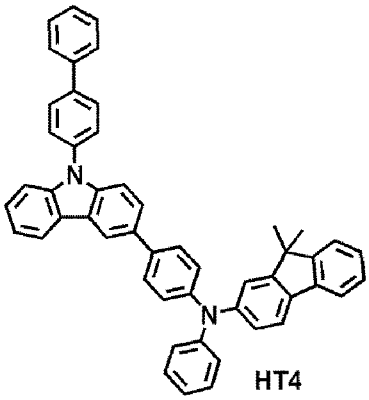

HT4

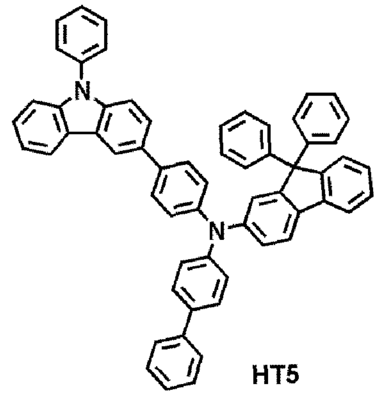

HT5

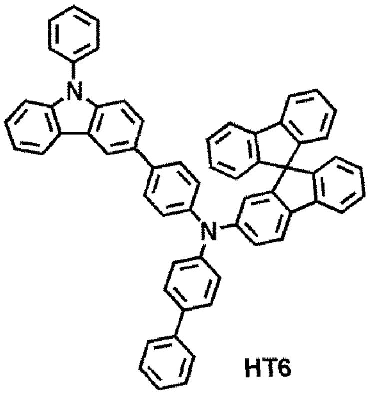

HT6

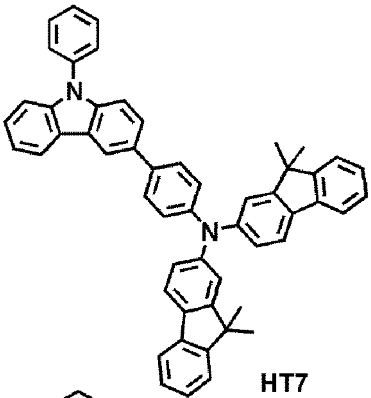

HT7

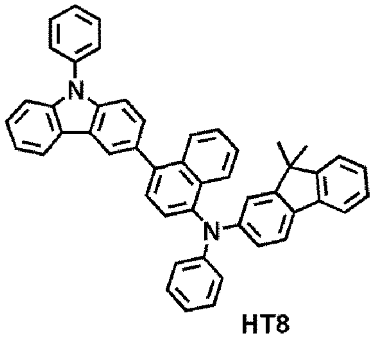

HT8

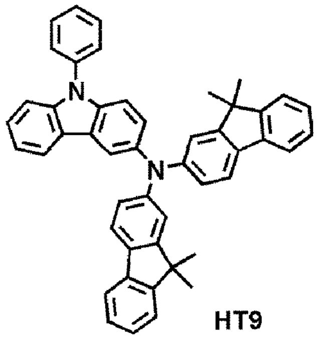

HT9

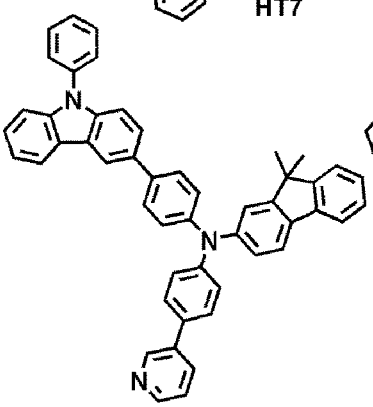

HT10

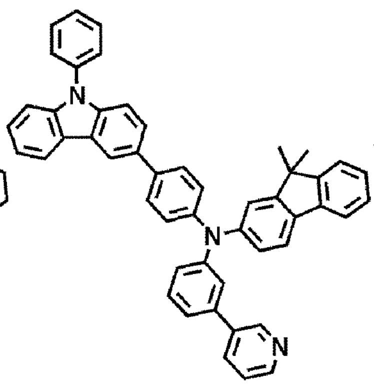

HT11

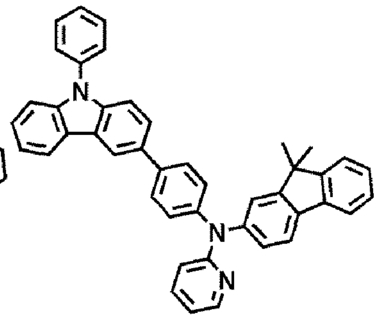

HT12

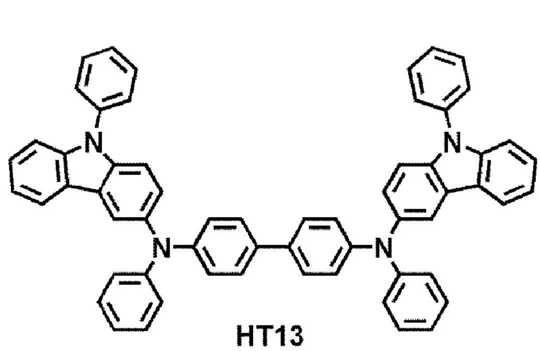

HT13

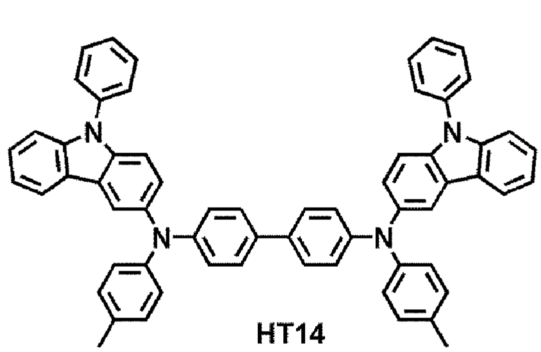

HT14

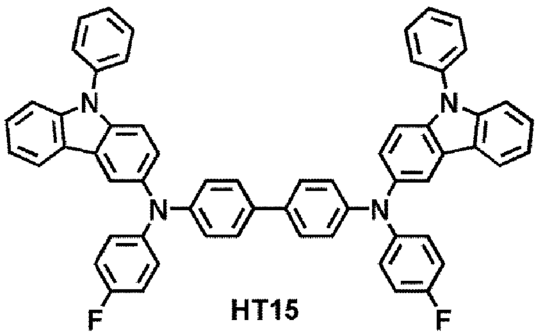
HT15

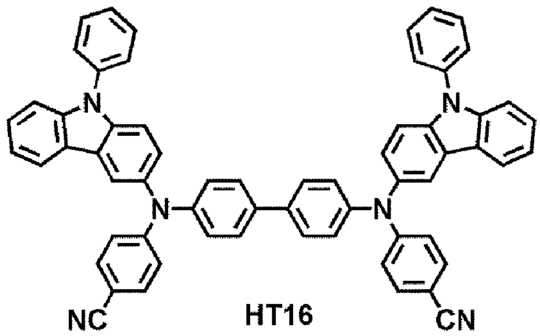
HT16

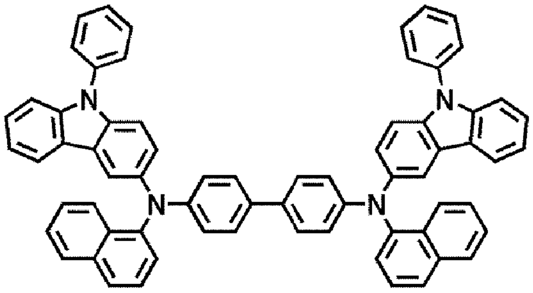
HT17

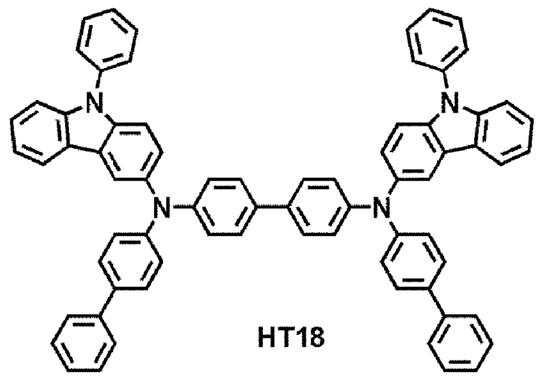
HT18

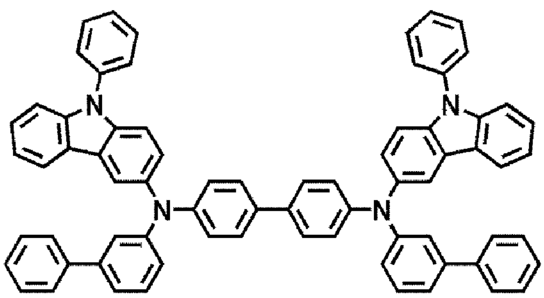
HT19

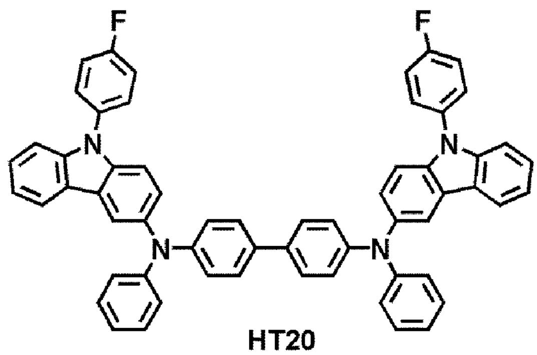
HT20

A thickness of the hole transport region may be in a range of about 100 Å to about 10,000 Å, for example, about 100 Å to about 1,000 Å. When the hole transport region includes at least one of a hole injection layer and a hole transport layer, the thickness of the hole injection layer may be in a range of about 100 Å to about 10,000 Å, and for example, about 100 Å to about 1,000 Å, and the thickness of the hole transport layer may be in a range of about 50 Å to about 2,000 Å, and for example, about 100 Å to about 1,500 Å. When the thicknesses of the hole transport region, the hole injection layer, and the hole transport layer are within these ranges, satisfactory hole transporting characteristics may be obtained without a substantial increase in driving voltage.

The hole transport region may further include, in addition to these materials, a charge-generation material for the improvement of conductive properties. The charge-generation material may be homogeneously or non-homogeneously dispersed in the hole transport region.

The charge-generation material may be, for example, a p-dopant. The p-dopant may be one selected from a quinone derivative, a metal oxide, and a cyano group-containing compound, but embodiments of the present disclosure are not limited thereto. Non-limiting examples of the p-dopant are a quinone derivative, such as tetracyanoquinonedimethane (TCNQ) or 2,3,5,6-tetrafluoro-tetracyano-1,4-benzoquinonedimethane (F4-TCNQ); a metal oxide, such as a tungsten oxide or a molybdenium oxide; or a cyano group-containing compound, such as Compound HT-D1 below, but are not limited thereto.

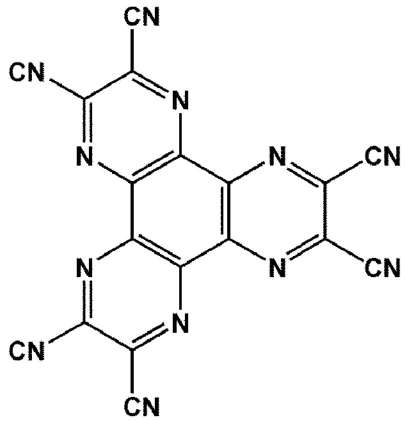

HT-D1

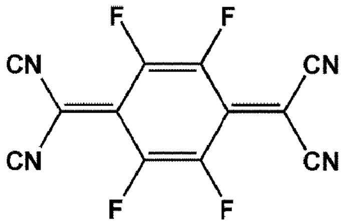

F4-TCNQ

The hole transport region may include a buffer layer.

Also, the buffer layer may compensate for an optical resonance distance according to a wavelength of light emitted from the emission layer, and thus, efficiency of a formed organic light-emitting device may be improved.

Then, an emission layer may be formed on the hole transport region by vacuum deposition, spin coating, casting, LB deposition, or the like. When the emission layer is formed by vacuum deposition or spin coating, the deposition or coating conditions may be similar to those applied in forming the hole injection layer although the deposition or coating conditions may vary according to a compound that is used to form the emission layer.

Meanwhile, when the hole transport region includes an electron blocking layer, a material for the electron blocking layer may be selected from materials for the hole transport region described above and/or materials for a host to be explained later. However, the material for the electron blocking layer is not limited thereto. For example, when the hole transport region includes an electron blocking layer, a material for the electron blocking layer may be mCP, which will be explained later.

The emission layer may include a host and a dopant, and the dopant may include the organometallic compound represented by Formula 1.

The host may include at least one selected from TPBi, TBADN, ADN (also referred to as "DNA"), CBP, CDBP, TCP, mCP, Compound H50, and Compound H51:

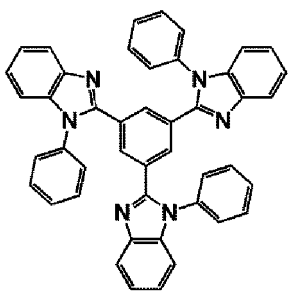

TPBi

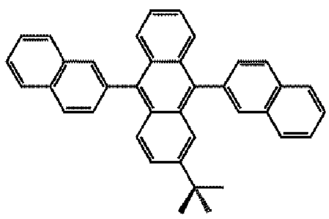

TBADN

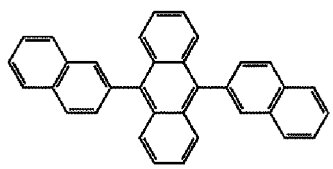

ADN

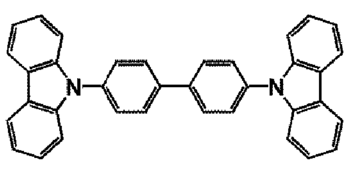

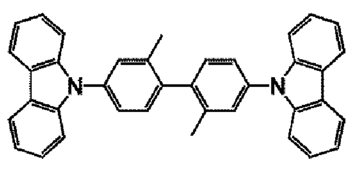

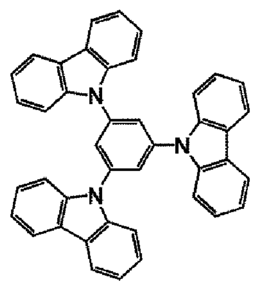

CBP

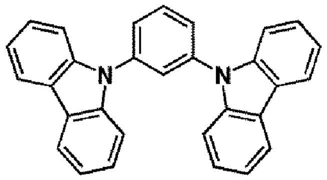

mCP

CDBP

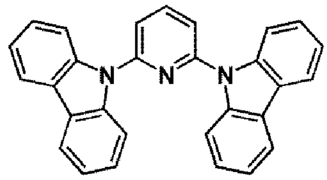

H50

TCP

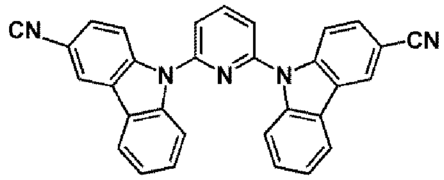

H51

In one or more embodiments, the host may further include a compound represented by Formula 301:

<Formula 301>

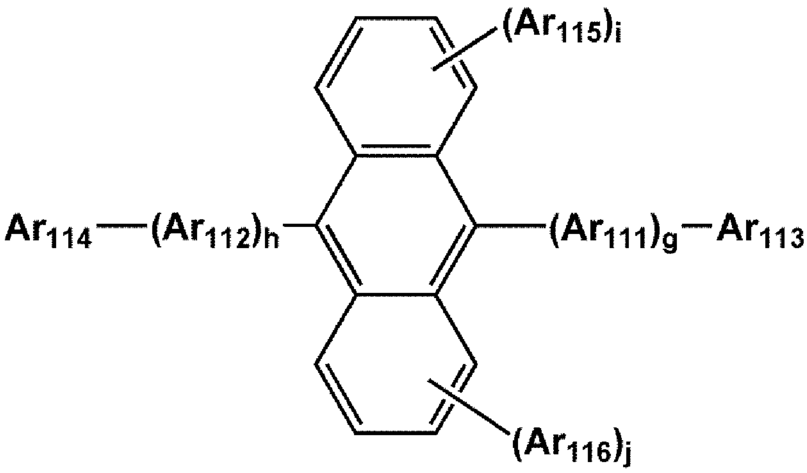

$Ar_{111}$ and $Ar_{112}$ in Formula 301 may each independently be selected from:

a phenylene group, a naphthylene group, a phenanthrenylene group, and a pyrenylene group; and
a phenylene group, a naphthylene group, a phenanthrenylene group, and a pyrenylene group, each substituted with at least one selected from a phenyl group, a naphthyl group, and an anthracenyl group.

$Ar_{113}$ to $Ar_{116}$ in Formula 301 may each independently be selected from:

a $C_1$-$C_{10}$ alkyl group, a phenyl group, a naphthyl group, a phenanthrenyl group, and a pyrenyl group; and
a phenyl group, a naphthyl group, a phenanthrenyl group, and a pyrenyl group, each substituted with at least one selected from a phenyl group, a naphthyl group, and an anthracenyl group.

In Formula 301, g, h, i, and j may each independently be an integer from 0 to 4, and may be, for example, 0, 1, or 2.

$Ar_{113}$ to $Ar_{116}$ in Formula 301 may each independently be selected from:

a $C_1$-$C_{10}$ alkyl group, the substituted with at least one selected from a phenyl group, a naphthyl group, and an anthracenyl group;
a phenyl group, a naphthyl group, an anthracenyl group, a pyrenyl, a phenanthrenyl group, and a fluorenyl group;
a phenyl group, a naphthyl group, an anthracenyl group, a pyrenyl group, a phenanthrenyl group, and a fluorenyl group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a phenyl group, a naphthyl group, an anthracenyl group, a pyrenyl group, a phenanthrenyl group, and a fluorenyl group; and

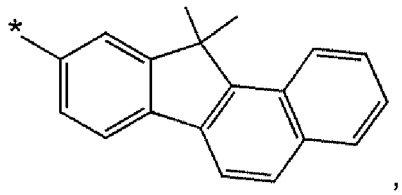

but embodiments of the present disclosure are not limited thereto.

In one or more embodiments, the host may include a compound represented by Formula 302 below:

<Formula 302>

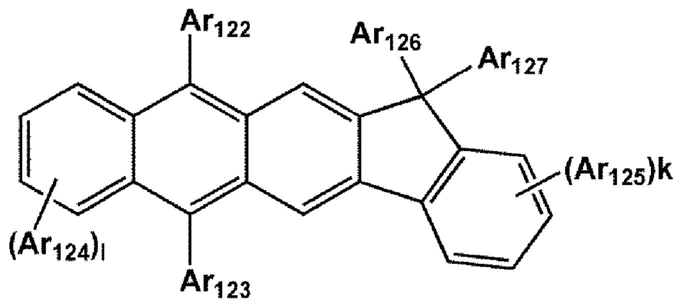

$Ar_{122}$ to $Ar_{125}$ in Formula 302 may be the same as described in connection with $Ar_{113}$ in Formula 301.

$Ar_{126}$ and $Ar_{127}$ in Formula 302 may each independently be a $C_1$-$C_{10}$ alkyl group (for example, a methyl group, an ethyl group, or a propyl group).

in Formula 302, k and l may each independently be an integer from 0 to 4. For example, k and l may be 0, 1, or 2.

When the organic light-emitting device is a full-color organic light-emitting device, the emission layer may be patterned into a red emission layer, a green emission layer, and a blue emission layer. In one or more embodiments, due to a stacked structure including a red emission layer, a green emission layer, and/or a blue emission layer, the emission layer may emit white light.

When the emission layer includes a host and a dopant, an amount of the dopant may be in a range of about 0.01 parts by weight to about 15 parts by weight based on 100 parts by weight of the host, but embodiments of the present disclosure are not limited thereto.

A thickness of the emission layer may be in a range of about 100 Å to about 1,000 Å, for example, about 200 Å to about 600 Å. When the thickness of the emission layer is within this range, excellent light-emission characteristics may be obtained without a substantial increase in driving voltage.

Then, an electron transport region may be disposed on the emission layer.

The electron transport region may include a hole blocking layer, an electron transport layer, an electron injection layer, or any combination thereof.

For example, the electron transport region may have a hole blocking layer/electron transport layer/electron injection layer structure or an electron transport layer/electron injection layer structure, but the structure of the electron transport region is not limited thereto. The electron transport layer may have a single-layered structure or a multi-layered structure including two or more different materials.

Conditions for forming the hole blocking layer, the electron transport layer, and the electron injection layer which constitute the electron transport region may be understood by referring to the conditions for forming the hole injection layer.

When the electron transport region includes a hole blocking layer, the hole blocking layer may include, for example, at least one of BCP, Bphen, and BAlq but embodiments of the present disclosure are not limited thereto:

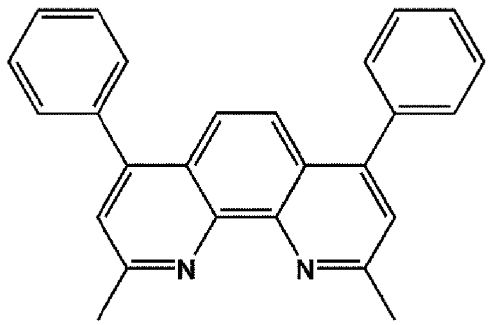

BCP

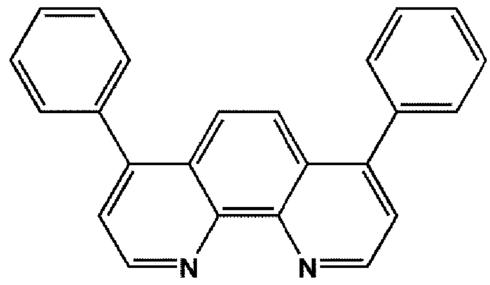

Bphen

A thickness of the hole blocking layer may be in a range of about 20 Å to about 1,000 Å, for example, about 30 Å to about 300 Å. When the thickness of the hole blocking layer is within these ranges, the hole blocking layer may have improved hole blocking ability without a substantial increase in driving voltage.

The electron transport layer may include at least one selected from BCP, Bphen, $Alq_3$, BAlq, TAZ, and NTAZ:

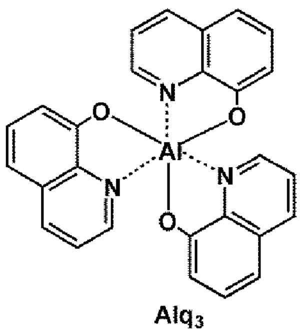

$Alq_3$

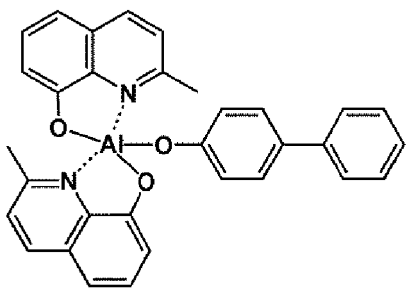

BAlq

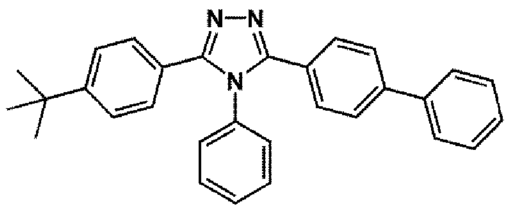

TAZ

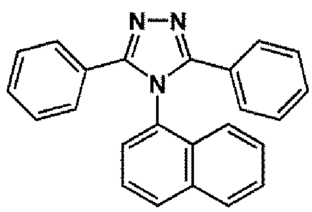

NTAZ

In one or more embodiments, the electron transport layer may include at least one of ET1 to ET25, but are not limited thereto:

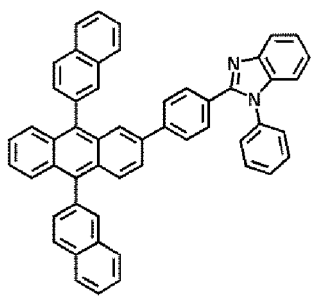

ET1

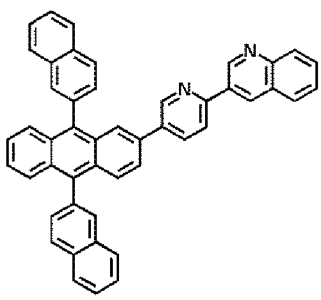

ET2

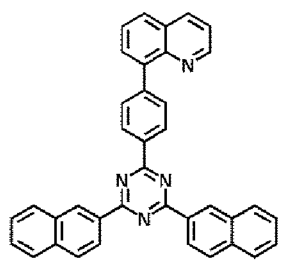

ET3

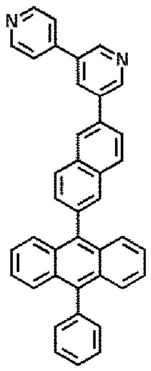

ET4

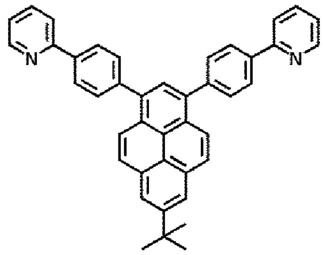

ET5

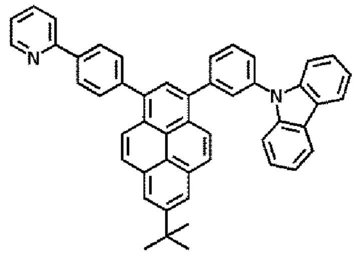

ET6

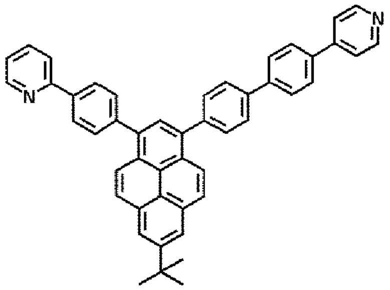

ET7

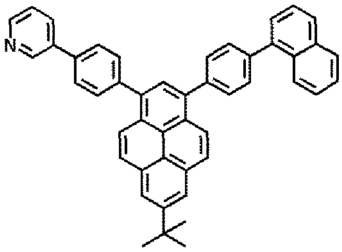

ET8

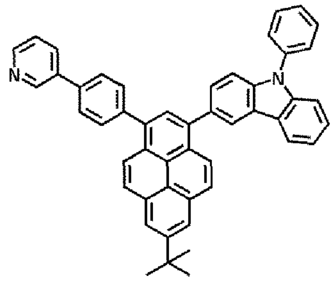

ET9

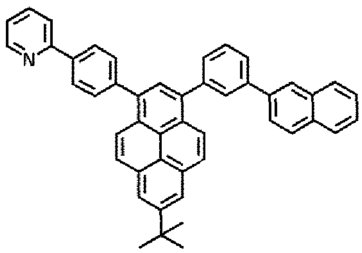

ET10

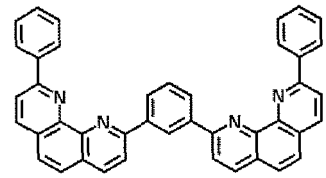

ET11

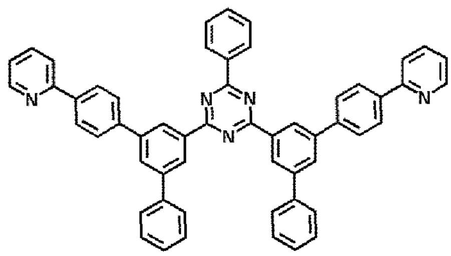

ET12

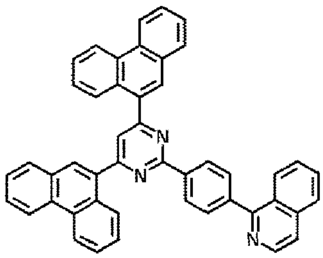

ET13

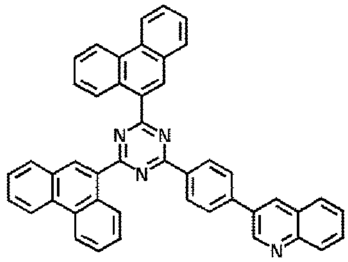

ET14

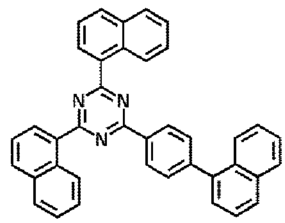

ET15

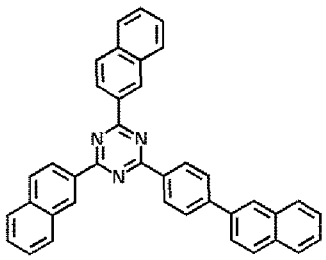

ET16

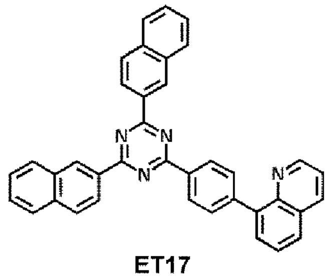

ET17

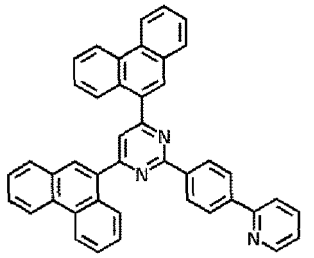

ET18

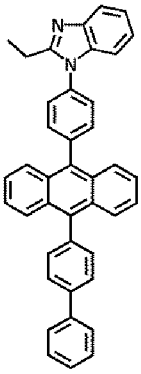

ET19

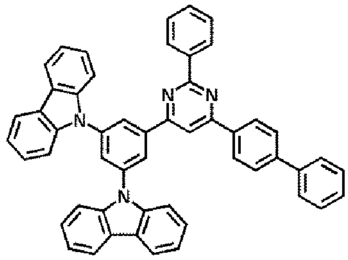

ET20

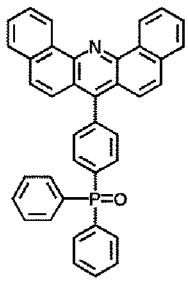

ET21

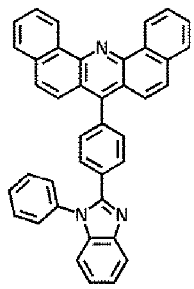

ET22

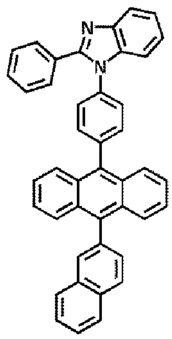

ET23

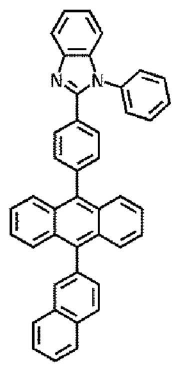

ET24

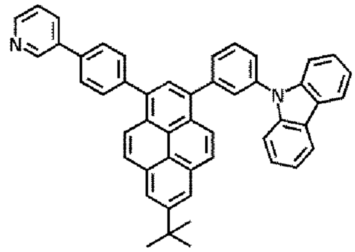

ET25

A thickness of the electron transport layer may be in a range of about 100 Å to about 1,000 Å, for example, about 150 Å to about 500 Å. When the thickness of the electron transport layer is within the range described above, the electron transport layer may have satisfactory electron transport characteristics without a substantial increase in driving voltage.

Also, the electron transport layer may further include, in addition to the materials described above, a metal-containing material.

The metal-containing material may include a Li complex. The Li complex may include, for example, Compound ET-D1 (LiQ) or ET-D2:

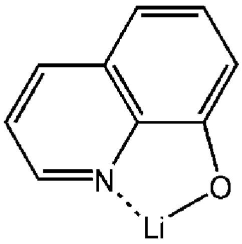

ET-D1

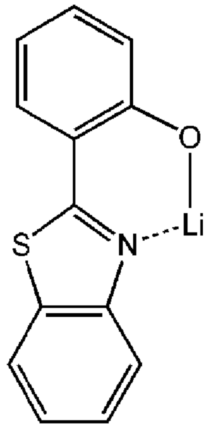

ET-D2.

The electron transport region may include an electron injection layer that promotes flow of electrons from the second electrode 19 thereinto.

The electron injection layer may include at least one selected from LiF, NaCl, CsF, $Li_2O$, and BaO.

A thickness of the electron injection layer may be in a range of about 1 Å to about 100 Å, for example, about 3 Å to about 90 Å. When the thickness of the electron injection layer is within the range described above, the electron injection layer may have satisfactory electron injection characteristics without a substantial increase in driving voltage.

The second electrode 19 is disposed on the organic layer 15. The second electrode 19 may be a cathode. A material for forming the second electrode 19 may be selected from metal, an alloy, an electrically conductive compound, and a combination thereof, which have a relatively low work function. For example, lithium (Li), magnesium (Mg), aluminum (Al), aluminum-lithium (Al-Li), calcium (Ca), magnesium-indium (Mg-In), or magnesium-silver (Mg-Ag) may be used as a material for forming the second electrode 19. In one or more embodiments, to manufacture a top-emission type light-emitting device, a transmissive electrode formed using ITO or IZO may be used as the second electrode 19.

Hereinbefore, the organic light-emitting device has been described with reference to the FIGURE, but embodiments of the present disclosure are not limited thereto.

Another aspect of the present disclosure provides a diagnostic composition including at least one organometallic compound represented by Formula 1.

The organometallic compound represented by Formula 1 provides high luminescent efficiency. Accordingly, a diagnostic composition including the organometallic compound may have high diagnostic efficiency.

The diagnostic composition may be used in various applications including a diagnosis kit, a diagnosis reagent, a biosensor, and a biomarker.

The term "$C_1$-$C_{60}$ alkyl group" as used herein refers to a linear or branched saturated aliphatic hydrocarbon monovalent group having 1 to 60 carbon atoms, and non-limiting examples thereof include a methyl group, an ethyl group, a propyl group, an isobutyl group, a sec-butyl group, a tert-butyl group, a pentyl group, an isoamyl group, and a hexyl group. The term "$C_1$-$C_{60}$ alkylene group" as used herein refers to a divalent group having the same structure as the $C_1$-$C_{60}$ alkyl group.

The term "$C_1$-$C_{60}$ alkoxy group" as used herein refers to a monovalent group represented by $-OA_{101}$ (wherein $A_{101}$ is the $C_1$-$C_{60}$ alkyl group), and non-limiting examples thereof include a methoxy group, an ethoxy group, and an isopropyloxy group.

The term "$C_2$-$C_{60}$ alkenyl group" as used herein refers to a hydrocarbon group formed by substituting at least one carbon-carbon double bond in the middle or at the terminus of the $C_2$-$C_{60}$ alkyl group, and examples thereof include an ethenyl group, a propenyl group, and a butenyl group. The term "$C_2$-$C_{60}$ alkenylene group" as used herein refers to a divalent group having the same structure as the $C_2$-$C_{60}$ alkenyl group.

The term "$C_2$-$C_{60}$ alkynyl group" as used herein refers to a hydrocarbon group formed by substituting at least one carbon-carbon triple bond in the middle or at the terminus of the $C_2$-$C_{60}$ alkyl group, and examples thereof include an ethynyl group, and a propynyl group. The term "$C_2$-$C_{60}$ alkynylene group" as used herein refers to a divalent group having the same structure as the $C_2$-$C_{60}$ alkynyl group.

The term "$C_3$-$C_{10}$ cycloalkyl group" as used herein refers to a monovalent saturated hydrocarbon monocyclic or multi-cyclic group having 3 to 10 carbon atoms, and non-limiting examples thereof include a cyclopropyl group, a cyclobutyl group, a cyclopentyl group, a cyclohexyl group, and a cycloheptyl group. The term "$C_3$-$C_{10}$ cycloalkylene group" as used herein refers to a divalent group having the same structure as the $C_3$-$C_{10}$ cycloalkyl group.

The term "$C_1$-$C_{10}$ heterocycloalkyl group" as used herein refers to a monovalent saturated monocyclic group

having at least one heteroatom selected from N, O, P, Si and S as a ring-forming atom and 1 to 10 carbon atoms, and non-limiting examples thereof include a tetrahydrofuranyl group, and a tetrahydrothiophenyl group. The term "$C_1$-$C_{10}$ heterocycloalkylene group" as used herein refers to a divalent group having the same structure as the $C_1$-$C_{10}$ heterocycloalkyl group.

The term "$C_3$-$C_{10}$ cycloalkenyl group" as used herein refers to a monovalent monocyclic group that has 3 to 10 carbon atoms and at least one carbon-carbon double bond in the ring thereof and no aromaticity, and non-limiting examples thereof include a cyclopentenyl group, a cyclohexenyl group, and a cycloheptenyl group. The term "$C_3$-$C_{10}$ cycloalkenylene group" as used herein refers to a divalent group having the same structure as the $C_3$-$C_{10}$ cycloalkenyl group.

The term "$C_1$-$C_{10}$ heterocycloalkenyl group" as used herein refers to a monovalent monocyclic group that has at least one heteroatom selected from N, O, P, Si, and S as a ring-forming atom, 1 to 10 carbon atoms, and at least one double bond in its ring. Examples of the $C_1$-$C_{10}$ heterocycloalkenyl group are a 2,3-dihydrofuranyl group, and a 2,3-dihydrothiophenyl group. The term "$C_1$-$C_{10}$ heterocycloalkenylene group" as used herein refers to a divalent group having the same structure as the $C_1$-$C_{10}$ heterocycloalkenyl group.

The term "$C_6$-$C_{60}$ aryl group" as used herein refers to a monovalent group having a carbocyclic aromatic system having 6 to 60 carbon atoms, and the term "$C_6$-$C_{60}$ arylene group" as used herein refers to a divalent group having a carbocyclic aromatic system having 6 to 60 carbon atoms. Non-limiting examples of the $C_6$-$C_{60}$ aryl group include a phenyl group, a naphthyl group, an anthracenyl group, a phenanthrenyl group, a pyrenyl group, and a chrysenyl group. When the $C_6$-$C_{60}$ aryl group and the $C_6$-$C_{60}$ arylene group each include two or more rings, the rings may be fused to each other.

The term "$C_1$-$C_{60}$ heteroaryl group" as used herein refers to a monovalent group having a heteroaromatic system that has at least one heteroatom selected from N, O, P, Si, and S as a ring-forming atom, and 1 to 60 carbon atoms. The term "$C_1$-$C_{60}$ heteroarylene group" as used herein refers to a divalent group having a heteroaromatic system that has at least one heteroatom selected from N, O, P, Si, and S as a ring-forming atom, and 1 to 60 carbon atoms. Non-limiting examples of the $C_1$-$C_{60}$ heteroaryl group include a pyridinyl group, a pyrimidinyl group, a pyrazinyl group, a pyridazinyl group, a triazinyl group, a quinolinyl group, and an isoquinolinyl group. When the $C_1$-$C_{60}$ heteroaryl group and the $C_1$-$C_{60}$ heteroarylene group each include two or more rings, the rings may be fused to each other.

The term "$C_6$-$C_{60}$ aryloxy group" as used herein indicates -$OA_{102}$ (wherein $A_{102}$ is the $C_6$-$C_{60}$ aryl group), and a $C_6$-$C_{60}$ arylthio group used herein indicates - $SA_{103}$ (wherein $A_{103}$ is the $C_6$-$C_{60}$ aryl group).

The term "monovalent non-aromatic condensed polycyclic group" as used herein refers to a monovalent group (for example, having 8 to 60 carbon atoms) having two or more rings condensed to each other, only carbon atoms as ring-forming atoms, and no aromaticity in its entire molecular structure. Examples of the monovalent non-aromatic condensed polycyclic group include a fluorenyl group. The term "divalent non-aromatic condensed polycyclic group" as used herein refers to a divalent group having the same structure as the monovalent non-aromatic condensed polycyclic group.

The term "monovalent non-aromatic condensed heteropolycyclic group" as used herein refers to a monovalent group (for example, having 2 to 60 carbon atoms) having two or more rings condensed to each other, a heteroatom selected from N, O, P, Si, and S, other than carbon atoms, as a ring-forming atom, and no aromaticity in its entire molecular structure. Non-limiting examples of the monovalent non-aromatic condensed heteropolycyclic group include a carbazolyl group. The term "divalent non-aromatic condensed heteropolycyclic group" as used herein refers to a divalent group having the same structure as the monovalent non-aromatic condensed heteropolycyclic group.

The term "$C_5$-$C_{30}$ carbocyclic group" as used herein refers to a saturated or unsaturated cyclic group having, as a ring-forming atom, 5 to 30 carbon atoms only. The $C_5$-$C_{30}$ carbocyclic group may be a monocyclic group or a polycyclic group.

The term "$C_2$-$C_{30}$ heterocyclic group" as used herein refers to a saturated or unsaturated cyclic group having, as a ring-forming atom, at least one heteroatom selected from N, O, Si, P, and S other than 2 to 30 carbon atoms. The $C_2$-$C_{30}$ heterocyclic group may be a monocyclic group or a polycyclic group.

At least one substituent of the substituted $C_5$-$C_{30}$ carbocyclic group, the substituted $C_2$-$C_{30}$ heterocyclic group, the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_6$-$C_{60}$ aryloxy group, the substituted $C_6$-$C_{60}$ arylthio group, the substituted $C_1$-$C_{60}$ heteroaryl group, the substituted monovalent non-aromatic condensed polycyclic group, and the substituted monovalent non-aromatic condensed heteropolycyclic group may be selected from:

deuterium, -F, -Cl, -Br, -I, -$CD_3$, -$CD_2H$, -$CDH_2$, -$CF_3$, -$CF_2H$, -$CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-C60 alkyl group, a $C_2$-$C_{60}$

alkenyl group, a $C_2$-$C_{60}$ alkynyl group, and a $C_1$-$C_{60}$ alkoxy group;
a $C_1$-$C_{60}$ alkyl group, a $C_2$-$C_{60}$ alkenyl group, a $C_2$-$C_{60}$ alkynyl group, and a $C_1$-$C_{60}$ alkoxy group, each substituted with at least one selected from deuterium, -F, - Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, a monovalent non-aromatic condensed heteropolycyclic group, - $N(Q_{11})(Q_{12})$, $-Si(Q_{13})(Q_{14})(Q_{15})$, $-Ge(Q_{13})(Q_{14})(Q_{15})$, $-B(Q_{16})(Q_{17})$, $-P(=O)(Q_{18})(Q_{19})$, and $-P(Q_{18})(Q_{19})$;
a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, and a monovalent non-aromatic condensed heteropolycyclic group;
a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, and a monovalent non-aromatic condensed heteropolycyclic group, each substituted with at least one selected from deuterium, - F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, a monovalent non-aromatic condensed heteropolycyclic group, - N(Q21)(Q22), $-Si(Q_{23})(Q_{24})(Q_{25})$, -Ge(Q23)(Q24)(Q25), $-B(Q_{26})(Q_{27})$, $-P(=O)(Q_{28})(Q_{29})$, and $-P(Q_{28})(Q_{29})$; and
-N(Q31)(Q32), $-Si(Q_{33})(Q_{34})(Q_{35})$, -Ge(Q33)(Q34)(Q35), $-B(Q_{36})(Q_{37})$, - $P(=O)(Q_{38})(Q_{39})$, and $-P(Q_{38})(Q_{39})$.

The $Q_1$ to $Q_9$, $Q_{11}$ to $Q_{19}$, $Q_{21}$ to $Q_{29}$, and $Q_{31}$ to $Q_{39}$ may each independently be selected from hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryl group substituted with at least one selected from a $C_1$-$C_{60}$ alkyl group, and a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, and a monovalent non-aromatic condensed heteropolycyclic group.

Hereinafter, a compound and an organic light-emitting device according to embodiments are described in detail with reference to Synthesis Example and Examples. However, the organic light-emitting device is not limited thereto. The wording "B was used instead of A" as used in describing Synthesis Examples means that an amount of A used was identical to an amount of B used, in terms of a molar equivalent.

**[Examples]**

**Synthesis Example 1 (Compound 2)**

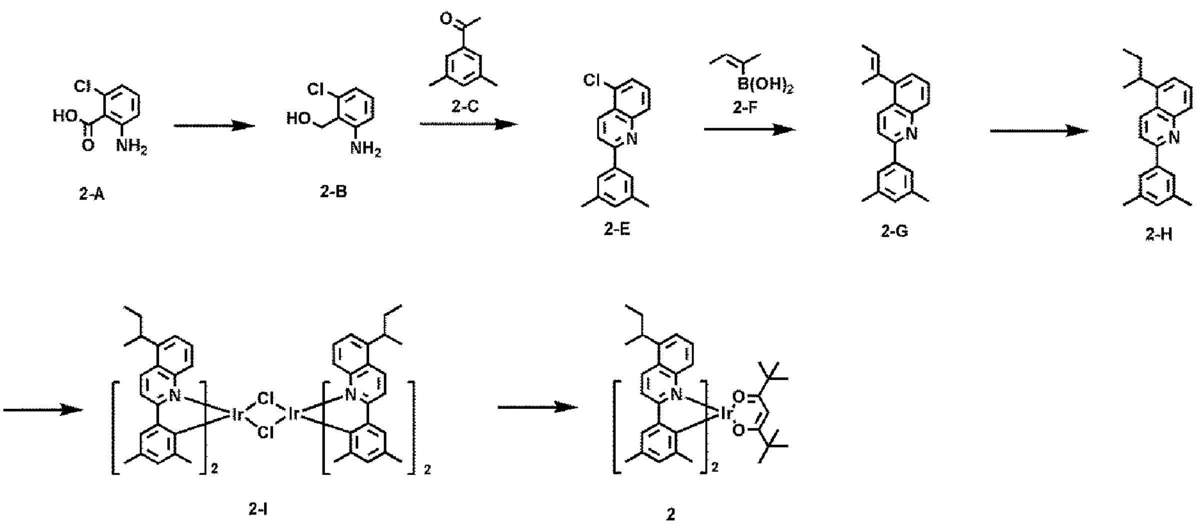

2-A 2-B 2-C 2-E 2-F 2-G 2-H 2-I 2

Synthesis of Intermediate 2-B

4 g (17.48 mmol) of a starting material 2-A was mixed with 72 mL of tetrahydrofuran (THF), and the mixture was cooled to a temperature of 0 °C. 29 mL of 1M $LiAlH_4$ in THF solution was added dropwise thereto. Then, the mixture was heated to room temperature and refluxed overnight. 1 mL of water was added to a reactant obtained therefrom, 2 mL of 50 % NaOH (aq) was added thereto, and ethyl acetate (EA) was added thereto to extract an organic layer therefrom. The extracted organic layer was dried, and column chromatography was performed thereon to obtain 3.0 g (yield of 82 %) of Intermediate 2-B.

Synthesis of Intermediate 2-E

3 g (19.04 mmol) of Intermediate 2-B, 4.23 g (28.55 mmol) of starting material 2-C, 0.18 g (0.190 mmol) of $RuCl_2(PPh_3)_3$, and 1.92 g (34.26 mmol) of KOH were mixed with 53 mL of toluene and refluxed overnight at a temperature of 120 °C. The result obtained therefrom was cooled to room temperature and washed with water. Then, column chromatography was performed thereon to obtain 4.4 g (yield of 48 %) of Intermediate 2-E. The obtained compound was identified by LC-MS analysis.

LC-MS m/z = 268.14 (M+H)+.

Synthesis of Intermediate 2-G

4.4 g (16.43 mmol) of Intermediate 2-E, 1.81 g (18.08 mmol) of starting material 2-F, 0.37 g (1.64 mmol) of $Pd(OAc)_2$, 6.81 g (49.30 mmol) of $K_2CO_3$, and 2.70 g (3.29 mmol) of Sphos were mixed with 154 mL of dioxane and 38 mL of $H_2O$ and refluxed overnight at a temperature of 90 °C. The result obtained therefrom was cooled to room temperature and washed with water and methylene chloride. Then, column chromatography was performed thereon to obtain 3.8 g (yield of 80 %) of Intermediate 2-G. The obtained compound was identified by LC-MS analysis.

LC-MS m/z = 288.28 (M+H)+.

Synthesis of Intermediate 2-H

1.8 g (6.26 mmol) of Intermediate 2-G was mixed with methanol, and 0.36 g of Pd on carbon was added thereto. A hydrogen gas was bubbled into a reactant obtained therefrom for 6 hours or more. After the reaction was completed, MeOH was removed therefrom, and the reaction product was washed with $H_2O$ and methylene chloride. Then, column chromatography was performed thereon to obtain 0.8 g (yield of 44 %) of Intermediate 2-H. The obtained compound was identified by LC-MS analysis.

LC-MS m/z = 290.20 (M+H)+.

Synthesis of Intermediate 2-I

0.40 g (1.13 mmol) of $IrCl_3 \cdot 4H_2O$, 14 mL of 2-ethoxyethanol, and 4.5 mL of $H_2O$ were added to 0.74 g (2.55 mmol) of Intermediate 2-H and refluxed overnight at a temperature of 120 °C. A result obtained therefrom was cooled

to room temperature, filtered, washed with methanol, and then dried to obtain 0.65 g of Intermediate 2-I.

Synthesis of Compound 2

0.65 g (0.40 mmol) of Intermediate 2-I, 0.74 g (4.04 mmol) of 2,2,6,6-tetramethylheptane-3,5-dione, and 0.56 g (4.04 mmol) of $K_2CO_3$ were mixed with 22 mL of 2-ethoxyethanol and stirred overnight at room temperature. A result obtained therefrom was washed with ethyl acetate and $H_2O$. Then, column chromatography was performed thereon to obtain 0.43 g (yield of 57 %) of Compound 2. The obtained compound was identified by LC-MS analysis.

m/z = 953.27 (M+H)+.

**Synthesis Example 2 (Compound 1)**

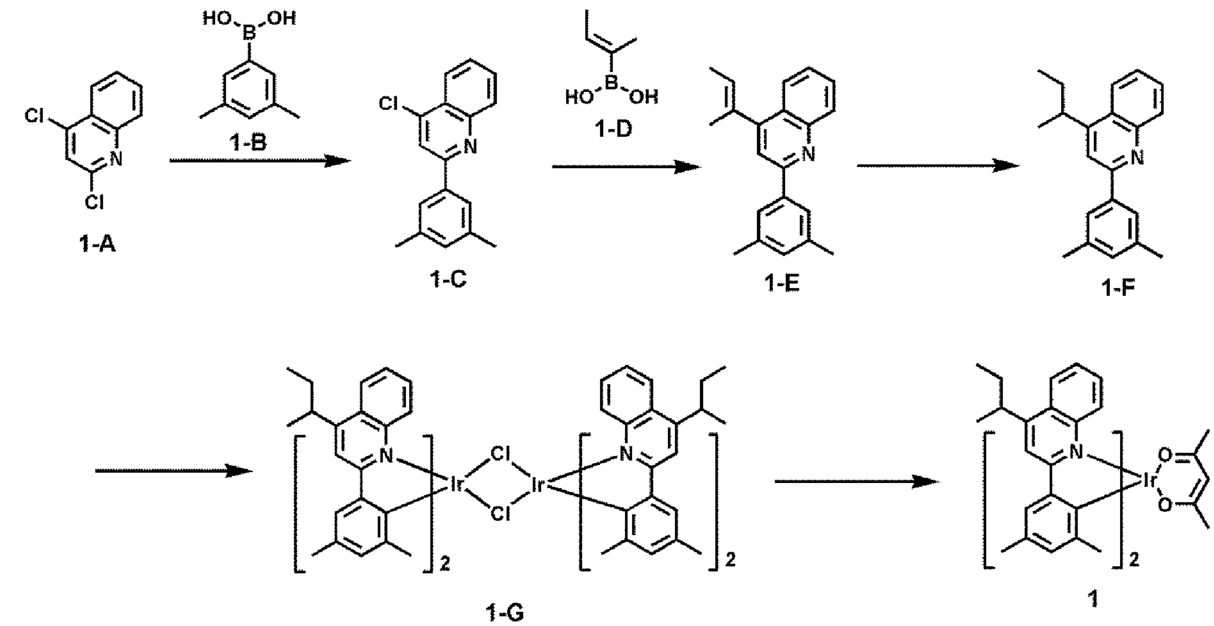

1-A 1-B 1-C 1-D 1-E 1-F 1-G 1

Synthesis of Intermediate 1-C

3.70 g (18.67 mmol) of a starting material 1-A, 2.94 g (19.61 mmol) of a starting material 1-B, 1.08 g (0.93 mmol) of $Pd(PPh_3)_4$, and 6.45 g (46.68 mmol) of $K_2CO_3$ were mixed with 60 mL of THF and 30 mL of $H_2O$ and refluxed overnight at a temperature of 90 °C. A result obtained therefrom was cooled to room temperature and washed with water and methylene chloride. Then, column chromatography was performed thereon to obtain 4.00 g (yield of 80 %) of Intermediate 1-C. The obtained compound was identified by LC-MS analysis.

LC-MS m/z = 268.12 (M+H)+.

Synthesis of Intermediate 1-E

4.00 g (14.96 mmol) of Intermediate 1-C, 1.79 g (18.95 mmol) of I starting material 1-D, 0.17 g (0.75 mmol) of $Pd(OAc)_2$, 5.17 g (37.40 mmol) of $K_2CO_3$, and 0.61 g (1.50 mmol) of Sphos were mixed with 50 mL of THF and 25 mL of $H_2O$ and refluxed overnight at a temperature of 90 °C. A result obtained therefrom was cooled to room temperature and washed with water and methylene chloride. Then, column chromatography was performed thereon to obtain 2.20 g (yield of 51 %) of Intermediate 1-E. The obtained compound was identified by LC-MS analysis.

LC-MS m/z = 288.22 (M+H)+

Synthesis of Intermediate 1-F

2.20 g (7.60 mmol) of Intermediate 1-E was mixed with methanol, and 0.24 g of Pd on carbon was added thereto. A hydrogen gas was bubbled into a reactant obtained therefrom for 6 hours or more. After the reaction was completed, MeOH was removed therefrom, and the reaction product was washed with $H_2O$ and methylene chloride.

Then, column chromatography was performed thereon to obtain 1.55 g (yield of 70 %) of Intermediate 1-F. The obtained compound was identified by LC-MS analysis.

LC-MS m/z = 290.22 (M+H)+.

Synthesis of Intermediate 1-G

0.96 g (2.73 mmol) of $IrCl_3 \cdot 4H_2O$, 10 mL of 2-ethoxyethanol, and 3.5 mL of $H_2O$ were added to 1.58 g (5.47 mmol) of Intermediate 1-F and refluxed overnight at a temperature of 120 °C. A result obtained therefrom was cooled to room temperature, filtered, washed with methanol, and then dried to obtain 1.35 g of Intermediate 1-G.

Synthesis of Compound 1

1.35 g (0.86 mmol) of Intermediate 1-G, 0.89 g (8.64 mmol) of pentane-2,4-dione, and 0.91 g (8.64 mmol) of $Na_2CO_3$ were mixed with 17 mL of 2-ethoxyethanol and refluxed overnight. A result obtained therefrom was washed with ethyl acetate and $H_2O$. Then, column chromatography was performed thereon to obtain 0.50 g (yield of 33 %) of Compound 1. The obtained compound was identified by LC-MS analysis.

m/z = 869.36 (M+H)+.

**Synthesis Example 3 (Compound 5)**

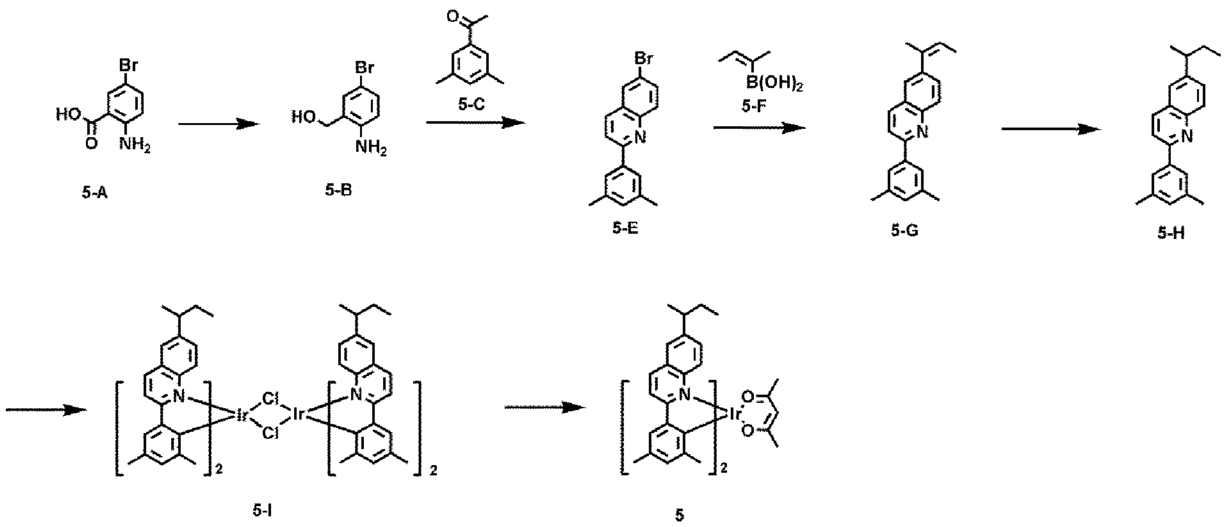
5-A
5-B
5-C
5-E
5-F
5-G
5-H
5-I
5

Synthesis of Intermediate 5-B

3.33 g (yield of 89 %) of Intermediate 5-B was obtained in the same manner as in Synthesis of Intermediate 2-B in Synthesis Example 1, except that 4.00 g (18.52 mmol) of a starting material 5-A was used instead of the starting material 2-A.

Synthesis of Intermediate 5-E

3.09 g (yield of 60 %) of Intermediate 5-E was obtained in the same manner as in Synthesis of Intermediate 2-E in Synthesis Example 1, except that 3.33 g (16.48 mmol) of Intermediate 5-B was used instead of Intermediate 2-B, and 3.66 g (24.72 mmol) of starting material 5-C was used instead of starting material 2-C.

Synthesis of Intermediate 5-G

2.26 g (yield of 82 %) of Intermediate 5-G was obtained in the same manner as in Synthesis of Intermediate 2-G in Synthesis Example 1, except that 3.00 g (9.61 mmol) of Intermediate 5-E was used instead of Intermediate 2-E, and 1.06 g (10.57 mmol) of starting material 5-F was used instead of starting material 2-F. The obtained compound was identified by LC-MS analysis.

LC-MS m/z = 288.28 (M+H)+.

Synthesis of Intermediate 5-H

1.22 g (yield of 55 %) of Intermediate 5-H was obtained in the same manner as in Synthesis of Intermediate 2-H in Synthesis Example 1, except that 2.2 g (7.65 mmol) of Intermediate 5-G was used instead of Intermediate 2-G. The obtained compound was identified by LC-MS analysis.

LC-MS m/z = 290.20 (M+H)+.

Synthesis of Intermediate 5-I

1.00 g of Intermediate 5-I was obtained in the same manner as in Synthesis of Intermediate 2-I, except that 1.22 g (4.22 mmol) of Intermediate 5-H was used instead of Intermediate 2-H.

Synthesis of Compound 5

0.72 g (yield of 55 %) of Compound 5 was obtained in the same manner as in Synthesis of Compound 2 of Synthesis Example 1, except that 1.00 g (0.97 mmol) of Intermediate 5-I was used instead of Intermediate 2-I, and pentane-2,4-dione was used instead of 2,2,6,6-tetramethylheptane-3,5-dione. The obtained compound was identified by LC-MS analysis.

m/z = 869.40 (M+H)+.

**Synthesis Example 4 (Compound 12)**

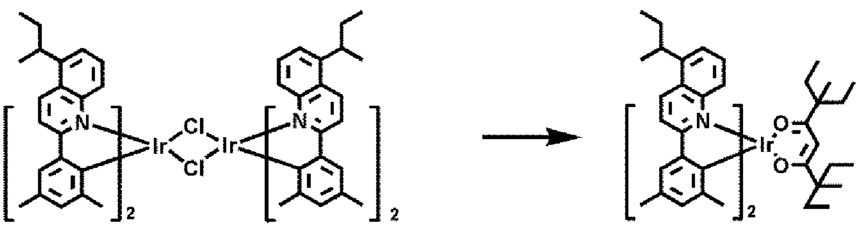

2-I 12

1.10 g (yield of 65 %) of Compound 12 was obtained in the same manner as in Synthesis of Compound 2 of Synthesis Example 1, except that 3,7-diethyl-3,7-dimethylnonane-4,6-dione was used instead of 2,2,6,6-tetramethylheptane-3,5-dione.

LC-MS: m/z = 1008.61 (M+H)+.

**Example 1**

As an anode, a glass substrate, on which ITO/Ag/ITO were deposited to thicknesses of 70 Å/1,000 Å/70 Å, was cut to a size of 50 mm x 50 mm x 0.5 mm, sonicated with isopropyl alcohol and pure water each for 5 minutes, and then cleansed by exposure to ultraviolet rays and ozone for 30 minutes. Then, the glass substrate was provided to a vacuum deposition apparatus.

2-TNATA was vacuum-deposited on the anode to form a hole injection layer having a thickness of 600 Å, and 4,4'-bis[N-(1-naphthyl)-N-phenylamino]biphenyl (NPB) was vacuum-deposited on the hole injection layer to form a hole transport layer having a thickness of 1,350 Å.

Then, CBP (host) and Compound 2 (dopant) were co-deposited on the hole transport layer at a weight ratio of 98:2 to form an emission layer having a thickness of 400 Å.

Then, BCP was vacuum-deposited on the emission layer to form a hole blocking layer having a thickness of 50 Å, $Alq_3$ was vacuum-deposited on the hole blocking layer to form an electron transport layer having a thickness of 350 Å, LiF was vacuum-deposited on the electron transport layer to form an electron injection layer having a thickness of 10 Å, and Mg and Ag were co-deposited on the electron injection layer at a weight ratio of 90:10 to form a cathode having a thickness of 120 Å, thereby completing the manufacture of an organic light-emitting device (which emits red light).

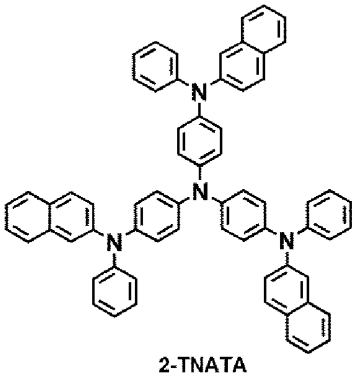

2-TNATA

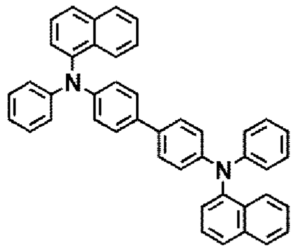

NPB

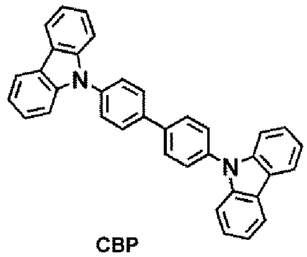

CBP

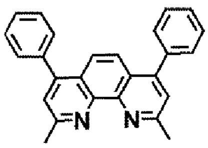

BCP

**Examples 2 to 4 and Comparative Examples A to F**

Organic light-emitting devices were manufactured in the same manner as in Example 1, except that Compounds shown in Table 1 were each used instead of Compound 2 as a dopant in forming an emission layer.

**Evaluation Example** 1: **Evaluation of characteristics of organic light-emitting devices**

The driving voltage, current density, external quantum luminescent efficiency (EQE), roll-off ratio, full width at half maximum (FWHM) and peak wavelength of emission peaks in EL spectra, and lifespan ($LT_{97}$) of the organic light-emitting devices manufactured according to Examples 1 to 4 and Comparative Examples A to F are evaluated, and results thereof are shown in Table 1. A current-voltage meter (Keithley 2400) and a luminance meter (Minolta Cs-1000A) were used as the evaluation apparatuses, and the lifespan ($LT_{97}$) (at 3,500 nit) indicates the time that lapsed when luminance was 97 % of initial luminance (100 %). The roll-off ratio was calculated by Equation 20 below.

<Equation 20>

Roll off ratio = {1- (Efficiency (at 3,500 nit) / Maximum luminescent efficiency)} X 100%

[Table 1]

| | Dopant in emission layer | Driving voltage (V) | Current density (mA/cm$^2$) | Max EQE (%) | Roll-Off ratio (%) | FWHM (nm) | peak wavelength (nm) | LT97 (hr) |
|---|---|---|---|---|---|---|---|---|
| Example 1 | Compound 2 | 5.35 | 17.4 | 25.8 | 10 | 62.47 | 617 | 250 |
| Example 2 | Compound 1 | 5.02 | 17.3 | 26.8 | 11 | 58.64 | 608 | 226 |
| Example 3 | Compound 5 | 5.06 | 17.3 | 26.0 | 13 | 61.98 | 614 | 207 |
| Example 4 | Compound 12 | 5.10 | 16.7 | 27.8 | 10 | 62.75 | 619 | 280 |
| Comparative Example A | Compound A | 5.49 | 12.2 | 20.4 | 28 | 82.39 | 623 | 50 |

(continued)

| | Dopant in emission layer | Driving voltage (V) | Current density (mA/cm2) | Max EQE (%) | Roll-Off ratio (%) | FWHM (nm) | peak wavelength (nm) | LT97 (hr) |
|---|---|---|---|---|---|---|---|---|
| Comparative Example B | Compound B | 9.82 | 670.2 | 13.7 | 89 | 23.6 | 652 | 1 |
| Comparative Example C | Compound C | 5.81 | 20.1 | 21.2 | 25 | 78.21 | 602 | 22 |
| Comparative Example D | Compound D | 5.65 | 19.4 | 21.8 | 17 | 68.17 | 615 | 80 |
| Comparative Example E | Compound E | 5.65 | 19.4 | 22.8 | 16 | 63.57 | 614 | 23 |
| Comparative Example F | Compound F | 5.80 | 20.0 | 25.9 | 13 | 59.41 | 616 | 150 |

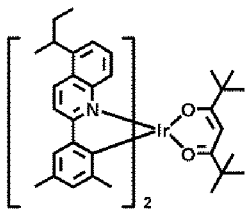

2

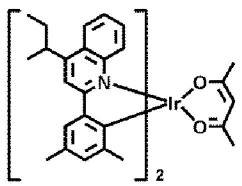

1

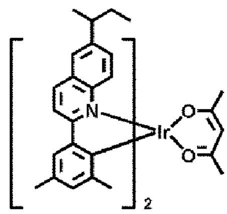

5

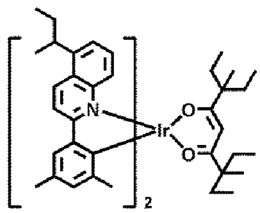

12

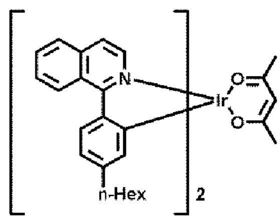

A

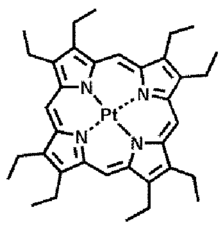

B

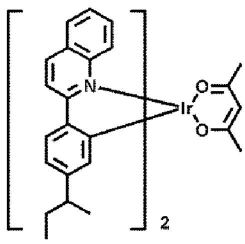

C

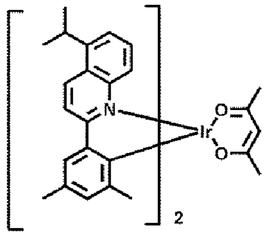

D

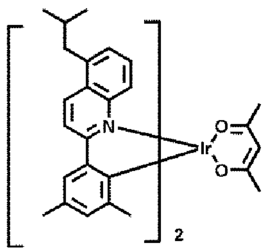

E

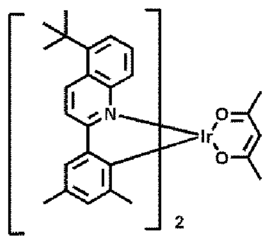

F

n-Hex in Compound A indicates an n-hexyl group.

Referring to Table 1, it was confirmed that the organic light-emitting devices of Examples 1 to 4 showed improved driving voltage, improved current density, improved external quantum luminescent efficiency, improved roll-off ratio, and improved lifespan characteristics compared to those of the organic light-emitting device of Comparative Examples A to F.

Since the organometallic compound has excellent electric characteristics and thermal stability, an organic light-emitting device including the organometallic compound may have excellent driving voltage, luminescent efficiency, quantum efficiency, roll-off ratio, and lifespan characteristics.

It should be understood that embodiments described herein should be considered in a descriptive sense only and not for purposes of limitation. Descriptions of features or aspects within each embodiment should typically be

considered as available for other similar features or aspects in other embodiments.

## Claims

**1.** An organometallic compound represented by Formula 1:

<Formula 1>

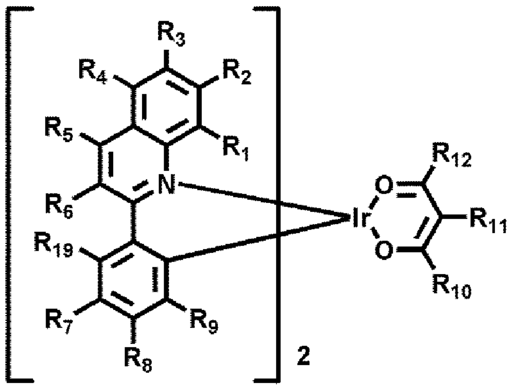

wherein, in Formula 1, $R_1$ to $R_{12}$ and $R_{19}$ are each independently selected from hydrogen, deuterium, -F, -Cl, -Br, -I, $-SF_5$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent non-aromatic condensed polycyclic group, a substituted or unsubstituted monovalent non-aromatic condensed heteropolycyclic group, $-N(Q_1)(Q_2)$, $-Si(Q_3)(Q_4)(Q_5)$, $-Ge(Q_3)(Q_4)(Q_5)$, $-B(Q_6)(Q_7)$, $-P(=O)(Q_8)(Q_9)$, and $-P(Q_8)(Q_9)$, and
at least one selected from $R_1$ to $R_6$ is each independently selected from groups represented by Formula 2:

<Formula 2>

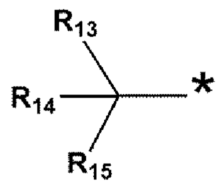

wherein the number of carbon atoms included in Formula 2 is 4 or more,
$R_{13}$ in Formula 2 is hydrogen, deuterium, a $C_1$-$C_{20}$ alkyl group, a deuterium-containing $C_1$-$C_{20}$ alkyl group, a $C_3$-$C_{10}$ cycloalkyl group, or a deuterium-containing $C_3$-$C_{10}$ cycloalkyl group,
$R_{14}$ and $R_{15}$ in Formula 2 are each independently a $C_1$-$C_{20}$ alkyl group, a deuterium-containing $C_1$-$C_{20}$ alkyl group, a $C_3$-$C_{10}$ cycloalkyl group, or a deuterium-containing $C_3$-$C_{10}$ cycloalkyl group,
provided that, $R_{13}$, $R_{14}$ and $R_{15}$ are not a methyl group, simultaneously,
* indicates a binding site to a neighboring atom,
wherein 1) at least one selected from $R_{10}$ and $R_{12}$ in Formula 1 are each independently a group represented by Formula 3, or 2) at least one of $R_{10}$, $R_{12}$ and $R_{14}$ in Formulae 1 and 2 are each independently a $C_3$-$C_{10}$ cycloalkyl, or a deuterium-containing $C_3$-$C_{10}$ cycloalkyl group:

<Formula 3>

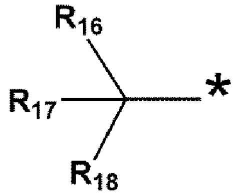

wherein, in Formula 3,
$R_{16}$ to $R_{18}$ are each independently selected from:

hydrogen, deuterium, a $C_1$-$C_{20}$ alkyl group, a $C_3$-$C_{10}$ cycloalkyl group, a $C_6$-$C_{60}$ aryl group, and a $C_1$-$C_{60}$ heteroaryl group; and
a $C_1$-$C_{20}$ alkyl group, a $C_3$-$C_{10}$ cycloalkyl group, a $C_6$-$C_{60}$ aryl group, and a $C_1$-$C_{60}$ heteroaryl group, each substituted with at least one selected from deuterium and a $C_1$-$C_{20}$ alkyl group,
one or more selected from $R_{16}$ to $R_{18}$ is not hydrogen and deuterium, and
* indicates a binding site to a neighboring atom,
at least one substituent of the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_6$-$C_{60}$ aryloxy group, the substituted $C_6$-$C_{60}$ arylthio group, the substituted $C_1$-$C_{60}$ heteroaryl group, the substituted monovalent non-aromatic condensed polycyclic group, and the substituted monovalent non-aromatic condensed heteropolycyclic group is selected from:
deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, and a $C_1$-$C_{60}$ alkoxy group;
a $C_1$-$C_{60}$ alkyl group, a $C_2$-$C_{60}$ alkenyl group, a $C_2$-$C_{60}$ alkynyl group, and a $C_1$-$C_{60}$ alkoxy group, each substituted with at least one selected from deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, a monovalent non-aromatic condensed heteropolycyclic group, $-N(Q_{11})(Q_{12})$, $-Si(Q_{13})(Q_{14})(Q_{15})$, $-Ge(Q_{13})(Q_{14})(Q_{15})$, $-B(Q_{16})(Q_{17})$, $-P(=O)(Q_{18})(Q_{19})$, and $-P(Q_{18})(Q_{19})$;
a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, and a monovalent non-aromatic condensed heteropolycyclic group;
a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, and a monovalent non-aromatic condensed heteropolycyclic group, each substituted with at least one selected from deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, a monovalent non-aromatic condensed heteropolycyclic group, $-N(Q_{21})(Q_{22})$, $-Si(Q_{23})(Q_{24})(Q_{25})$, $-Ge(Q_{23})(Q_{24})(Q_{25})$, $-B(Q_{26})(Q_{27})$, $-P(=O)(Q_{28})(Q_{29})$, and $-P(Q_{28})(Q_{29})$; and
$-N(Q_{31})(Q_{32})$, $-Si(Q_{33})(Q_{34})(Q_{35})$, $-Ge(Q_{33})(Q_{34})(Q_{35})$, $-B(Q_{36})(Q_{37})$, $-P(=O)(Q_{38})(Q_{39})$, and $-P(Q_{38})(Q_{39})$, and

$Q_1$ to $Q_9$, $Q_{11}$ to $Q_{19}$, $Q_{21}$ to $Q_{29}$, and $Q_{31}$ to $Q_{39}$ are each independently selected from hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryl group substituted with at least one selected from a $C_1$-$C_{60}$ alkyl group, and a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, and a monovalent non-aromatic condensed heteropolycyclic group.

**2.** The organometallic compound of claim 1, wherein
$R_1$ to $R_{12}$ and $R_{19}$ are each independently selected from:

hydrogen, deuterium, a methyl group, an ethyl group, an n-propyl group, an iso-propyl group, an n-butyl group, a sec-butyl group, an iso-butyl group, a tert-butyl group, an n-pentyl group, a tert-pentyl group, a neopentyl group, an iso-pentyl group, a sec-pentyl group, a 3-pentyl group, a sec-isopentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group, a tert-decyl group, a methoxy group, an ethoxy group, a propoxy group, a butoxy group, a pentoxy group, a cyclopentyl group, a cyclohexyl group, a cycloheptyl group, a cycloctyl group, an adamantanyl group, a norbornanyl group, a norbornenyl group, a cyclopentenyl group, a cyclohexenyl group, a cycloheptenyl group, bicyclo[1.1.1]pentyl, bicyclo[2.1.1]hexyl, bicyclo[2.2.1]heptyl, a bicyclo[2.2.2]octyl group, a phenyl group, a biphenyl group, a terphenyl group, a naphthyl group, a pyridinyl group, a pyrimidinyl group, a carbazolyl group, a fluorenyl group, a dibenzosilolyl group, a dibenzofuranyl group, a dibenzothiophenyl group, or -Si($Q_3$)($Q_4$)($Q_5$);
a methyl group, an ethyl group, an n-propyl group, an iso-propyl group, an n-butyl group, a sec-butyl group, an iso-butyl group, a tert-butyl group, an n-pentyl group, a tert-pentyl group, a neopentyl group, an iso-pentyl group, a sec-pentyl group, a 3-pentyl group, a sec-isopentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group, and a tert-decyl group, each substituted with at least one deuterium; and
a methoxy group, an ethoxy group, a propoxy group, a butoxy group, a pentoxy group, a cyclopentyl group, a cyclohexyl group, a cycloheptyl group, a cycloctyl group, an adamantanyl group, a norbornanyl group, a norbornenyl group, a cyclopentenyl group, a cyclohexenyl group, a cycloheptenyl group, bicyclo[1.1.1]pentyl, bicyclo[2.1.1]hexyl, bicyclo[2.2.1]heptyl, a bicyclo[2.2.2]octyl group, a phenyl group, a biphenyl group, a terphenyl group, a naphthyl group, a pyridinyl group, a pyrimidinyl group, a carbazolyl group, a fluorenyl group, a dibenzosilolyl group, a dibenzofuranyl group, and a dibenzothiophenyl group, each substituted with at least one selected from deuterium and a $C_1$-$C_{10}$ alkyl group, and
$Q_3$ to $Q_5$ are each independently selected from:

$-CH_3$, $-CD_3$, $-CD_2H$, $-CDH_2$, $-CH_2CH_3$, $-CH_2CD_3$, $-CH_2CD_2H$, $-CH_2CDH_2$, - $CHDCH_3$, $-CHDCD_2H$, $-CHDCDH_2$, $-CHDCD_3$, $-CD_2CD_3$, $-CD_2CD_2H$, and $-CD_2CDH_2$;
an n-propyl group, an iso-propyl group, an n-butyl group, an iso-butyl group, a sec-butyl group, a tert-butyl group, an n-pentyl group, an iso-pentyl group, a sec-pentyl group, a tert-pentyl group, a phenyl group, and a naphthyl group; and
an n-propyl group, an iso-propyl group, an n-butyl group, an iso-butyl group, a sec-butyl group, a tert-butyl group, an n-pentyl group, an iso-pentyl group, a sec-pentyl group, a tert-pentyl group, a phenyl group, and a naphthyl group, each substituted with at least one selected from deuterium, a $C_1$-$C_{10}$ alkyl group, and a phenyl group.

**3.** The organometallic compound of claims 1 or 2, wherein
one selected from $R_2$ to $R_5$ in Formula 1 is a group represented by Formula 2.

**4.** The organometallic compound of any of claims 1-3, wherein

1) $R_2$ is a group represented by Formula 2 and $R_1$ and $R_3$ to $R_6$ are hydrogen,
2) $R_3$ is a group represented by Formula 2 and $R_1$, $R_2$ and $R_4$ to $R_6$ are hydrogen,

3) $R_4$ is a group represented by Formula 2 and $R_1$ to $R_3$, $R_5$ and $R_6$ are hydrogen,
4) $R_5$ is a group represented by Formula 2 and $R_1$ to $R_4$ and $R_6$ are hydrogen,
5) $R_4$ is a group represented by Formula 2, $R_5$ is a substituted or unsubstituted $C_1$-$C_{60}$ alkyl group, a substituted or unsubstituted $C_3$-$C_{10}$ cycloalkyl group, a phenyl group, a biphenyl group, or -Si($Q_3$)($Q_4$)($Q_5$) and $R_1$, $R_2$, $R_3$ and $R_6$ are hydrogen,
6) $R_5$ is a group represented by Formula 2, $R_3$ is a substituted or unsubstituted $C_1$-$C_{60}$ alkyl group, a substituted or unsubstituted $C_3$-$C_{10}$ cycloalkyl group, a phenyl group, a biphenyl group, or -Si($Q_3$)($Q_4$)($Q_5$) and $R_1$, $R_2$, $R_4$ and $R_6$ are hydrogen,
7) $R_2$ is a group represented by Formula 2, $R_5$ is a substituted or unsubstituted $C_1$-$C_{60}$ alkyl group, a substituted or unsubstituted $C_3$-$C_{10}$ cycloalkyl group, a phenyl group, a biphenyl group, or -Si($Q_3$)($Q_4$)($Q_5$) and $R_1$, $R_3$, $R_4$ and $R_6$ are hydrogen,
8) $R_4$ is a group represented by Formula 2, $R_6$ is a substituted or unsubstituted $C_1$-$C_{60}$ alkyl group, a substituted or unsubstituted $C_3$-$C_{10}$ cycloalkyl group, a phenyl group, a biphenyl group, or -Si($Q_3$)($Q_4$)($Q_5$) and $R_1$, $R_2$, $R_3$ and $R_5$ are hydrogen,
9) $R_3$ is a group represented by Formula 2, $R_5$ is a substituted or unsubstituted $C_1$-$C_{60}$ alkyl group, a substituted or unsubstituted $C_3$-$C_{10}$ cycloalkyl group, a phenyl group, a biphenyl group, or -Si($Q_3$)($Q_4$)($Q_5$) and $R_1$, $R_2$, $R_4$ and $R_6$ are hydrogen, or
10) $R_2$ is a group represented by Formula 2, $R_4$ and $R_5$ are each independently a substituted or unsubstituted $C_1$-$C_{60}$ alkyl group, a substituted or unsubstituted $C_3$-$C_{10}$ cycloalkyl group, a phenyl group, a biphenyl group, or - Si($Q_3$)($Q_4$)($Q_5$) and $R_1$, $R_3$ and $R_6$ are hydrogen.

**5.** The organometallic compound of any of claims 1-4, wherein
at least one of $R_7$ to $R_9$ is each independently a substituted or unsubstituted $C_1$-$C_{60}$ alkyl group, a substituted or unsubstituted $C_3$-$C_{10}$ cycloalkyl group, or a substituted or unsubstituted $C_6$-$C_{60}$ aryl group.

**6.** The organometallic compound of any of claims 1-5, wherein

$R_{13}$ in Formula 2 is hydrogen or deuterium; or
wherein
$R_{13}$ in Formula 2 is a $C_1$-$C_{20}$ alkyl group, a deuterium-containing $C_1$-$C_{20}$ alkyl group, a $C_3$-$C_{10}$ cycloalkyl group, or a deuterium-containing $C_3$-$C_{10}$ cycloalkyl group.

**7.** The organometallic compound of any of claims 1-5, wherein

$R_{14}$ and $R_{15}$ in Formula 2 are different from each other; and/or
wherein,
in Formula 2,
$R_{13}$ is hydrogen, deuterium, $-CH_3$, $-CDH_2$, $-CD_2H$, or $-CD_3$,
R14 and $R_{15}$ are each independently:

a methyl group, an ethyl group, an n-propyl group, an iso-propyl group, an n-butyl group, a sec-butyl group, an iso-butyl group, a tert-butyl group, an n-pentyl group, a tert-pentyl group, a neopentyl, an iso-pentyl group, a sec-pentyl group, a 3-pentyl group, a sec-isopentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group, a tert-decyl group, a cyclopentyl group, a cyclohexyl group, a cycloheptyl group, a cycloctyl group, an adamantanyl group, a norbornanyl group, a norbornenyl group, a cyclopentenyl group, a cyclohexenyl group, a cycloheptenyl group, bicyclo[1.1.1]pentyl, bicyclo[2.1.1]hexyl, bicyclo[2.2.1]heptyl, or a bicyclo[2.2.2]octyl group; or
a methyl group, an ethyl group, an n-propyl group, an iso-propyl group, an n-butyl group, a sec-butyl group, an iso-butyl group, a tert-butyl group, an n-pentyl group, a tert-pentyl group, a neopentyl, an iso-pentyl group, a sec-pentyl group, a 3-pentyl group, a sec-isopentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group, a tert-decyl group, a cyclopentyl group, a cyclohexyl group, a cycloheptyl group, a cycloctyl group, an adamantanyl group, a norbornanyl group, a norbornenyl group, a cyclopentenyl group, a cyclohexenyl

group, a cycloheptenyl group, bicyclo[1.1.1]pentyl, bicyclo[2.1.1]hexyl, bicyclo[2.2.1]heptyl, or a bicyclo[2.2.2]octyl group, each substituted with at least one deuterium.

**8.** The organometallic compound of any of claims 1-7, wherein $R_{10}$ and $R_{12}$ in Formula 1 are identical to each other.

**9.** The organometallic compound of any of claims 1-7, wherein $R_{10}$ and $R_{12}$ in Formula 1 are different from each other.

**10.** The organometallic compound of claim 1, wherein the organometallic compound is one selected from Compounds 2 to 4 and 6 to 20:

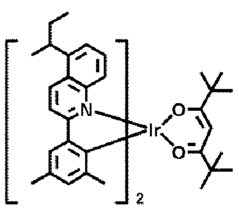

2

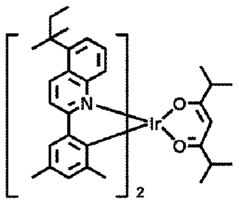

3

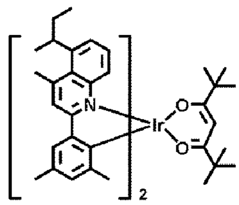

4

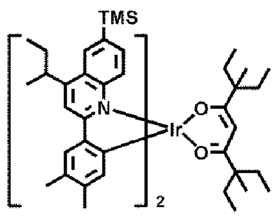

6

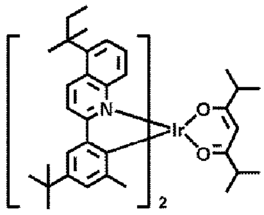

7

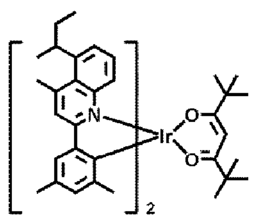

8

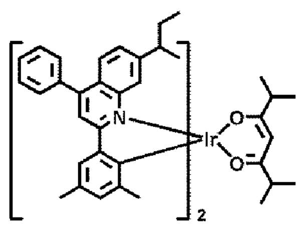

9

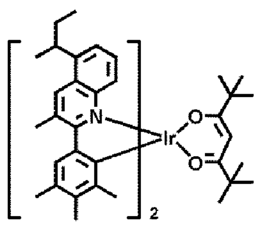

10

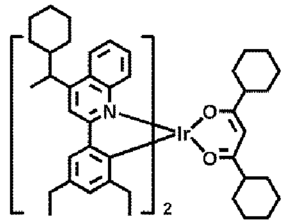

11

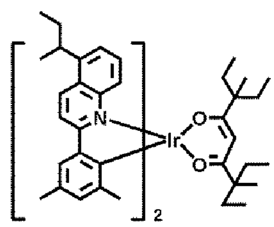

12

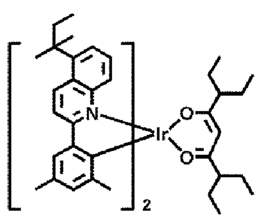

13

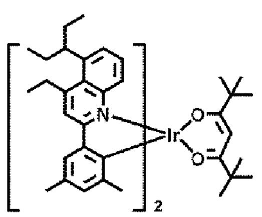

14

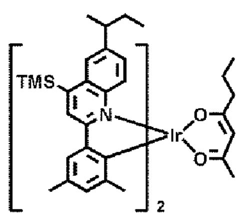

15

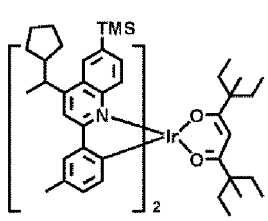

16

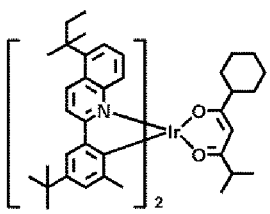

17

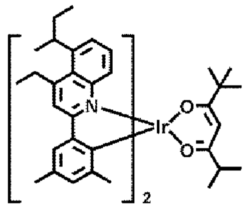

18

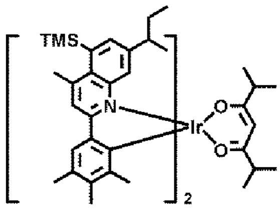

19

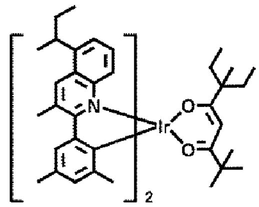

20

.

**11.** An organic light-emitting device comprising:

a first electrode;
a second electrode; and
an organic layer between the first electrode and the second electrode and comprising an emission layer, wherein the organic layer comprises at least one of the organometallic compound of any of claims 1-10.

**12.** The organic light-emitting device of claim 11, wherein

the first electrode is an anode,
the second electrode is a cathode,
the organic layer further comprises a hole transport region between the first electrode and the emission layer and an electron transport region between the emission layer and the second electrode,
the hole transport region comprises a hole injection layer, a hole transport layer, an electron blocking layer, a buffer layer, or any combination thereof, and
the electron transport region comprises a hole blocking layer, an electron transport layer, an electron injection layer, or any combination thereof.

**13.** The organic light-emitting device of claims 11 or 12, wherein

the emission layer comprises the organometallic compound, preferably wherein the emission layer emits red light; and/or
wherein
the emission layer further comprises a host, and an amount of the host in the emission layer is larger than an amount of the organometallic compound in the emission layer.

**14.** A diagnostic composition comprising at least one of the organometallic compound of any of claims 1-10.

**Patentansprüche**

**1.** Metallorganische Verbindung, dargestellt durch Formel 1:

<Formel 1>

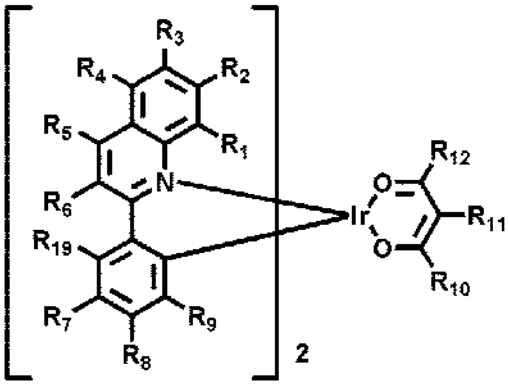

,

wobei in Formel 1 $R_1$ bis $R_{12}$ und $R_{19}$ jeweils unabhängig ausgewählt sind aus Wasserstoff, Deuterium, -F, -Cl, -Br, -I, $-SF_5$, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer substituierten oder unsubstituierten $C_1$-$C_{60}$-Alkylgruppe, einer substituierten oder unsubstituierten $C_2$-$C_{60}$-Alkenylgruppe, einer substituierten oder unsubstituierten $C_2$-$C_{60}$-Alkinylgruppe, einer substituierten oder unsubstituierten $C_1$-$C_{60}$-Alkoxygruppe, einer substituierten oder unsubstituierten $C_3$-$C_{10}$-Cycloalkylgruppe, einer substituierten oder unsubstituierten $C_1$-$C_{10}$-Heterocycloalkylgruppe, einer substituierten oder unsubstituierten $C_3$-$C_{10}$-Cycloalkenylgruppe, einer substituierten oder unsubstituierten $C_1$-$C_{10}$-Heterocycloalkenylgruppe, einer substituierten oder unsubstituierten $C_6$-$C_{60}$-Arylgruppe, einer substituierten oder unsubstituierten $C_6$-$C_{60}$-Aryloxygruppe, einer substituierten oder unsubstituierten $C_6$-$C_{60}$-Arylthiogruppe, einer substituierten oder unsubstituierten $C_1$-$C_{60}$-Heteroarylgruppe, einer substituierten oder unsubstituierten monovalenten nichtaromatischen kondensierten polycyclischen Gruppe, einer substituierten oder unsubstituierten monovalenten nichtaromatischen kondensierten heteropolycyclischen Gruppe, $-N(Q_1)(Q_2)$, $-Si(Q_3)(Q_4)(Q_5)$, - $Ge(Q_3)(Q_4)(Q_5)$, $-B(Q_6)(Q_7)$, $-P(=O)(Q_8)(Q_9)$ und $-P(Q_8)(Q_9)$, und

mindestens eines ausgewählt aus $R_1$ bis $R_5$ jeweils unabhängig ausgewählt ist aus Gruppen, dargestellt durch Formel 2:

<Formel 2>

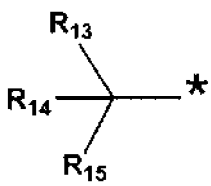

,

wobei die Anzahl der in der Formel 2 beinhalteten Kohlenstoffatome 4 oder mehr ist, $R_{13}$ in Formel 2 Wasserstoff, Deuterium, eine $C_1$-$C_{20}$-Alkylgruppe, eine Deuterium-haltige $C_1$-$C_{20}$-Alkylgruppe, eine $C_3$-$C_{10}$-Cycloalkylgruppe oder eine Deuterium-haltige $C_3$-$C_{10}$-Cycloalkylgruppe ist,

$R_{14}$ und $R_{15}$ in Formel 2 jeweils unabhängig eine $C_1$-$C_{20}$-Alkylgruppe, eine Deuterium-haltige $C_1$-$C_{20}$-Alkylgruppe, eine $C_3$-$C_{10}$-Cycloalkylgruppe oder eine Deuterium-haltige $C_3$-$C_{10}$-Cycloalkylgruppe sind,

vorausgesetzt, dass $R_{13}$, $R_{14}$ und $R_{15}$ nicht gleichzeitig eine Methylgruppe sind,

* eine Bindungsstelle zu einem benachbarten Atom angibt,

wobei 1) mindestens eines ausgewählt aus $R_{10}$ und $R_{12}$ in Formel 1 jeweils unabhängig eine durch Formel 3 dargestellte Gruppe ist, oder 2) mindestens eines von $R_{10}$, $R_{12}$ und $R_{14}$ in Formel 1 und 2 jeweils unabhängig eine $C_3$-$C_{10}$-Cycloalkyl- oder eine Deuterium-haltige $C_3$-$C_{10}$-Cycloalkylgruppe ist:

<Formel 3>

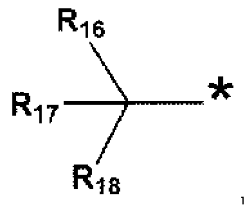

wobei, in Formel 3,
$R_{16}$ bis $R_{18}$ jeweils unabhängig ausgewählt sind aus:

Wasserstoff, Deuterium, einer $C_1$-$C_{20}$-Alkylgruppe, einer $C_3$-$C_{10}$-Cycloalkylgruppe, einer $C_6$-$C_{60}$-Arylgruppe und einer $C_1$-$C_{60}$-Heteroarylgruppe; und
einer $C_1$-$C_{20}$-Alkylgruppe, einer $C_3$-$C_{10}$-Cycloalkylgruppe, einer $C_6$-$C_{60}$-Arylgruppe und einer $C_1$- $C_{60}$-Heteroarylgruppe, jeweils substituiert mit mindestens einem ausgewählt aus Deuterium und einer $C_1$-$C_{20}$-Alkylgruppe,
eines oder mehrere, ausgewählt aus $R_{16}$ bis $R_{18}$ nicht Wasserstoff und Deuterium ist, und
* eine Bindungsstelle zu einem benachbarten Atom angibt,
mindestens ein Substituent der substituierten $C_1$-$C_{60}$-Alkylgruppe, der substituierten $C_2$-$C_{60}$-Alkenylgruppe, der substituierten $C_2$-$C_{60}$-Alkinylgruppe, der substituierten $C_1$-$C_{60}$-Alkoxygruppe, der substituierten $C_3$-$C_{10}$-Cycloalkylgruppe, der substituierten $C_1$-$C_{10}$-Heterocycloalkylgruppe, der substituierten $C_3$-$C_{10}$-Cycloalkenylgruppe, der substituierten $C_1$-$C_{10}$-Heterocycloalkenylgruppe, der substituierten $C_6$-$C_{60}$-Arylgruppe, der substituierten $C_6$-$C_{60}$-Aryloxygruppe, der substituierten $C_6$-$C_{60}$-Arylthiogruppe, der substituierten $C_1$-$C_{60}$-Heteroarylgruppe, der substituierten monovalenten nichtaromatischen kondensierten polycyclischen Gruppe, und der substituierten monovalenten nichtaromatischen kondensierten heteropolycyclischen Gruppe, ausgewählt ist aus:
Deuterium, -F, -Cl, -Br, -I, $-CD_3$, $-CD_2H$, $-CDH_2$, $-CF_3$, $-CF_2H$, $-CFH_2$, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer $C_1$-$C_{60}$-Alkylgruppe, einer $C_2$-$C_{60}$-Alkenylgruppe, einer $C_2$-$C_{60}$-Alkinylgruppe und einer $C_1$-$C_{60}$-Alkoxygruppe;
einer $C_1$-$C_{60}$-Alkylgruppe, einer $C_2$-$C_{60}$-Alkenylgruppe, einer $C_2$-$C_{60}$-Alkinylgruppe und einer $C_1$-$C_{60}$-Alkoxygruppe, jeweils substituiert mit mindestens einem, ausgewählt aus Deuterium, -F, -Cl, -Br, -I, $-CD_3$, $-CD_2H$, $-CDH_2$, $-CF_3$, $-CF_2H$, $-CFH_2$, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer $C_3$-$C_{10}$-Cycloalkylgruppe, einer $C_1$-$C_{10}$-Heterocycloalkylgruppe, einer $C_3$-$C_{10}$-Cycloalkenylgruppe, einer $C_1$-$C_{10}$-Heterocycloalkenylgruppe, einer $C_6$-$C_{60}$-Arylgruppe, einer $C_6$-$C_{60}$-Aryloxygruppe, einer $C_6$-$C_{60}$-Arylthiogruppe, einer $C_1$-$C_{60}$-Heteroarylgruppe, einer monovalenten nicht-aromatischen kondensierten polycyclischen Gruppe, einer monovalenten nicht-aromatischen kondensierten heteropolycyclischen Gruppe, $-N(Q_{11}(Q_{12})$, $-Si(Q_{13})(Q_{14})(Q_{15})$, $-Ge(Q_{13})(Q_{14})(Q_{15})$, $-B(Q_{16})(Q_{17})$, $-P(=O)(Q_{18})(Q_{19})$ und $-P(Q_{18})(Q_{19})$,
einer $C_3$-$C_{10}$-Cycloalkylgruppe, einer $C_1$-$C_{10}$-Heterocycloalkylgruppe, einer $C_3$-$C_{10}$-Cycloalkenylgruppe, einer $C_1$-$C_{10}$-Heterocycloalkenylgruppe, einer $C_6$-$C_{60}$-Arylgruppe, einer $C_6$-$C_{60}$-Aryloxygruppe, einer $C_6$-$C_{60}$-Arylthiogruppe, einer $C_1$-$C_{60}$-Heteroarylgruppe, einer monovalenten nicht-aromatischen kondensierten polycyclischen Gruppe und einer monovalenten nicht-aromatischen kondensierten heteropolycyclischen Gruppe;
einer $C_3$-$C_{10}$-Cycloalkylgruppe, einer $C_1$-$C_{10}$-Heterocycloalkylgruppe, einer $C_3$-$C_{10}$-Cycloalkenylgruppe, einer $C_1$-$C_{10}$-Heterocycloalkenylgruppe, einer $C_6$-$C_{60}$-Arylgruppe, einer $C_6$-$C_{60}$-Aryloxygruppe, einer $C_6$-$C_{60}$-Arylthiogruppe, einer $C_1$-$C_{60}$-Heteroarylgruppe, einer monovalenten nichtaromatischen kondensierten polycyclischen Gruppe und einer monovalenten nichtaromatischen kondensierten heteropolycyclischen Gruppe, jeweils substituiert mit mindestens einem, ausgewählt aus Deuterium, -F, -Cl, -Br, -I, $-CD_3$, $-CD_2H$, $-CDH_2$, $-CF_3$, $-CF_2H$, $-CFH_2$, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer $C_1$-$C_{60}$-Alkylgruppe, einer $C_2$-$C_{60}$-Alkenylgruppe, einer $C_2$-$C_{60}$-Alky-

nylgruppe, einer $C_1$-$C_{60}$-Alkoxygruppe, einer $C_3$-$C_{10}$-Cycloalkylgruppe, einer $C_1$-$C_{10}$-Heterocycloalkylgruppe, einer $C_3$-$C_{10}$-Cycloalkenylgruppe, einer $C_1$-$C_{10}$-Heterocycloalkenylgruppe, einer $C_6$-$C_{60}$-Arylgruppe, einer $C_6$-$C_{60}$-Aryloxygruppe, einer $C_6$-$C_{60}$-Arylthiogruppe, einer $C_1$-$C_{60}$-Heteroarylgruppe, einer monovalenten nichtaromatischen kondensierten polycyclischen Gruppe und einer monovalenten nichtaromatischen kondensierten heteropolycyclischen Gruppe, $-N(Q_{21})(Q_{22})$, $-Si(Q_{23})(Q_{24})(Q_{25})$, $-Ge(Q_{23})(Q_{24})(Q_{25})$, -$B(Q_{26})(Q_{27})$, $-P(=O)(Q_{28})(Q_{29})$ und $-P(Q_{28})(Q_{29})$; und

$-N(Q_{31})(Q_{32})$, $-Si(Q_{33})(Q_{34})(Q_{35})$, $-Ge(Q_{33})(Q_{34})(Q_{35})$, $-B(Q_{36})(Q_{37})$, $-P(=O)(Q_{38})(Q_{39})$ und $-P(C_{38})(Q_{39})$, und

$Q_1$ bis $Q_9$, $Q_{11}$ bis $Q_{19}$, $Q_{21}$ bis $Q_{29}$ und $Q_{31}$ bis $Q_{39}$ jeweils unabhängig ausgewählt sind aus Wasserstoff, Deuterium, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer $C_1$-$C_{60}$-Alkylgruppe, einer $C_2$-$C_{60}$-Alkenylgruppe, einer $C_2$-$C_{60}$-Alkynylgruppe, einer $C_1$-$C_{60}$-Alkoxygruppe, einer $C_3$-$C_{10}$-Cycloalkylgruppe, einer $C_1$-$C_{10}$-Heterocycloalkylgruppe, einer $C_3$-$C_{10}$-Cycloalkenylgruppe, einer $C_1$-$C_{10}$-Heterocycloalkenylgruppe, einer $C_6$-$C_{60}$-Arylgruppe, einer $C_6$-$C_{60}$-Arylgruppe substituiert mit mindestens einem, ausgewählt aus einer $C_1$-$C_{60}$-Alkylgruppe und einer $C_6$-$C_{60}$-Arylgruppe, einer $C_6$-$C_{60}$-Aryloxygruppe, einer $C_6$-$C_{60}$-Arylthiogruppe, einer $C_1$-$C_{60}$-Heteroarylgruppe, einer monovalenten nichtaromatischen kondensierten polycyclischen Gruppe und einer monovalenten nichtaromatischen kondensierten heteropolycyclischen Gruppe.

**2.** Metallorganische Verbindung nach Anspruch 1, wobei
$R_1$ bis $R_{12}$ und $R_{19}$ jeweils unabhängig ausgewählt sind aus:

Wasserstoff, Deuterium, einer Methylgruppe, einer Ethylgruppe, einer n-Propylgruppe, einer iso-Propylgruppe, einer n-Butylgruppe, einer sec-Butylgruppe, einer iso-Butylgruppe, einer tert-Butylgruppe, einer n-Pentylgruppe, einer tert-Pentylgruppe, einer Neopentylgruppe, einer iso-Pentylgruppe, einer sec-Pentylgruppe, einer 3-Pentylgruppe, einer sec-Isopentylgruppe, einer n-Hexylgruppe, einer iso-Hexylgruppe, einer sec-Hexylgruppe, einer tert-Hexylgruppe, einer n-Heptylgruppe, einer iso-Heptylgruppe, einer sec-Heptylgruppe, einer tert-Heptylgruppe, einer n-Octylgruppe, einer iso-Octylgruppe, einer sec-Octylgruppe, einer tert-Octylgruppe, einer n-Nonylgruppe, einer iso-Nonylgruppe, einer sec-Nonylgruppe, einer tert-Nonylgruppe, einer n-Decylgruppe, einer iso-Decylgruppe, einer sec-Decylgruppe, einer tert-Decylgruppe, einer Methoxygruppe, einer Ethoxygruppe, einer Propoxygruppe, einer Butoxygruppe, einer Pentoxygruppe, einer Cyclopentylgruppe, einer Cyclohexylgruppe, einer Cycloheptylgruppe, einer Cycloctylgruppe, einer Adamantanylgruppe, einer Norbornanylgruppe, einer Norbornenylgruppe, einer Cyclopentenylgruppe, einer Cyclohexenylgruppe, einer Cycloheptenylgruppe, Bicyclo[1.1.1]pentyl, Bicyclo[2.1.1]hexyl, Bicyclo[2.2.1]heptyl, einer Bicyclo[2.2.2]octylgruppe, einer Phenylgruppe, einer Biphenylgruppe, einer Terphenylgruppe, einer Naphthylgruppe, einer Pyridinylgruppe, einer Pyrimidinylgruppe, einer Carbazolylgruppe, einer Fluorenylgruppe, einer Dibenzosilolylgruppe, einer Dibenzofuranylgruppe, einer Dibenzothiophenylgruppe oder $-Si(Q_3)(Q_4)(Q_5)$;
einer Methylgruppe, einer Ethylgruppe, einer n-Propylgruppe, einer iso-Propylgruppe, einer n-Butylgruppe, einer sec-Butylgruppe, einer iso-Butylgruppe, einer tert-Butylgruppe, einer n-Pentylgruppe, einer tert-Pentylgruppe, einer Neopentylgruppe, einer iso-Pentylgruppe, einer sec-Pentylgruppe, einer 3-Pentylgruppe, einer sec-Isopentylgruppe, einer n-Hexylgruppe, einer iso-Hexylgruppe, einer sec-Hexylgruppe, einer tert-Hexylgruppe, einer n-Heptylgruppe, einer iso-Heptylgruppe, einer sec-Heptylgruppe, einer tert-Heptylgruppe, einer n-Octylgruppe, einer iso-Octylgruppe, einer sec-Octylgruppe, einer tert-Octylgruppe, einer n-Nonylgruppe, einer iso-Nonylgruppe, einer sec-Nonylgruppe, einer tert-Nonylgruppe, einer n-Decylgruppe, einer iso-Decylgruppe, einer sec-Decylgruppe, und einer tert-Decylgruppe, jeweils substituiert mit mindestens einem Deuterium; und
einer Methoxygruppe, einer Ethoxygruppe, einer Propoxygruppe, einer Butoxygruppe, einer Pentoxygruppe, einer Cyclopentylgruppe, einer Cyclohexylgruppe, einer Cycloheptylgruppe, einer Cycloctylgruppe, einer Adamantanylgruppe, einer Norbornanylgruppe, einer Norbornenylgruppe, einer Cyclopentenylgruppe, einer Cyclohexenylgruppe, einer Cycloheptenylgruppe, Bicyclo[1.1.1]pentyl, Bicyclo[2.1.1]hexyl, Bicyclo[2.2.1]heptyl, einer Bicyclo[2.2.2]octylgruppe, einer Phenylgruppe, einer Biphenylgruppe, einer Terphenylgruppe, einer Naphthylgruppe, einer Pyridinylgruppe, einer Pyrimidinylgruppe, einer Carbazolylgruppe, einer Fluorenylgruppe, einer Dibenzosilolylgruppe, einer Dibenzofuranylgruppe und einer Dibenzothiophenylgruppe, jeweils substituiert mit mindestens einem, ausgewählt aus Deuterium und einer $C_1$-$C_{10}$-Alkylgruppe, und
$Q_3$ bis $Q_5$ jeweils unabhängig ausgewählt sind aus:

$-CH_3$, $-CD_3$, $-CD_2H$, $-CDH_2$, $-CH_2CH_3$, $-CH_2CD_3$, $-CH_2CD_2H$, $-CH_2CDH_2$, $-CHDCH_3$, - $CHDCD_2H$, $-CHDCDH_2$, $-CHDCD_3$, $-CD_2CD_3$, $-CD_2CD_2H$ und $-CD_2CDH_2$;

einer n-Propylgruppe, einer Isopropylgruppe, einer n-Butylgruppe, einer Isobutylgruppe, einer sec-Butylgruppe, einer tert-Butylgruppe, einer n-Pentylgruppe, einer Isopentylgruppe, einer sec-Pentylgruppe, einer tert-Pentylgruppe, einer Phenylgruppe und einer Naphthylgruppe; und
einer n-Propylgruppe, einer iso-Propylgruppe, einer n-Butylgruppe, einer iso-Butylgruppe, einer sec-Butylgruppe, einer tert-Butylgruppe, einer n-Pentylgruppe, einer iso-Pentylgruppe, einer sec-Pentylgruppe, einer tert-Pentylgruppe, einer Phenylgruppe und einer Naphthylgruppe, jeweils substituiert mit mindestens einem, ausgewählt aus Deuterium, einer $C_1$-$C_{10}$-Alkylgruppe und einer Phenylgruppe.

**3.** Metallorganische Verbindung nach Anspruch 1 oder 2, wobei eines ausgewählt aus $R_2$ bis $R_5$ in Formel 1 eine durch Formel 2 dargestellte Gruppe ist.

**4.** Metallorganische Verbindung nach einem der Ansprüche 1-3, wobei

1) $R_2$ eine durch Formel 2 dargestellte Gruppe ist und $R_1$ und $R_3$ bis $R_6$ Wasserstoff sind,
2) $R_3$ eine durch Formel 2 dargestellte Gruppe ist und $R_1$, $R_2$ und $R_4$ bis $R_6$ Wasserstoff sind,
3) $R_4$ eine durch Formel 2 dargestellte Gruppe ist und $R_1$ bis $R_3$, $R_5$ und $R_6$ Wasserstoff sind,
4) $R_5$ eine durch Formel 2 dargestellte Gruppe ist und $R_1$ bis $R_4$ und $R_6$ Wasserstoff sind,
5) $R_4$ eine durch Formel 2 dargestellte Gruppe ist, $R_5$ eine substituierte oder unsubstituierte $C_1$-$C_{60}$-Alkylgruppe, eine substituierte oder unsubstituierte $C_3$-$C_{10}$-Cycloalkylgruppe, eine Phenylgruppe, eine Biphenylgruppe oder -Si($Q_3$)($Q_4$)($Q_5$) ist, und $R_1$, $R_2$, $R_3$ und $R_6$ Wasserstoff sind,
6) $R_5$ eine durch Formel 2 dargestellte Gruppe ist, $R_3$ eine substituierte oder unsubstituierte $C_1$-$C_{60}$-Alkylgruppe, eine substituierte oder unsubstituierte $C_3$-$C_{10}$-Cycloalkylgruppe, eine Phenylgruppe, eine Biphenylgruppe oder -Si($Q_3$)($Q_4$)($Q_5$) ist, und $R_1$, $R_2$, $R_4$ und $R_6$ Wasserstoff sind,
7) $R_2$ eine durch Formel 2 dargestellte Gruppe ist, $R_5$ eine substituierte oder unsubstituierte $C_1$-$C_{60}$-Alkylgruppe, eine substituierte oder unsubstituierte $C_3$-$C_{10}$-Cycloalkylgruppe, eine Phenylgruppe, eine Biphenylgruppe oder -Si($Q_3$)($Q_4$)($Q_5$) ist, und $R_1$, $R_3$, $R_4$ und $R_6$ Wasserstoff sind,
8) $R_4$ eine durch Formel 2 dargestellte Gruppe ist, $R_6$ eine substituierte oder unsubstituierte $C_1$-$C_{60}$-Alkylgruppe, eine substituierte oder unsubstituierte $C_3$-$C_{10}$-Cycloalkylgruppe, eine Phenylgruppe, eine Biphenylgruppe oder -Si($Q_3$)($Q_4$)($Q_5$) ist, und $R_1$, $R_2$, $R_3$ und $R_5$ Wasserstoff sind,
9) $R_3$ eine durch Formel 2 dargestellte Gruppe ist, $R_5$ eine substituierte oder unsubstituierte $C_1$-$C_{60}$-Alkylgruppe, eine substituierte oder unsubstituierte $C_3$-$C_{10}$-Cycloalkylgruppe, eine Phenylgruppe, eine Biphenylgruppe oder -Si($C_3$)($Q_4$)($Q_5$) ist, und $R_1$, $R_2$, $R_4$ und $R_6$ Wasserstoff sind, oder
10) $R_2$ eine durch Formel 2 dargestellte Gruppe ist, $R_4$ und $R_5$ jeweils unabhängig eine substituierte oder unsubstituierte $C_1$-$C_{60}$-Alkylgruppe, eine substituierte oder unsubstituierte $C_3$-$C_{10}$-Cycloalkylgruppe, eine Phenylgruppe, eine Biphenylgruppe oder -Si($C_3$)($Q_4$)($Q_5$) sind, und $R_1$, $R_3$ und $R_6$ Wasserstoff sind.

**5.** Metallorganische Verbindung nach einem der Ansprüche 1-4, wobei mindestens eines von $R_7$ bis $R_9$ jeweils unabhängig eine substituierte oder unsubstituierte $C_1$-$C_{60}$-Alkylgruppe, eine substituierte oder unsubstituierte $C_3$-$C_{10}$-Cycloalkylgruppe oder eine substituierte oder unsubstituierte $C_6$-$C_{60}$-Arylgruppe ist.

**6.** Metallorganische Verbindung nach einem der Ansprüche 1-5, wobei

$R_{13}$ in Formel 2 Wasserstoff oder Deuterium ist; oder
wobei
$R_{13}$ in Formel 2 eine $C_1$-$C_{20}$-Alkylgruppe, eine Deuterium-haltige $C_1$-$C_{20}$-Alkylgruppe, eine $C_3$-$C_{10}$-Cycloalkylgruppe oder eine Deuterium-haltige $C_3$-$C_{10}$-Cycloalkylgruppe ist.

**7.** Metallorganische Verbindung nach einem der Ansprüche 1-5, wobei

$R_{14}$ und $R_{15}$ in Formel 2 voneinander verschieden sind; und/oder
wobei
in Formel 2,
$R_{13}$ Wasserstoff, Deuterium, $-CH_3$, $-CDH_2$, $-CD_2H$ oder $-CD_3$ ist,
$R_{14}$ und $R_{15}$ jeweils unabhängig Folgendes sind:

eine Methylgruppe, an Ethylgruppe, an n-Propylgruppe, an iso-Propylgruppe, an n-Butylgruppe, eine sec-Butylgruppe, aniso-Butylgruppe, eine tert-Butylgruppe, an n-Pentylgruppe, eine tert-Pentylgruppe, ein Neopentyl, an iso-Pentylgruppe, eine sec-Pentylgruppe, eine 3-Pentylgruppe, eine sec-Isopentylgruppe, an n-Hexylgruppe, an iso-Hexylgruppe, eine sec-Hexylgruppe, eine tert-Hexylgruppe, an n-Heptylgruppe, an iso-Heptylgruppe, eine sec-Heptylgruppe, eine tert-Heptylgruppe, an n-Octylgruppe, an iso-Octylgruppe, eine sec-Octylgruppe, eine tert-Octylgruppe, an n-Nonylgruppe, an iso-Nonylgruppe, eine sec-Nonylgruppe, eine tert-Nonylgruppe, an n-Decylgruppe, an iso-Decylgruppe, eine sec-Decylgruppe, eine tert-Decylgruppe, eine Cyclopentylgruppe, eine Cyclohexylgruppe, eine Cycloheptylgruppe, eine Cycloctylgruppe, an Adamantanylgruppe, eine Norbornanylgruppe, eine Norbornenylgruppe, eine Cyclopentenylgruppe, eine Cyclohexenylgruppe, eine Cycloheptenylgruppe, Bicyclo[1.1.1]pentyl, Bicyclo[2.1.1]hexyl, Bicyclo[2.2.1]heptyl oder eine Bicyclo[2.2.2]octylgruppe; oder
eine Methylgruppe, an Ethylgruppe, an n-Propylgruppe, an iso-Propylgruppe, an n-Butylgruppe, eine sec-Butylgruppe, aniso-Butylgruppe, eine tert-Butylgruppe, an n-Pentylgruppe, eine tert-Pentylgruppe, ein Neopentyl, an iso-Pentylgruppe, eine sec-Pentylgruppe, eine 3-Pentylgruppe, eine sec-Isopentylgruppe, an n-Hexylgruppe, an iso-Hexylgruppe, eine sec-Hexylgruppe, eine tert-Hexylgruppe, an n-Heptylgruppe, an iso-Heptylgruppe, eine sec-Heptylgruppe, eine tert-Heptylgruppe, an n-Octylgruppe, an iso-Octylgruppe, eine sec-Octylgruppe, eine tert-Octylgruppe, an n-Nonylgruppe, an iso-Nonylgruppe, eine sec-Nonylgruppe, eine tert-Nonylgruppe, an n-Decylgruppe, an iso-Decylgruppe, eine sec-Decylgruppe, eine tert-Decylgruppe, eine Cyclopentylgruppe, eine Cyclohexylgruppe, eine Cycloheptylgruppe, eine Cycloctylgruppe, an Adamantanylgruppe, eine Norbornanylgruppe, eine Norbornenylgruppe, eine Cyclopentenylgruppe, eine Cyclohexenylgruppe, eine Cycloheptenylgruppe, Bicyclo[1.1.1]pentyl, Bicyclo[2.1.1]hexyl, Bicyclo[2.2.1]heptyl oder eine Bicyclo[2.2.2]octylgruppe; jeweils substituiert mit mindestens einem Deuterium.

**8.** Metallorganische Verbindung nach einem der Ansprüche 1-7, wobei $R_{10}$ und $R_{12}$ in Formel 1 identisch zueinander sind.

**9.** Metallorganische Verbindung nach einem der Ansprüche 1-7, wobei $R_{10}$ und $R_{12}$ in Formel 1 voneinander verschieden sind.

**10.** Metallorganische Verbindung nach Anspruch 1, wobei
die metallorganische Verbindung eine ausgewählt aus den Verbindungen 2 bis 4 und 6 bis 20 ist:

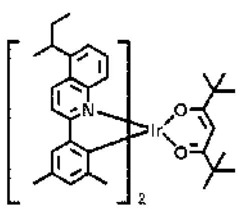

**2**

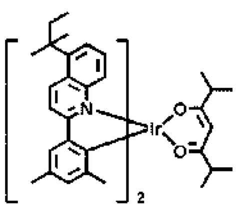

**3**

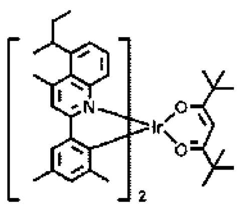

**4**

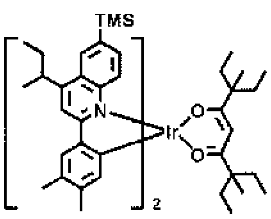

**6**

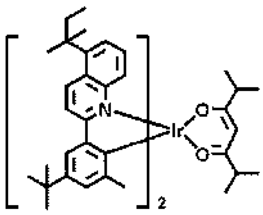

**7**

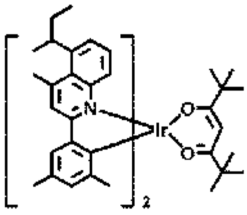

**8**

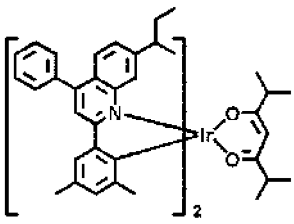
9

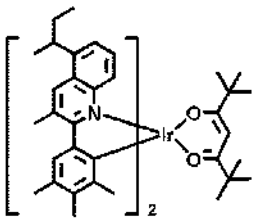
10

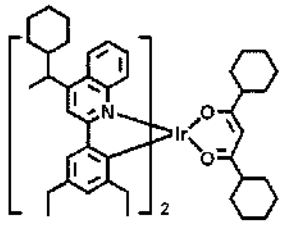
11

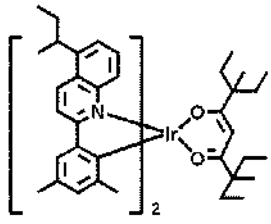
12

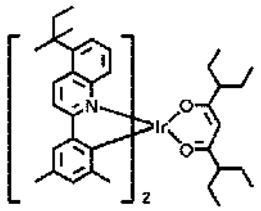
13

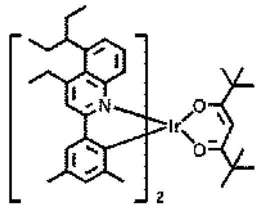
14

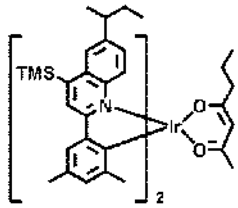
15

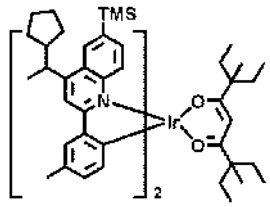
16

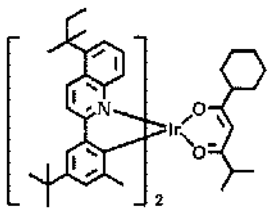
17

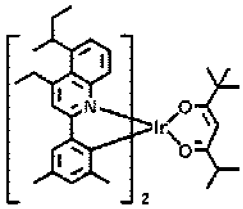
18

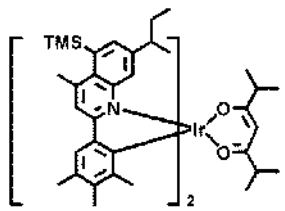
19

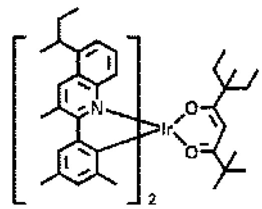
20

**11.** Organische lichtemittierende Vorrichtung, umfassend:

eine erste Elektrode;
eine zweite Elektrode; und
eine organische Schicht zwischen der ersten Elektrode und der zweiten Elektrode und umfassend eine Emissionsschicht,
wobei die organische Schicht mindestens eine der metallorganischen Verbindung nach einem der Ansprüche 1-10 umfasst.

**12.** Organische lichtemittierende Vorrichtung nach Anspruch 11, wobei

die erste Elektrode eine Anode ist,
die zweite Elektrode eine Kathode ist,
die organische Schicht ferner einen Lochtransportbereich zwischen der ersten Elektrode und der Emissionsschicht und einen Elektronentransportbereich zwischen der Emissionsschicht und der zweiten Elektrode umfasst,
der Lochtransportbereich eine Lochinjektionsschicht, eine Lochtransportschicht, eine Elektronensperrschicht, eine Pufferschicht oder eine beliebige Kombination davon umfasst, und
der Elektronentransportbereich eine Lochsperrschicht, eine Elektronentransportschicht, eine Elektroneninjektionsschicht oder eine beliebige Kombination davon umfasst.

**13.** Organische lichtemittierende Vorrichtung nach Anspruch 11 oder 12, wobei

die Emissionsschicht die metallorganische Verbindung umfasst, wobei die Emissionsschicht vorzugsweise rotes Licht emittiert; und/oder
wobei
die Emissionsschicht ferner einen Wirt umfasst, und eine Menge des Wirts in der Emissionsschicht größer ist

als eine Menge der metallorganischen Verbindung in der Emissionsschicht.

**14.** Diagnostische Zusammensetzung, umfassend mindestens eine der metallorganischen Verbindung nach einem der Ansprüche 1 bis 10.

**Revendications**

**1.** Composé organométallique représenté par la formule 1 :

<Formule 1>

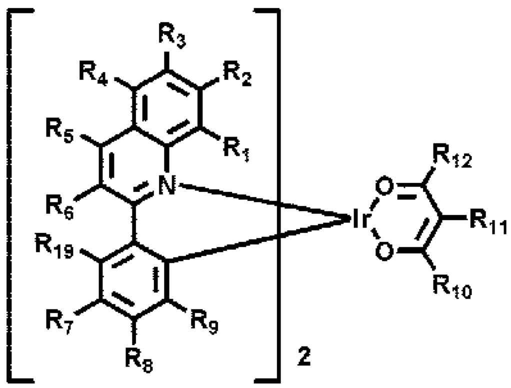

,

dans laquelle, dans la formule 1, $R_1$ à $R_{12}$ et $R_{19}$ sont chacun indépendamment choisis parmi un atome d'hydrogène, un atome de deutérium, un groupe -F, -Cl, -Br, -I, $-SF_5$, un groupe hydroxy, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe ($C_1$ à $C_{60}$)alkyle substitué ou non substitué, un groupe ($C_2$ à $C_{60}$)alcényle substitué ou non substitué, un groupe ($C_2$ à $C_{60}$)alcynyle substitué ou non substitué, un groupe ($C_1$ à $C_{60}$)alcoxy substitué ou non substitué, un groupe ($C_3$ à $C_{10}$)cycloalkyle substitué ou non substitué, un groupe ($C_1$ à $C_{10}$)hétéocycloalkyle substitué ou non substitué, un groupe ($C_3$ à $C_{10}$)cycloalcényle substitué ou non substitué, un groupe ($C_1$ à $C_{10}$)hétéocycloalcényle substitué ou non substitué, un groupe ($C_6$ à $C_{60}$)aryle substitué ou non substitué, un groupe ($C_6$ à $C_{60}$)aryloxy substitué ou non substitué, un groupe ($C_6$ à $C_{60}$)arylthio substitué ou non substitué, un groupe ($C_1$ à $C_{60}$)hétéroaryle substitué ou non substitué, un groupe polycyclique condensé non aromatique monovalent substitué ou non substitué, un groupe hétéropolycyclique condensé non aromatique monovalent substitué ou non substitué, $-N(Q_1)(Q_2)$, $-Si(Q_3)(Q_4)(Q_5)$, $-Ge(Q_3)(Q_4)(Q_5)$, $-B(Q_6)(Q_7)$, $-P(=O)(Q_8)(Q_9)$ et - $P(Q_8)(Q_9)$, et

au moins un groupe sélectionné parmi $R_1$ à $R_6$ est chacun indépendamment choisi parmi les groupes représentés par la formule 2 :

<Formule 2>

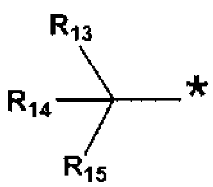

,

dans laquelle le nombre d'atomes de carbone inclus dans la formule 2 est de 4 ou plus,

$R_{13}$ dans la formule 2 représente un atome d'hydrogène, un atome de deutérium, un groupe ($C_1$ à $C_{20}$)alkyle, un groupe ($C_1$ à $C_{20}$)alkyle contenant du deutérium, un groupe ($C_3$ à $C_{10}$)cycloalkyle, ou un groupe ($C_3$ à $C_{10}$)cycloalkyle contenant du deutérium,

$R_{14}$ et $R_{15}$ dans la formule 2 représentent chacun indépendamment un groupe ($C_1$ à $C_{20}$)alkyle, un groupe ($C_1$

à $C_{20}$)alkyle contenant du deutérium, un groupe ($C_3$ à $C_{10}$)cycloalkyle, un groupe ($C_3$ à $C_{10}$)cycloalkyle contenant du deutérium,

à condition que, $R_{13}$, $R_{14}$ et $R_{15}$ ne représentent pas un groupe méthyle, simultanément,

* indique un site de liaison à un atome voisin,

dans laquelle 1) au moins un groupe choisi parmi $R_{10}$ et $R_{12}$ dans la formule 1 représentent chacun indépendamment un groupe représenté par la formule 3, ou 2) au moins l'un des groupes $R_{10}$, $R_{12}$ et $R_{14}$ dans les formules 1 et 2 représentent chacun indépendamment un groupe ($C_3$ à $C_{10}$)cycloalkyle, ou un groupe ($C_3$ à $C_{10}$)cycloalkyle contenant du deutérium :

<Formule 3>

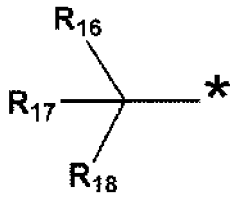

dans laquelle, dans la formule 3,

$R_6$ à $R_{18}$ sont chacun indépendamment choisis parmi :

un atome d'hydrogène, un atome de deutérium, un groupe ($C_1$ à $C_{20}$)alkyle, un groupe ($C_3$ à $C_{10}$)cycloalkyle, un groupe ($C_6$ à $C_{60}$)aryle, et un groupe ($C_1$ à $C_{60}$)hétéroaryle ; et

un groupe ($C_1$ à $C_{20}$)alkyle, un groupe ($C_3$ à $C_{10}$)cycloalkyle, un groupe ($C_6$ à $C_{60}$)aryle, et un groupe ($C_1$ à $C_{60}$)hétéroaryle, chacun substitué par au moins un élément choisi parmi un atome de deutérium et un groupe ($C_1$ à $C_{20}$)alkyle,

un ou plusieurs groupes choisis parmi $R_{16}$ à $R_{18}$ ne représentent pas un atome d'hydrogène et un atome de deutérium, et

* indique un site de liaison à un atome voisin,

au moins un substituant parmi le groupe ($C_1$ à $C_{60}$)alkyle substitué, le groupe ($C_2$ à $C_{60}$)alcényle substitué, le groupe ($C_2$ à $C_{60}$)alcynyle substitué, le groupe ($C_1$ à $C_{60}$)alcoxy substitué, le groupe ($C_3$ à $C_{10}$)cycloalkyle substitué, le groupe ($C_1$ à $C_{10}$)hétérocycloalkyle substitué, le groupe ($C_3$ à $C_{10}$)cycloalcényle substitué, le groupe ($C_1$ à $C_{10}$)hétérocycloalcényle substitué, le groupe ($C_6$ à $C_{60}$)aryle substitué, le groupe ($C_6$ à $C_{60}$)aryloxy substitué, le groupe ($C_6$ à $C_{60}$)arylthio substitué, le groupe ($C_1$ à $C_{60}$)hétéroaryle substitué, le groupe polycyclique condensé non aromatique monovalent substitué, et le groupe hétéropolycyclique condensé non aromatique monovalent substitué est choisi parmi :

un atome de deutérium, un groupe -F, -Cl, -Br, -I, $-CD_3$, $-CD_2H$, $-CDH_2$, $-CF_3$, $-CF_2H$, - $CFH_2$, un groupe hydroxy, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe ($C_1$ à $C_{60}$)alkyle, un groupe ($C_2$ à $C_{60}$)alcényle, un groupe ($C_2$ à $C_{60}$)alcynyle, et un groupe ($C_1$ à $C_{60}$)alcoxy ;

un groupe ($C_1$ à $C_{60}$)alkyle, un groupe ($C_2$ à $C_{60}$)alcényle, un groupe ($C_2$ à $C_{60}$)alcynyle, et un groupe ($C_1$ à $C_{60}$)alcoxy, chacun substitué par au moins un élément choisi parmi un atome de deutérium, un groupe -F, -Cl, -Br, -I, $-CD_3$, $-CD_2H$, $-CDH_2$, $-CF_3$, $-CF_2H$, $-CFH_2$, un groupe hydroxy, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe ($C_3$ à $C_{10}$)cycloalkyle, un groupe ($C_1$ à $C_{10}$)hétérocycloalkyle, un groupe ($C_3$ à $C_{10}$)cycloalcényle, un groupe ($C_1$ à $C_{10}$)hétérocycloalcényle, un groupe ($C_6$ à $C_{60}$)aryle, un groupe ($C_6$ à $C_{60}$)aryloxy, un groupe ($C_6$ à $C_{60}$)arylthio, un groupe ($C_1$ à $C_{60}$)hétéroaryle, un groupe polycyclique condensé non aromatique monovalent, un groupe hétéropolycyclique condensé non aromatique monovalent, $-N(Q_{11}(Q_{12})$, $-Si(Q_{13})(Q_{14})(Q_{15})$, $-Ge(Q_{13})(Q_{14})(Q_{15})$, $-B(Q_{16})(Q_{17})$, - $P(=O)(Q_{18})(Q_{19})$ et $-P(Q_{18})(Q_{19})$ ;

un groupe ($C_3$ à $C_{10}$)cycloalkyle, un groupe ($C_1$ à $C_{10}$)hétérocycloalkyle, un groupe ($C_3$ à $C_{10}$)cycloalcényle, un groupe ($C_1$ à $C_{10}$)hétérocycloalcényle, un groupe ($C_6$ à $C_{60}$)aryle, un groupe ($C_6$ à $C_{60}$)aryloxy, un groupe ($C_6$ à $C_{60}$)arylthio, un groupe ($C_1$ à $C_{60}$)hétéroaryle, un groupe polycyclique condensé non aromatique monovalent, et un groupe hétéropolycyclique condensé non aromatique monovalent ;

un groupe ($C_3$ à $C_{10}$)cycloalkyle, un groupe ($C_1$ à $C_{10}$)hétérocycloalkyle, un groupe ($C_3$ à $C_{10}$)cycloalcényle,

un groupe ($C_1$ à $C_{10}$)hétérocycloalcényle, un groupe ($C_6$ à $C_{60}$)aryle, un groupe ($C_6$ à $C_{60}$)aryloxy, un groupe ($C_6$ à $C_{60}$)arylthio, un groupe ($C_1$ à $C_{60}$)hétéroaryle, un groupe polycyclique condensé non aromatique monovalent, et un groupe hétéropolycyclique condensé non aromatique monovalent, chacun substitué par au moins un élément choisi parmi un atome de deutérium, un groupe -F, -Cl, -Br, -I, $-CD_3$, $-CD_2H$, $-CDH_2$, $-CF_3$, $-CF_2H$, $-CFH_2$, un groupe hydroxy, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe ($C_1$ à $C_{60}$)alkyle, un groupe ($C_2$ à $C_{60}$)alcényle, un groupe ($C_2$ à $C_{60}$)alcynyle, un groupe ($C_1$ à $C_{60}$)alcoxy, un groupe ($C_3$ à $C_{10}$)cycloalkyle, un groupe ($C_1$ à $C_{10}$)hétérocycloalkyle, un groupe ($C_3$ à $C_{10}$)cycloalcényle, un groupe ($C_1$ à $C_{10}$)hétérocycloalcényle, un groupe ($C_6$ à $C_{60}$)aryle, un groupe ($C_6$ à $C_{60}$)aryloxy, un groupe ($C_6$ à $C_{60}$)arylthio, un groupe ($C_1$ à $C_{60}$)hétéroaryle, un groupe polycyclique condensé non aromatique monovalent, un groupe hétéropolycyclique condensé non aromatique monovalent, $-N(Q_{21})(Q_{22})$, $-Si(Q_{23})(Q_{24})(Q_{25})$, $-Ge(Q_{23})(Q_{24})(Q_{25})$, $-B(Q_{26})(Q_{27})$, $-P(=O)(Q_{28})(Q_{29})$ et $-P(Q_{28})(Q_{29})$ ; et $-N(Q_{31})(Q_{32})$, $-Si(Q_{33})(Q_{34})(Q_{35})$, $-Ge(Q_{33})(Q_{34})(Q_{35})$, $-B(Q_{36})(Q_{37})$, $-P(=O)(Q_{38})(Q_{39})$ et $-P(Q_{38})(Q_{39})$, et $Q_1$ à $Q_9$, $Q_{11}$ à $Q_{19}$, $Q_{21}$ à $Q_{29}$ et $Q_{31}$ à $Q_{39}$ sont chacun indépendamment choisis parmi un atome d'hydrogène, un atome de deutérium, un groupe -F, -Cl, -Br, -I, un groupe hydroxy, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe ($C_1$ à $C_{60}$)alkyle, un groupe ($C_2$ à $C_{60}$)alcényle, un groupe ($C_2$ à $C_{60}$)alcynyle, un groupe ($C_1$ à $C_{60}$)alcoxy, un groupe ($C_3$ à $C_{10}$)cycloalkyle, un groupe ($C_1$ à $C_{10}$)hétérocycloalkyle, un groupe ($C_3$ à $C_{10}$)cycloalcényle, un groupe ($C_1$ à $C_{10}$)hétérocycloalcényle, un groupe ($C_6$ à $C_{60}$)aryle, un groupe ($C_6$ à $C_{60}$)aryle substitué par au moins un groupe choisi parmi un groupe ($C_1$ à $C_{60}$)alkyle et un groupe ($C_6$ à $C_{60}$)aryle, un groupe ($C_6$ à $C_{60}$)aryloxy, un groupe ($C_6$ à $C_{60}$)arylthio, un groupe ($C_1$ à $C_{60}$)hétéroaryle, un groupe polycyclique condensé non aromatique monovalent, et un groupe hétéropolycyclique condensé non aromatique monovalent.

**2.** Composé organométallique selon la revendication 1,
$R_1$ à $R_{12}$ et $R_{19}$ étant chacun indépendamment choisis parmi :

un atome d'hydrogène, un atome de deutérium, un groupe méthyle, un groupe éthyle, un groupe n-propyle, un groupe iso-propyle, un groupe n-butyle, un groupe sec-butyle, un groupe iso-butyle, un groupe tert-butyle, un groupe n-pentyle, un groupe tert-pentyle, un groupe néopentyle, un groupe iso-pentyle, un groupe sec-pentyle, un groupe 3-pentyle, un groupe sec-isopentyle, un groupe n-hexyle, un groupe iso-hexyle, un groupe sec-hexyle, un groupe tert-hexyle, un groupe n-heptyle, un groupe iso-heptyle, un groupe sec-heptyle, un groupe tert-heptyle, un groupe n-octyle, un groupe iso-octyle, un groupe sec-octyle, un groupe tert-octyle, un groupe n-nonyle, un groupe iso-nonyle, un groupe sec-nonyle, un groupe tert-nonyle, un groupe n-décyle, un groupe iso-décyle, un groupe sec-décyle, un groupe tert-décyle, un groupe méthoxy, un groupe éthoxy, un groupe propoxy, un groupe butoxy, un groupe pentoxy, un groupe cyclopentyle, un groupe cyclohexyle, un groupe cycloheptyle, un groupe cycloctyle, un groupe adamantanyle, un groupe norbornanyle, un groupe norbornényle, un groupe cyclopentényle, un groupe cyclohexényle, un groupe cycloheptényle, un groupe bicyclo[1.1.1]pentyle, un groupe bicyclo[2.1.1]hexyle, un groupe bicyclo[2.2.1]heptyle, un groupe bicyclo[2.2.2]octyle, un groupe phényle, un groupe biphényle, un groupe terphényle, un groupe naphtyle, un groupe pyridinyle, un groupe pyrimidinyle, un groupe carbazolyle, un groupe fluorényle, un groupe dibenzosilolyle, un groupe dibenzofuranyle, un groupe dibenzothiophényle, ou $-Si(Q_3)(Q_4)(Q_5)$ ;

un groupe méthyle, un groupe éthyle, un groupe n-propyle, un groupe iso-propyle, un groupe n- butyle, un groupe sec-butyle, un groupe iso-butyle, un groupe tert-butyle, un groupe n-pentyle, un groupe tert-pentyle, un groupe néopentyle, un groupe iso-pentyle, un groupe sec-pentyle, un groupe 3-pentyle, un groupe sec-isopentyle, un groupe n-hexyle, un groupe iso-hexyle, un groupe sec-hexyle, un groupe tert-hexyle, un groupe n-heptyle, un groupe iso-heptyle, un groupe sec-heptyle, un groupe tert-heptyle, un groupe n-octyle, un groupe iso-octyle, un groupe sec-octyle, un groupe tert-octyle, un groupe n-nonyle, un groupe iso-nonyle, un groupe sec-nonyle, un groupe tert-nonyle, un groupe n-décyle, un groupe iso-décyle, un groupe sec-décyle, et un groupe tert-décyle, chacun substitué par au moins un atome de deutérium ; et

un groupe méthoxy, un groupe éthoxy, un groupe propoxy, un groupe butoxy, un groupe pentoxy, un groupe cyclopentyle, un groupe cyclohexyle, un groupe cycloheptyle, un groupe cycloctyle, un groupe adamantanyle, un groupe norbornanyle, un groupe norbornényle, un groupe cyclopentényle, un groupe cyclohexényle, un groupe cycloheptényle, un groupe bicyclo[1.1.1]pentyle, un groupe bicyclo[2.1.1]hexyle, un groupe bicyclo[2.2.1]heptyle, un groupe bicyclo[2.2.2]octyle, un groupe phényle, un groupe biphényle, un groupe terphényle, un groupe naphtyle, un groupe pyridinyle, un groupe pyrimidinyle, un groupe carbazolyle, un groupe fluorényle,

un groupe dibenzosilolyle, un groupe dibenzofuranyle, et un groupe dibenzothiophényle, chacun substitué par au moins un élément choisi parmi un atome de deutérium et un groupe ($C_1$ à $C_{10}$)alkyle, et
$Q_3$ à $Q_5$ sont chacun indépendamment choisis parmi :

$-CH_3$, $-CD_3$, $-CD_2H$, $-CDH_2$, $-CH_2CH_3$, $-CH_2CD_3$, $-CH_2CD_2H$, $-CH_2CDH_2$, $-CHDCH_3$, - $CHDCD_2H$, $-CHDCDH_2$, $-CHDCD_3$, $-CD_2CD_3$, $-CD_2CD_2H$ et $-CD_2CDH_2$ ;
un groupe n-propyle, un groupe iso-propyle, un groupe n-butyle, un groupe iso-butyle, un groupe sec-butyle, un groupe tert-butyle, un groupe n-pentyle, un groupe iso-pentyle, un groupe sec-pentyle, un groupe tert-pentyle, un groupe phényle, et un groupe naphtyle ; et
un groupe n-propyle, un groupe iso-propyle, un groupe n-butyle, un groupe iso-butyle, un groupe sec-butyle, un groupe tert-butyle, un groupe n-pentyle, un groupe iso-pentyle, un groupe sec-pentyle, un groupe tert-pentyle, un groupe phényle, et un groupe naphtyle, chacun substitué par au moins un élément choisi parmi un atome de deutérium, un groupe ($C_1$ à $C_{10}$)alkyle et un groupe phényle.

**3.** Composé organométallique selon la revendication 1 ou 2,
un groupe choisi parmi $R_2$ à $R_5$ dans la formule 1 étant un groupe représenté par la formule 2.

**4.** Composé organométallique selon l'une quelconque des revendications 1 à 3,

1) $R_2$ étant un groupe représenté par la formule 2 et $R_1$ et $R_3$ à $R_6$ représentant un atome d'hydrogène,
2) $R_3$ étant un groupe représenté par la formule 2 et $R_1$, $R_2$ et $R_4$ à $R_6$ représentant un atome d'hydrogène,
3) $R_4$ étant un groupe représenté par la formule 2 et $R_1$ à $R_3$, $R_5$ et $R_6$ représentant un atome d'hydrogène,
4) $R_5$ étant un groupe représenté par la formule 2 et $R_1$ à $R_4$ et $R_6$ représentant un atome d'hydrogène,
5) $R_4$ étant un groupe représenté par la formule 2, $R_5$ représentant un groupe ($C_1$ à $C_{60}$)alkyle substitué ou non substitué, un groupe ($C_3$ à $C_{10}$)cycloalkyle substitué ou non substitué, un groupe phényle, un groupe biphényle, ou $-Si(Q_3)(Q_4)(Q_5)$ et $R_1$, $R_2$, $R_3$ et $R_6$ représentant un atome d'hydrogène,
6) $R_5$ étant un groupe représenté par la formule 2, $R_3$ représentant un groupe ($C_1$ à $C_{60}$)alkyle substitué ou non substitué, un groupe ($C_3$ à $C_{10}$)cycloalkyle substitué ou non substitué, un groupe phényle, un groupe biphényle, ou $-Si(Q_3)(Q_4)(Q_5)$ et $R_1$, $R_2$, $R_4$ et $R_6$ représentant un atome d'hydrogène,
7) $R_2$ étant un groupe représenté par la formule 2, $R_5$ représentant un groupe ($C_1$ à $C_{60}$)alkyle substitué ou non substitué, un groupe ($C_3$ à $C_{10}$)cycloalkyle substitué ou non substitué, un groupe phényle, un groupe biphényle, ou $-Si(Q_3)(Q_4)(Q_5)$ et $R_1$, $R_3$, $R_4$ et $R_6$ représentant un atome d'hydrogène,
8) $R_4$ étant un groupe représenté par la formule 2, $R_6$ représentant un groupe ($C_1$ à $C_{60}$)alkyle substitué ou non substitué, un groupe ($C_3$ à $C_{10}$)cycloalkyle substitué ou non substitué, un groupe phényle, un groupe biphényle, ou $-Si(Q_3)(Q_4)(Q_5)$ et $R_1$, $R_2$, $R_3$ et $R_5$ représentant un atome d'hydrogène,
9) $R_3$ étant un groupe représenté par la formule 2, $R_5$ représentant un groupe ($C_1$ à $C_{60}$)alkyle substitué ou non substitué, un groupe ($C_3$ à $C_{10}$)cycloalkyle substitué ou non substitué, un groupe phényle, un groupe biphényle, ou $-Si(Q_3)(Q_4)(Q_5)$ et $R_1$, $R_2$, $R_4$ et $R_6$ représentant un atome d'hydrogène, ou
10) $R_2$ étant un groupe représenté par la formule 2, $R_4$ et $R_5$ représentant chacun indépendamment un groupe ($C_1$ à $C_{60}$)alkyle substitué ou non substitué, un groupe ($C_3$ à $C_{10}$)cycloalkyle substitué ou non substitué, un groupe phényle, un groupe biphényle, ou - $Si(Q_3)(Q_4)(Q_5)$ et $R_1$, $R_3$ et $R_6$ représentant un atome d'hydrogène.

**5.** Composé organométallique selon l'une quelconque des revendications 1 à 4,
au moins l'un des groupes $R_7$ à $R_9$ représentant chacun indépendamment un groupe ($C_1$ à $C_{60}$)alkyle substitué ou non substitué, un groupe ($C_3$ à $C_{10}$)cycloalkyle substitué ou non substitué, ou un groupe ($C_6$ à $C_{60}$)aryle substitué ou non substitué.

**6.** Composé organométallique selon l'une quelconque des revendications 1 à 5,

$R_{13}$ dans la formule 2 représentant un atome d'hydrogène ou un atome de deutérium ; ou
$R_{13}$ dans la formule 2 représentant un groupe ($C_1$ à $C_{20}$)alkyle, un groupe ($C_1$ à $C_{20}$)alkyle contenant du deutérium, un groupe ($C_3$ à $C_{10}$)cycloalkyle, ou un groupe ($C_3$ à $C_{10}$)cycloalkyle contenant du deutérium.

**7.** Composé organométallique selon l'une quelconque des revendications 1 à 5,

$R_{14}$ et $R_{15}$ dans la formule 2 étant différents l'un de l'autre ; et/ou
dans la formule 2,
$R_{13}$ représentant un atome d'hydrogène, un atome de deutérium, un groupe $-CH_3$, $-CDH_2$, $-CD_2H$ ou $-CD_3$,

$R_{14}$ et $R_{15}$ représentant chacun indépendamment :

un groupe méthyle, un groupe éthyle, un groupe n-propyle, un groupe iso-propyle, un groupe n-butyle, un groupe sec-butyle, un groupe iso-butyle, un groupe tert-butyle, un groupe n-pentyle, un groupe tert-pentyle, un groupe néopentyle, un groupe iso-pentyle, un groupe sec-pentyle, un groupe 3-pentyle, un groupe sec-isopentyle, un groupe n-hexyle, un groupe iso-hexyle, un groupe sec-hexyle, un groupe tert-hexyle, un groupe n-heptyle, un groupe iso-heptyle, un groupe sec-heptyle, un groupe tert-heptyle, un groupe n-octyle, un groupe iso-octyle, un groupe sec-octyle, un groupe tert-octyle, un groupe n-nonyle, un groupe iso-nonyle, un groupe sec-nonyle, un groupe tert-nonyle, un groupe n-décyle, un groupe iso-décyle, un groupe sec-décyle, un groupe tert-décyle, un groupe cyclopentyle, un groupe cyclohexyle, un groupe cycloheptyle, un groupe cycloctyle, un groupe adamantanyle, un groupe norbornanyle, un groupe norbornényle, un groupe cyclopentényle, un groupe cyclohexényle, un groupe cycloheptényle, un groupe bicyclo[1.1.1 ]pentyle, un groupe bicyclo[2.1.1]hexyle, un groupe bicyclo[2.2.1]heptyle, ou un groupe bicyclo[2.2.2]octyle ; ou

un groupe méthyle, un groupe éthyle, un groupe n-propyle, un groupe iso-propyle, un groupe n- butyle, un groupe sec-butyle, un groupe iso-butyle, un groupe tert-butyle, un groupe n-pentyle, un groupe tert-pentyle, un groupe néopentyle, un groupe iso-pentyle, un groupe sec-pentyle, un groupe 3-pentyle, un groupe sec-isopentyle, un groupe n-hexyle, un groupe iso-hexyle, un groupe sec-hexyle, un groupe tert-hexyle, un groupe n-heptyle, un groupe iso-heptyle, un groupe sec-heptyle, un groupe tert-heptyle, un groupe n-octyle, un groupe iso-octyle, un groupe sec-octyle, un groupe tert-octyle, un groupe n-nonyle, un groupe iso-nonyle, un groupe sec-nonyle, un groupe tert-nonyle, un groupe n-décyle, un groupe iso-décyle, un groupe sec-décyle, un groupe tert-décyle, un groupe cyclopentyle, un groupe cyclohexyle, un groupe cycloheptyle, un groupe cycloctyle, un groupe adamantanyle, un groupe norbornanyle, un groupe norbornényle, un groupe cyclopentényle, un groupe cyclohexényle, un groupe cycloheptényle, un groupe bicyclo[1.1.1 ]pentyle, un groupe bicyclo[2.1.1]hexyle, un groupe bicyclo[2.2.1]heptyle, or un groupe bicyclo[2.2.2]octyle, chacun substitué par au moins un atome de deutérium.

**8.** Composé organométallique selon l'une quelconque des revendications 1 à 7, $R_{10}$ et $R_{12}$ dans la formule 1 étant identiques l'un à l'autre.

**9.** Composé organométallique selon l'une quelconque des revendications 1 à 7, $R_{10}$ et $R_{12}$ dans la formule 1 étant différents l'un de l'autre.

**10.** Composé organométallique selon la revendication 1, ledit composé organométallique étant l'un choisi parmi les composés 2 à 4 et 6 à 20 :

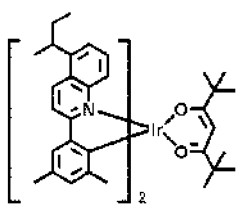

2

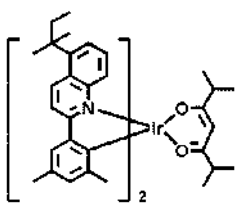

3

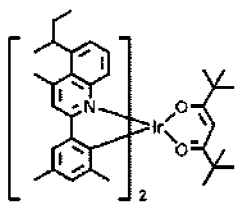

4

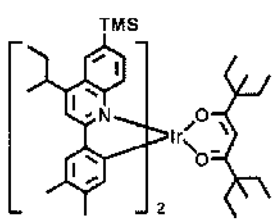

6

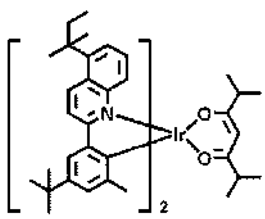

7

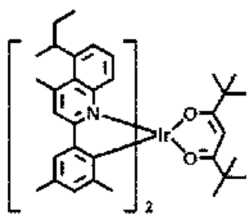

8

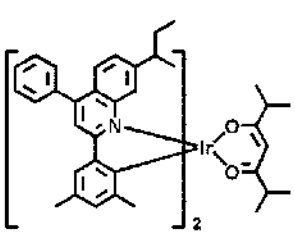
9
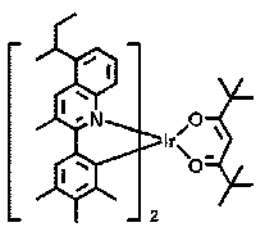
10
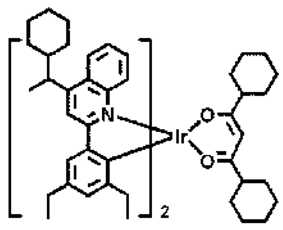
11
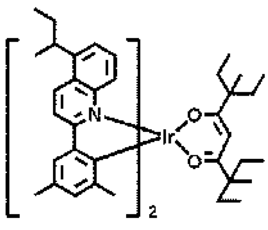
12

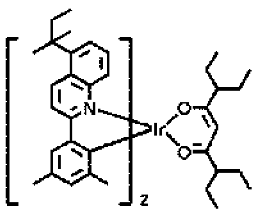
13
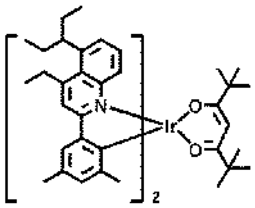
14
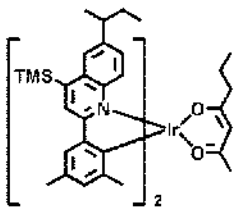
15
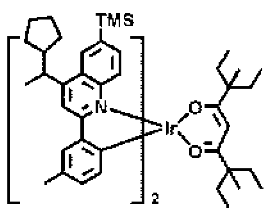
16

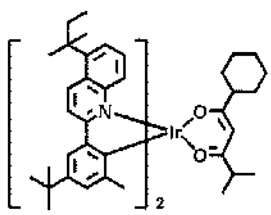
17
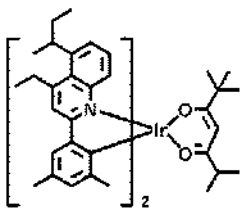
18
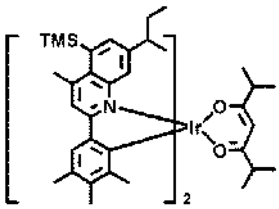
19
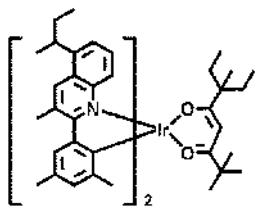
20

**11.** Dispositif électroluminescent organique comprenant :

une première électrode ;
une seconde électrode ; et
une couche organique entre la première électrode et la seconde électrode et comprenant une couche d'émission, ladite couche organique comprenant au moins l'un parmi le composé organique selon l'une quelconque des revendications 1 à 10.

**12.** Dispositif électroluminescent organique selon la revendication 11,

ladite première électrode étant une anode,
ladite seconde électrode étant une cathode,
ladite couche organique comprenant en outre une région de transport de trous entre la première électrode et la couche d'émission et une région de transport d'électrons entre la couche d'émission et la seconde électrode, ladite région de transport de trous comprenant une couche d'injection de trous, une couche de transport de trous, une couche de blocage d'électrons, une couche tampon ou toute combinaison de celles-ci, et
ladite région de transport d'électrons comprenant une couche de blocage de trous, une couche de transport d'électrons, une couche d'injection d'électrons ou toute combinaison de celles-ci.

**13.** Dispositif électroluminescent organique selon la revendication 11 ou 12,

ladite couche d'émission comprenant le composé organométallique, de préférence ladite couche d'émission émettant de la lumière rouge ; et/ou
ladite couche d'émission comprenant en outre un hôte, et la quantité de l'hôte dans la couche d'émission étant plus grande que la quantité du composé organométallique dans la couche d'émission.

**14.** Composition de diagnostic comprenant au moins l'un parmi le composé organique selon l'une quelconque des

revendications 1 à 10.

# FIGURE

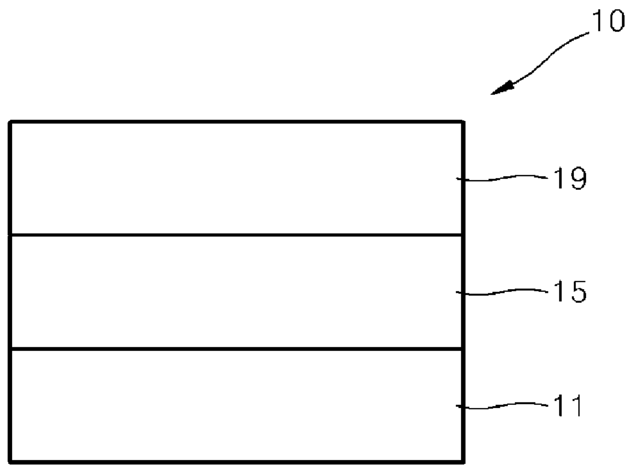

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- CN 107459535
- CN 103694277
- WO 2014023377 A